# EUROPEAN PATENT APPLICATION

(11) **EP 4 474 524 A2**
(43) Date of publication of application: **11.12.2024**
(21) Application number: 24178595.5
(22) Date of filing: 28.05.2024
(51) Int. Cl.: C23C 18/12, C07F 1/00, C07F 7/00, G03F 7/11

(54) **COMPOUND FOR FORMING METAL-CONTAINING FILM, COMPOSITION FOR FORMING METAL-CONTAINING FILM, METHOD FOR MANUFACTURING COMPOUND FOR FORMING METAL-CONTAINING FILM, AND PATTERNING PROCESS**

(30) Priority: 07.06.2023 JP 2023093628
(71) Applicant: SHIN-ETSU CHEMICAL CO., LTD., Tokyo 1000005 (JP)
(72) Inventor: Kobayashi, Naoki, Niigata (JP); Nagamachi, Nobuhiro, Niigata, Niigata (JP); Ishiwata, Kenta, Niigata (JP); Kori, Daisuke, Niigata (JP)
(74) Representative: Sonnenhauser, Thomas Martin

(57) **Abstract**

The present invention is a compound (A) for forming a metal-containing film, where the compound is derived from a metal-containing compound, being a hydrolysate, condensate, or hydrolysis condensate of a metal compound represented by the following formula (A-1), and the compound (A) further has a ligand derived from an organic compound represented by the following formula (1). This can provide a compound for forming a metal-containing film having better dry etching resistance than those of conventional organic underlayer film materials and also having high filling property and/or high planarizing property.

M(OR^{1A})₄ (A-1)

R^{2A}COXCOOH (1)

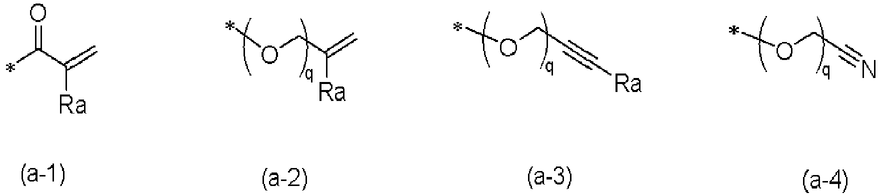

## Description

### TECHNICAL FIELD

The present invention relates to: a compound for forming a metal-containing film; a composition for forming a metal-containing film; a method for manufacturing a compound for forming a metal-containing film; and a patterning process.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1, for example.

On the other hand, in recent years, with the rapid miniaturization of DRAM memory, there is a growing need for further improvement in dry etching resistance, as well as a need for a resist underlayer film having excellent filling and planarizing properties. As a coating-type material for an organic underlayer film excellent in filling and planarizing properties, for example, the composition disclosed in Patent Document 2 has been reported. However, in view of application of this composition in the advanced generation, there is a concern about dry etching resistance. The application limit of the previously-known coating-type composition for an organic underlayer film is thus approaching.

To solve the problems, there is consideration of development of the use of a material containing a metal element for a resist underlayer film. Patent Document 3 reports that a material containing a Ti compound exhibits excellent dry etching resistance to CHF₃/CF₄-based gas and CO₂/N₂-based gas.

On the other hand, filling property is a problem when using a metal compound for a resist underlayer film. Although there is no mention of filling property in Patent Document 3, a metal oxide compound generally undergoes large thermal shrinkage during baking and induces remarkable degradation of filling after baking at a high temperature. Therefore, there is a concern that such a compound is insufficient as a resist underlayer film material for which high planarizing and filling properties and heat resistance are required. Patent Documents 4 and 5 report that a metal compound modified with a particular ligand has excellent filling property. However, the baking temperature in the performed filling property evaluation is 150°C which is a low temperature, and there is a concern that the compound is insufficient as a resist underlayer film, which requires heat resistance (for example, resistance to a heat treatment that is performed after the formation of a resist underlayer film in some cases). In addition, a metal compound in which a hydrolysable group is protected by a silicon-containing organic group is used, and therefore, it is difficult for a condensation reaction to be promoted and the denseness of the metal film obtained at the time of baking is insufficient, and there is a concern that dry etching resistance is insufficient.

As a method to improve filling property, use of a ligand excellent in thermosetting property may be conceived. Patent Document 6 reports that a metal compound having a substituted or unsubstituted ethenyl group or a substituted or unsubstituted ethynyl group has excellent thermosetting property, and therefore, has excellent resolution and sensitivity as a radiation-sensitive composition. In the Examples, metal compounds having a ligand derived from 4-vinylbenzoic acid and 4-allyloxybenzoic acid are given. However, there is a concern that the compounds are insufficient for resist underlayer film materials, which require high heat resistance relative to resist materials.

### CITATION LIST

### PATENT LITERATURE

Patent Document 1: JP2004-205685A
Patent Document 2: JP6714493B2
Patent Document 3: JP6189758B2
Patent Document 4: JP6786391B2
Patent Document 5: JP7050137B2
Patent Document 6: JP2020-201480A

### SUMMARY OF INVENTION

### TECHNICAL PROBLEM

The present invention has been made in view of the above-described circumstances. An object of the present invention is to provide: a compound for forming a metal-containing film having better dry etching resistance than that of conventional organic underlayer film materials and also having high filling property and/or high planarizing property; a method for manufacturing the compound; a composition for forming a metal-containing film containing the compound; and a patterning process in which the composition is used.

### SOLUTION TO PROBLEM

To achieve the object, the present invention provides a compound (A) for forming a metal-containing film, wherein
the compound (A) for forming a metal-containing film is a compound derived from a metal-containing compound, being a hydrolysate, condensate, or hydrolysis condensate of a metal compound represented by the following formula (A-1), and the compound (A) further has a ligand derived from an organic compound represented by the following formula (1),

M(OR^{1A})₄ (A-1)

R^{2A}COXCOOH (1)

wherein M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the following general formulae (a-1) to (a-4); and X represents a divalent organic group having 2 to 20 carbon atoms, 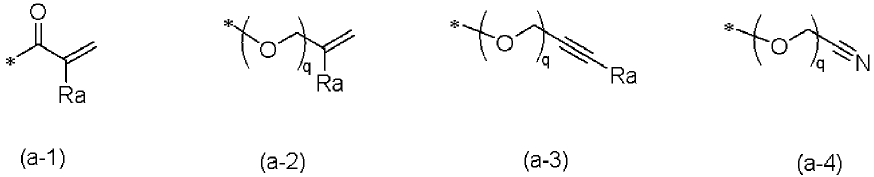 wherein Rₐ represents a hydrogen atom or a monovalent organic group having 1 to 10 carbon atoms; "q" represents 0 or 1; and "*" represents an attachment point.

Such a compound for forming a metal-containing film contains a ligand derived from an organic compound of the formula (1), containing one or more crosslinking groups represented by any of (a-1) to (a-4), and therefore, when the compound is contained in a composition for forming a metal-containing film, volume shrinkage during baking is small, and it is possible to provide a composition for forming a metal-containing film excellent in planarizing property and/or filling property even after high-temperature baking. In addition, the compound is derived from a metal-containing compound, being a hydrolysate, condensate, or hydrolysis condensate of a metal compound represented by the formula (A-1), and therefore, when the compound is contained in a composition for forming a metal-containing film, a dense metal-containing film can be formed, and it is possible to provide a metal-containing film having exceptionally good dry etching resistance relative to a substrate to be processed.

The compound (A) for forming a metal-containing film is preferably a metal-containing compound, being a reaction product of a reaction between:
one or more selected from a hydrolysate of only the metal compound represented by the formula (A-1), a condensate of only the metal compound represented by the formula (A-1), and a hydrolysis condensate of only the metal compound represented by the formula (A-1); and
the organic compound represented by the formula (1).

In such a compound for forming a metal-containing film, the ligand derived from the organic compound of the formula (1) can be introduced to the metal compound efficiently, and therefore, when the compound is contained in a composition for forming a metal-containing film, it is possible to provide a metal-containing film having both high filling property and high dry etching resistance.

The R^{2A} in the formula (1) preferably has a structure represented by one of the following general formulae (B-1), 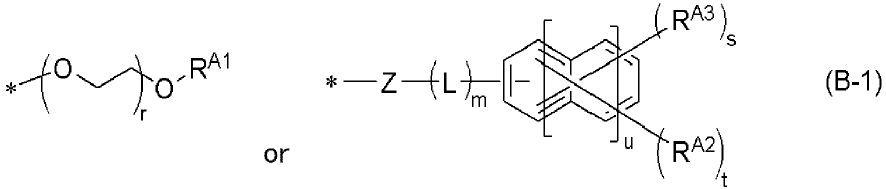 wherein R^{A1} has a structure represented by the general formula (a-1); R^{A2} has a structure represented by the general formula (a-2) or (a-3); Z represents an oxygen atom or a secondary amine; L represents a divalent hydrocarbon group having 1 to 10 carbon atoms; R^{A3} represents a saturated divalent organic group having 1 to 20 carbon atoms or an unsaturated divalent organic group having 2 to 20 carbon atoms; "t" represents 1 to 6 and "s" represents 0 to 5, provided that t+s is 1 or more and 6 or less; "r" represents 1 to 10; "u" represents 0 or 1; "m" represents 0 or 1; and "*" represents an attachment point to a carbon atom of a carbonyl group.

When the R^{2A} in the general formula (1) has a structure represented by one of the formulae (B-1), it is possible to achieve both high thermal flowability and high thermosetting property of the compound for forming a metal-containing film, and when the compound is contained in a composition for forming a metal-containing film, it is possible to provide a composition for forming a metal-containing film that exhibits better planarizing property and/or filling property.

The organic group X in the formula (1) is preferably a saturated hydrocarbon group having 2 to 20 carbon atoms or an unsaturated hydrocarbon group having 2 to 20 carbon atoms.

When the organic group X in the formula (1) has such a structure, the thermal flowability of the compound for forming a metal-containing film can be further enhanced, and when the compound is contained in a composition for forming a metal-containing film, it is possible to provide a composition for forming a metal-containing film that exhibits better planarizing property and/or filling property.

The organic group X in the formula (1) is preferably a group represented by one of the following formulae (2), 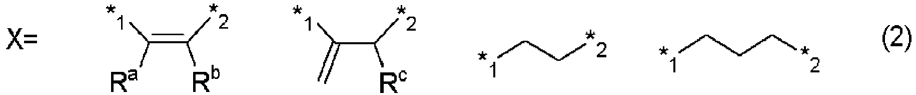 wherein R^{a} and R^{b} each represent a hydrogen atom or a monovalent organic group having 1 to 18 carbon atoms and R^{c} represents a hydrogen atom or a monovalent organic group having 1 to 17 carbon atoms, R^{a} and R^{b} optionally being bonded to each other to form a cyclic substituent; and "*1" and "*2" each represent an attachment point to a carbonyl group, "*1" and "*2" optionally being reversed.

When the organic group X in the formula (1) has such a structure, the thermal flowability of the compound for forming a metal-containing film can be further enhanced, and when the compound is contained in a composition for forming a metal-containing film, it is possible to provide a composition for forming a metal-containing film that exhibits even better planarizing property and/or filling property.

For example, the compound (A) for forming a metal-containing film may comprise a compound having a structure represented by the following general formula (m-1), 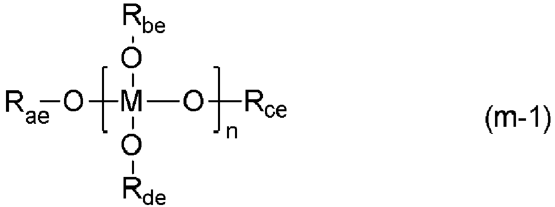 wherein Rₐₑ to R_{de} each independently represent the R^{1A} in the formula (A-1) or the COXCOR^{2A} in the formula (1), provided that at least one of Rₐₑ to R_{de} represents the COXCOR^{2A} in the formula (1); "n" represents 1 to 20; and M is identical to the M in the formula (A-1).

The compound (A) for forming a metal-containing film can contain, for example, a compound having the above-described structure, although the compound is not limited thereto.

The compound (A) for forming a metal-containing film preferably further comprises, besides the ligand derived from the organic compound represented by the formula (1), at least one additional ligand selected from the group consisting of a ligand derived from an organic compound represented by the following formula (3) and a ligand derived from any of succinic anhydride, maleic anhydride, glutaric anhydride, phthalic anhydride, and cyclohexanedicarboxylic anhydride, and
the additional ligand preferably does not contain a group represented by any of the general formulae (a-1) to (a-4),

R^{3A}COOH (3)

wherein R^{3A} represents a monovalent organic group having 1 to 20 carbon atoms.

When such a compound is contained in a composition for forming a metal-containing film, it is possible to promote a crosslinking reaction during baking, and the baking temperature at the time of the baking can be in a low temperature range. Furthermore, a dense metal-containing film can be formed by the crosslinking reaction being promoted, and etching resistance can be enhanced.

In this case, for example, the compound (A) for forming a metal-containing film may comprise a compound having one of the following structures, 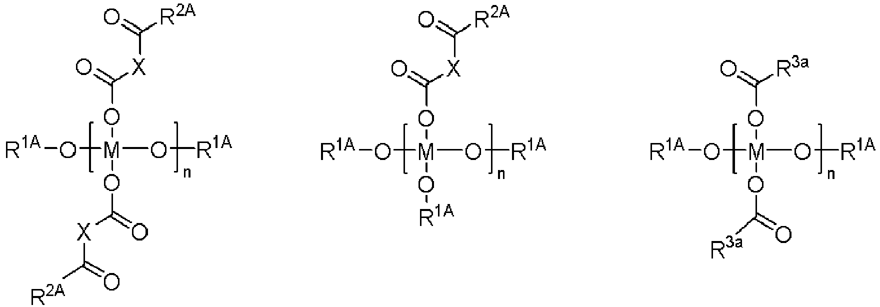 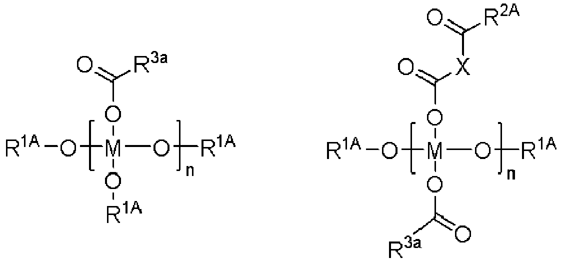 wherein the R^{3a} represents a monovalent organic group having 1 to 20 carbon atoms and not containing a crosslinking group represented by any of the general formulae (a-1) to (a-4) or has a structure of any of the following formulae; R^{1A} is identical to the R^{1A} in the formula (A-1); R^{2A} is identical to the R^{2A} in the formula (1); "n" represents 1 to 20; and M is identical to the M in the formula (A-1), 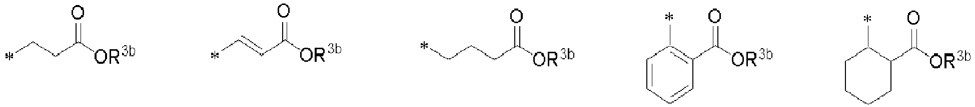 wherein R^{3b} represents an alkyl group having 1 to 10 carbon atoms; and "*" represents an attachment point to a carbon atom of a carbonyl group.

When an additional ligand is contained, the compound (A) for forming a metal-containing film can contain, for example, a compound having the above-described structure, although the compound is not limited thereto.

In addition, the present invention provides a composition for forming a metal-containing film, comprising:
(A) the inventive compound for forming a metal-containing film; and
(B) an organic solvent.

Such a composition for forming a metal-containing film contains a metal-containing compound that is excellent in heat resistance and thermal flowability, and therefore, can provide a composition for forming a metal-containing film that has better dry etching resistance than that of conventional organic underlayer film materials, and also has higher filling property and/or higher planarizing property than those of conventional metal-containing underlayer film materials.

The composition can further comprise one or more of:
(C) a crosslinking agent;
(D) a surfactant; and
(E) an acid generator.

When the composition for forming a metal-containing film contains one or more of the additives, the composition for forming a metal-containing film has better coatability, dry etching resistance, and filling and/or planarizing property.

The organic solvent (B) preferably contains a high-boiling-point solvent (B-1), and the high-boiling-point solvent (B-1) is one or more kinds of organic solvent having a boiling point of 180°C or higher.

When thermal flowability is imparted to the compound for forming a metal-containing film by a high-boiling-point solvent being contained, the composition for forming a metal-containing film also has higher filling and/or planarizing property.

The composition for forming a metal-containing film preferably further comprises (BP) a flowability accelerator having an organic group represented by one of the following general formulae (bp1a) and an aromatic ring, 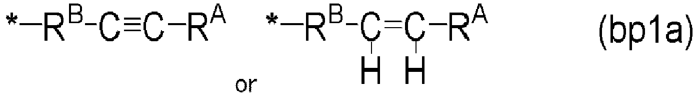 wherein "*" represents an attachment point to an oxygen atom; R^{B} represents a divalent organic group having 1 to 10 carbon atoms; R^{A} represents a hydrogen atom or a monovalent organic group having 1 to 10 carbon atoms.

When heat resistance and thermal flowability are imparted to the compound for forming a metal-containing film by a flowability accelerator (BP) being contained, the composition for forming a metal-containing film also has even higher filling property and/or planarizing property.

The flowability accelerator (BP) preferably has at least one constitutional unit represented by any of the following general formulae (BP-1), (BP-2), (BP-3), (BP-4), and (BP-5), 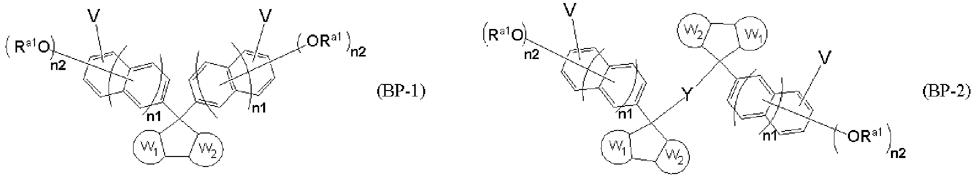 wherein W₁ and W₂ each independently represent a benzene ring or a naphthalene ring, part of hydrogen atoms in the benzene ring and the naphthalene ring optionally being substituted with a hydrocarbon group having 1 to 6 carbon atoms; R^{a1} represents either group represented by the following general formulae (4); Y represents any group represented by the following general formulae (5); "n₁" represents 0 or 1; "n₂" represents 1 or 2; and each V independently represents a hydrogen atom or an attachment point, 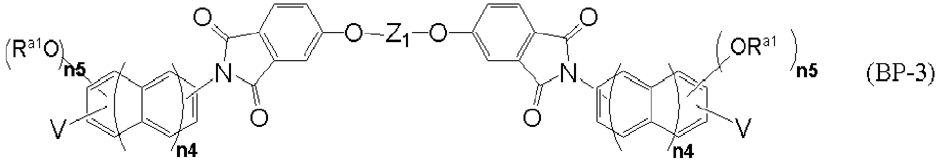 wherein Z₁ represents any group represented by the following general formulae (6); R^{a1} represents either group represented by the following general formulae (4); "n₄" represents 0 or 1; "n₅" represents 1 or 2; and each V independently represents a hydrogen atom or an attachment point, 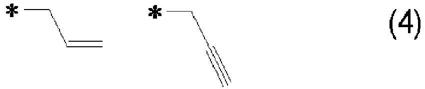 wherein "*" represents an attachment point to an oxygen atom, 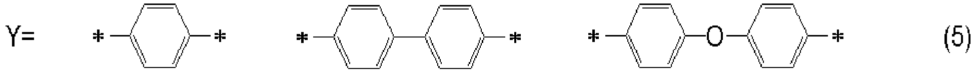 wherein "*" represents an attachment point, 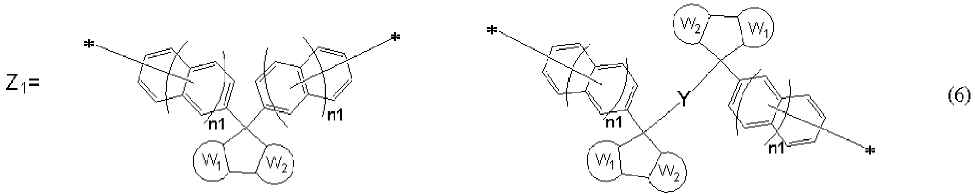 wherein W₁, W₂, Y, and "n₁" are as defined above, 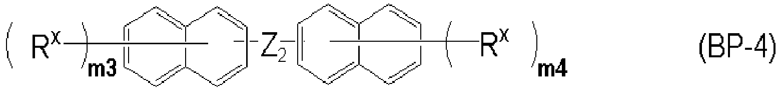 wherein "m₃" and "m₄" each represent 1 or 2; Z₂ represents a single bond or any structure represented by the following general formulae (7); and R^{x} represents any structure represented by the following general formulae (8), 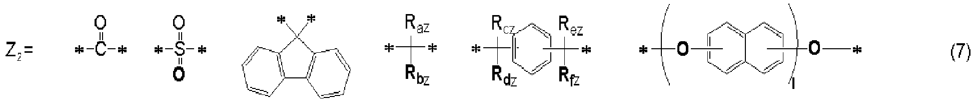 wherein "*" represents an attachment point; "l" represents an integer of 0 to 3; and R_{az} to R_{fz} each independently represent a hydrogen atom, an alkyl group having 1 to 10 carbon atoms and optionally having a substituent fluorine atom, a phenyl group optionally having a substituent fluorine atom, or a phenylethyl group optionally having a substituent fluorine atom, R_{az} and R_{bz} optionally being bonded to each other to form a cyclic compound, 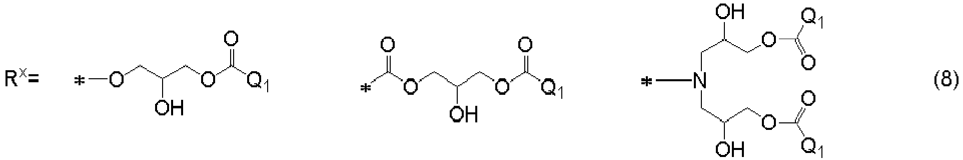 wherein "*" represents an attachment point to an aromatic ring; and Q₁ represents a linear saturated hydrocarbon group having 1 to 30 carbon atoms or a structure represented by the following general formula (9), 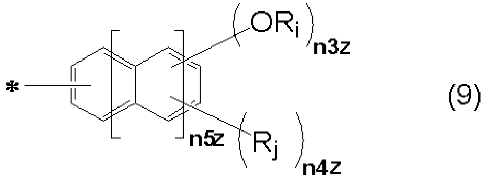 wherein "*" represents an attachment point to a carbonyl group; Rᵢ represents either of the general formulae (4); Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 1 to 10 carbon atoms; "n_{3z}" and "n_{4z}" each represent a number of substituents on an aromatic ring, the number each representing an integer of 0 to 7, provided that n_{3z}+n_{4z} is 0 or more and 7 or less; and "n_{5z}" represents 0 to 2, 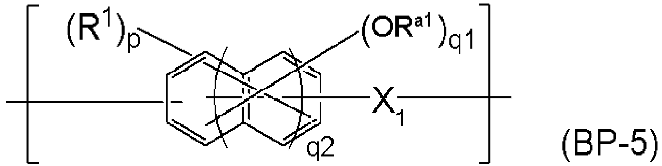 wherein R¹ represents a saturated monovalent organic group having 1 to 30 carbon atoms or an unsaturated monovalent organic group having 2 to 30 carbon atoms; X₁ represents a divalent organic group having 1 to 30 carbon atoms; R^{a1} represents either of the general formulae (4); "p" represents an integer of 0 to 5 and "q₁" represents an integer of 1 to 6, provided that p+q₁ is an integer of 1 or more and 6 or less; and "q₂" represents 0 or 1.

When the composition for forming a metal-containing film contains a flowability accelerator (BP) having at least one constitutional unit represented by the above-described (BP-1) to (BP-5), the composition for forming a metal-containing film has even better filling and/or planarizing property.

In addition, the present invention provides a method for manufacturing a compound (A) for forming a metal-containing film, the method comprising
allowing one or more selected from the group consisting of a hydrolysate of only a metal compound represented by the following formula (A-1), a condensate of only a metal compound represented by the following formula (A-1), and a hydrolysis condensate of only a metal compound represented by the following formula (A-1) to react with an organic compound represented by the following formula (1) or
hydrolyzing, condensing, or hydrolysis-condensing a metal compound represented by the following general formula (A-2),

   M(OR^{1A})₄ (A-1)

   R^{2A}COXCOOH (1)

   wherein M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the following general formulae (a-1) to (a-4); and X represents a divalent organic group having 2 to 20 carbon atoms, 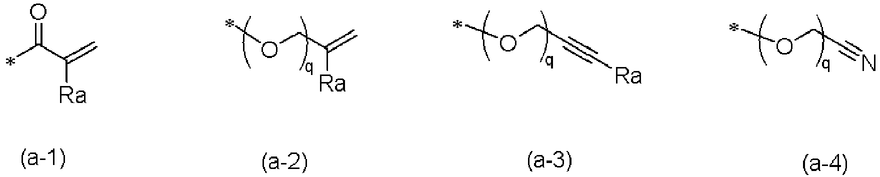 wherein Rₐ represents a hydrogen atom or a monovalent organic group having 1 to 10 carbon atoms; "q" represents 0 or 1; and "*" represents an attachment point,

   (R^{2A}COXCOO)ₓM(OR^{1A})_{y} (A-2)
wherein M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the general formulae (a-1) to (a-4); X represents a divalent organic group having 2 to 20 carbon atoms; x + y = 4; and "x" and "y" each represent an integer of 1 or more.

Such a manufacturing method can provide a compound for forming a metal-containing film containing a ligand derived from an organic compound of the formula (1), including any one or more crosslinking groups represented by any of the formulae (a-1) to (a-4), and therefore, when the method is used for a composition for forming a metal-containing film, it is possible to provide a composition for forming a metal-containing film that undergoes little volume shrinkage at the time of baking and is excellent in planarizing property and/or filling property even after high-temperature baking. Furthermore, the method can provide a compound derived from a metal-containing compound obtained by hydrolyzing, condensing, or hydrolysis-condensing a metal compound represented by the formula (A-1), and therefore, when the method is used for a composition for forming a metal-containing film, a dense metal-containing film can be formed, and it is possible to provide a metal-containing film that has exceptionally good dry etching resistance relative to a substrate to be processed.

The present invention also provides a patterning process for forming a pattern in a substrate to be processed, comprising the steps of:
(I-1) applying the inventive composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The patterning process by way of the two-layer resist process makes it possible to form fine patterns on the body to be processed (substrate to be processed).

The present invention also provides a patterning process for forming a pattern in a substrate to be processed, comprising the steps of:
(II-1) applying the inventive composition for forming a metal-containing film onto a substrate to be processed, followed by heating to form a metal-containing film;
(II-2) forming a resist middle layer film on the metal-containing film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal-containing film by dry etching while using the resist middle layer film having the transferred pattern as a mask; and
(II-7) processing the substrate to be processed while using the metal-containing film having the formed pattern as a mask to form the pattern in the substrate to be processed.

The patterning process by way of the three-layer resist process makes it possible to form fine patterns on the body to be processed with high accuracy.

The present invention also provides a patterning process for forming a pattern in a substrate to be processed, comprising the steps of:
(III-1) applying the inventive composition for forming a metal-containing film onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

The patterning process by way of the four-layer resist process makes it possible to form fine patterns on the body to be processed with high accuracy.

In this event, the inorganic hard mask middle layer film is preferably formed by a CVD method or an ALD method.

When the inorganic hard mask is formed by a CVD method or an ALD method, a fine pattern can be formed on a body to be processed with higher accuracy.

The present invention also provides a patterning process for forming a pattern in a substrate to be processed, comprising the steps of:
(IV-1) applying the inventive composition for forming a metal-containing film onto a substrate to be processed, followed by heating to form a metal-containing film;
(IV-2) forming an organic middle layer film on the metal-containing film;
(IV-3) forming a silicon-containing resist middle layer film or a combination of an organic thin film and an inorganic hard mask middle layer film selected from a silicon oxide film, a silicon nitride film, and a silicon oxynitride film on the organic middle layer film;
(IV-4) forming a resist upper layer film on the silicon-containing resist middle layer film or the organic thin film by using a photoresist material;
(IV-5) subjecting the resist upper layer film to pattern exposure and then development with a developer to form a pattern in the resist upper layer film;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the organic middle layer film by dry etching while using the silicon-containing resist middle layer film or the inorganic hard mask middle layer film having the transferred pattern as a mask;
(IV-8) transferring the pattern to the metal-containing film by dry etching while using the organic middle layer film having the transferred pattern as a mask; and
(IV-9) processing the substrate to be processed while using the metal-containing film having the formed pattern as a mask to form the pattern in the substrate to be processed.

The patterning process by way of the multilayer resist process makes it possible to form fine patterns on the body to be processed with high accuracy.

The present invention also provides a tone-reversal patterning process for forming a pattern in a substrate to be processed, comprising the steps of:
(V-1) forming a resist underlayer film on a substrate to be processed;
(V-2) forming a resist middle layer film or a combination of an organic thin film and an inorganic hard mask middle layer film selected from a silicon oxide film, a silicon nitride film, and a silicon oxynitride film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the inventive composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

The patterning process by way of the reverse process makes it possible to form fine patterns on the body to be processed with a higher degree of accuracy.

### ADVANTAGEOUS EFFECTS OF INVENTION

As described above, the inventive compound for forming a metal-containing film is a compound derived from a metal-containing compound, being a hydrolysate, condensate, or hydrolysis condensate of a metal compound represented by the formula (A-1), and the compound (A) further has a ligand derived from an organic compound represented by the formula (1), and therefore, when the compound is contained in a composition for forming a metal-containing film, it is possible to provide a composition for forming a metal-containing film that undergoes little volume shrinkage during baking and has excellent planarizing property and/or filling property even after high-temperature baking.

In particular, in a fine patterning process using a multilayer resist method in a semiconductor device manufacturing process, a composition for forming a metal-containing film containing the inventive compound for forming a metal-containing film allows filling without causing defects such as voids and peeling even on a substrate to be processed having a portion that is difficult to be filled and/or be planarized, such as a dense portion of a fine pattern structure having a high aspect ratio exemplified by increasingly miniaturized DRAM. In addition, the inventive compound has better dry etching resistance than conventional coating-type resist underlayer film materials, and therefore, a fine pattern can be formed on a body to be processed with even higher precision compared with conventional resist underlayer films.

In addition, according to the inventive method for manufacturing a compound for forming a metal-containing film, it is possible to manufacture a compound for forming a metal-containing film, which is a compound derived from a metal-containing compound, being a hydrolysate, condensate, or hydrolysis condensate of a metal compound represented by the formula (A-1), the compound (A) further having a ligand derived from an organic compound represented by the formula (1). Therefore, when the method is used for a composition for forming a metal-containing film, it is possible to provide a composition for forming a metal-containing film that undergoes little volume shrinkage during baking and has excellent planarizing property and/or filling property even after high-temperature baking.

Meanwhile, the inventive patterning processes use the inventive composition for forming a metal-containing film, and therefore, make it possible to form a fine pattern in a body to be processed with even higher accuracy.

### BRIEF DESCRIPTION OF DRAWINGS

FIG. 1 is an explanatory view of an example (three-layer resist process) of the patterning process of the present invention.
FIG. 2 is an explanatory view of an example (forming reverse SOC pattern of a three-layer resist process) of the inventive tone-reversal patterning process.
FIG. 3 is an explanatory view of a method for evaluating the filling property.
FIG. 4 is an explanatory view of a method for evaluating the planarizing property.

### DESCRIPTION OF EMBODIMENTS

As stated above, there have been demands for the development of: a composition for forming a metal-containing film, excellent in filling property and planarization property, used for forming a metal-containing film that makes it possible to transfer a resist pattern to a substrate to be processed with higher precision in a fine patterning process according to a multilayer resist method; a compound for forming a metal-containing film useful for the composition; and a patterning process using the composition.

The present inventors have focused on metal materials that exhibit better etching resistance than that of conventional resist underlayer film materials, and studied earnestly. On the other hand, conventional metal compounds for forming a resist underlayer film have poor heat resistance, and undergo rapid volume shrinkage during baking. Therefore, it is difficult to fill and planarize the steps of a substrate to be processed after high-temperature baking of the conventional metal compound. The present inventors have considered that when an organic group excellent in heat resistance is contained, rapid volume shrinkage at the time of baking can be reduced and thermal flowability can be improved, so that steps of a substrate to be processed can be filled without voids being generated even after baking at a high temperature. The present inventors have also assumed that a compound for forming a metal-containing film having a structure that contains a crosslinking group at a terminal has excellent thermosetting property during baking, and therefore, has better heat resistance. Furthermore, there may be concerns that the dry etching resistance of the metal-containing film is degraded by introducing an organic ligand having excellent heat resistance, and therefore, the present inventors hypothesized that a compound derived from a metal-containing compound, being a hydrolysate, condensate, or hydrolysis condensate of a metal compound, makes it possible to enhance dry etching resistance without degrading filling property.

The present inventors have studied earnestly further, and found out that a compound for forming a metal-containing film, which is a compound derived from a metal-containing compound, being a hydrolysate, condensate, or hydrolysis condensate of a metal compound represented by the formula (A-1) shown below, and which contains a ligand derived from an organic compound represented by the formula (1), including one or more crosslinking groups represented by any of (a-1) to (a-4), is excellent in thermosetting property, and therefore, can reduce rapid volume shrinkage during baking, also has excellent thermal flowability, and therefore, can realize high filling property and/or high planarizing property, and can provide a resist underlayer film excellent in dry etching resistance. Based on these findings, the present invention has been completed.

That is, the present invention is a compound (A) for forming a metal-containing film, wherein
the compound (A) for forming a metal-containing film is a compound derived from a metal-containing compound, being a hydrolysate, condensate, or hydrolysis condensate of a metal compound represented by the following formula (A-1), and the compound (A) further has a ligand derived from an organic compound represented by the following formula (1),

M(OR^{1A})₄ (A-1)

R^{2A}COXCOOH (1)

wherein M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the following general formulae (a-1) to (a-4); and X represents a divalent organic group having 2 to 20 carbon atoms, 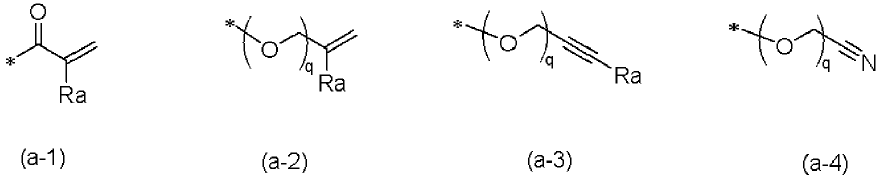 wherein Rₐ represents a hydrogen atom or a monovalent organic group having 1 to 10 carbon atoms; "q" represents 0 or 1; and "*" represents an attachment point.

Hereinafter, the present invention will be described in detail, but the present invention is not limited thereto.

### <(A) Compound for Forming Metal-Containing Film>

The inventive compound (A) for forming a metal-containing film is a compound derived from a metal-containing compound, being a hydrolysate, condensate, or hydrolysis condensate of a metal compound represented by the following formula (A-1), and the compound (A) further has a ligand derived from an organic compound represented by the following formula (1),

M(OR^{1A})₄ (A-1)

R^{2A}COXCOOH (1)

where M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the following general formulae (a-1) to (a-4); and X represents a divalent organic group having 2 to 20 carbon atoms, 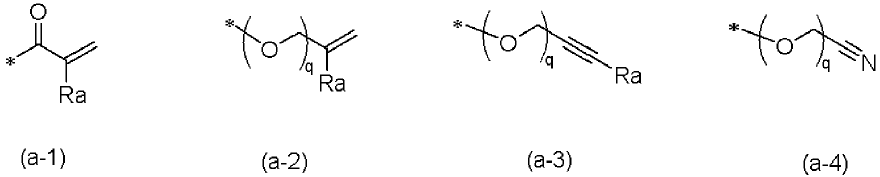 where Rₐ represents a hydrogen atom or a monovalent organic group having 1 to 10 carbon atoms; "q" represents 0 or 1; and "*" represents an attachment point.

The compound derived from the metal-containing compound, being a hydrolysate, condensate, or hydrolysis condensate of the metal compound, has at least one [metal]-[oxygen]-[metal] bond, and therefore, when a metal-containing film is formed using this compound, it is possible to provide a metal-containing film having high hardness and excellent denseness. Moreover, by performing hydrolysis, condensation, or hydrolysis condensation when synthesizing the compound, it is possible to reduce volume shrinkage that accompanies a condensation reaction during baking of the film, and therefore, filling property can be enhanced further.

In the formula (A-1), R^{1A} represents a monovalent organic group having 1 to 20 carbon atoms, preferably an alkyl group having 1 to 10 carbon atoms, and from the viewpoint of productivity of the metal compound, more preferably an isopropyl group or an n-butyl group.

Examples of the metal compound represented by the formula (A-1) include, titanium tetraisopropoxide, titanium butoxide tetramer, zirconium(IV) tetrabutoxide, hafnium(IV) n-butoxide, zirconium(IV) tetraisopropoxide, zirconium(IV) tetrapropoxide, etc.

In the formula (1), R^{2A} represents a divalent organic group having 2 to 20 carbon atoms and containing at least one crosslinking group represented by any of the general formulae (a-1) to (a-4).

By a ligand derived from such an organic compound being contained, the thermosetting property of the compound (A) for forming a metal-containing film is enhanced, and when the compound is contained in a composition for forming a metal-containing film, volume shrinkage during high-temperature baking can be reduced, and it is possible to provide a composition for forming a metal-containing film excellent in filling and/or planarizing property.

In the above-described (a-1) to (a-4), Rₐ represents a hydrogen atom or a monovalent organic group having 1 to 10 carbon atoms, preferably a hydrogen atom, a methyl group, or a phenyl group in view of the availability of raw materials, and more preferably a hydrogen atom from the viewpoint of thermosetting property.

The compound (A) for forming a metal-containing film is preferably a metal-containing compound, being a reaction product of a reaction between:
one or more selected from a hydrolysate of only the metal compound represented by the formula (A-1), a condensate of only the metal compound represented by the formula (A-1), and a hydrolysis condensate of only the metal compound represented by the formula (A-1); and
the organic compound represented by the formula (1).

In such a compound for forming a metal-containing film, the ligand derived from an organic compound of the formula (1) can be introduced to the metal compound efficiently, and therefore, when the compound is contained in a composition for forming a metal-containing film, it is possible to provide a metal-containing film having both high filling property and high dry etching resistance.

The R^{2A} in the formula (1) preferably has a structure represented by one of the following general formulae (B-1).

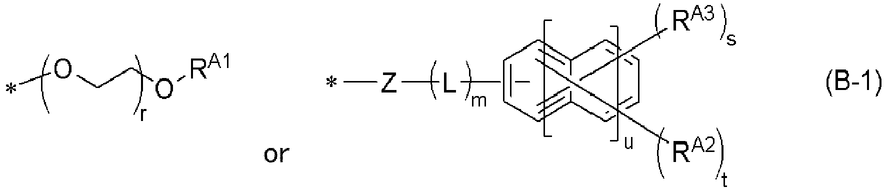

In the general formulae (B-1), R^{A1} has a structure represented by the general formula (a-1); R^{A2} has a structure represented by the general formula (a-2) or (a-3); Z represents an oxygen atom or a secondary amine; L represents a divalent hydrocarbon group having 1 to 10 carbon atoms; R^{A3} represents a saturated divalent organic group having 1 to 20 carbon atoms or an unsaturated divalent organic group having 2 to 20 carbon atoms; "t" represents 1 to 6 and "s" represents 0 to 5, provided that t+s is 1 or more and 6 or less; "r" represents 1 to 10; "u" represents 0 or 1; "m" represents 0 or 1; and "*" represents an attachment point to a carbon atom of a carbonyl group.

In the general formulae (B-1), it is preferable that "r" represents 1 to 10, "t" represents 1 to 6 and "s" represents 0 to 5, provided that t+s is 1 or more and 6 or less, "u" represents 0 or 1, and "m" represents 0 or 1. When "m" is 1, L is preferably methylene. In a more preferable structure, "r" represents 1 to 4, "t" represents 1 to 2, "s" represents 0 to 1, and "m" represents 0.

When the R^{2A} in the formula (1) has a structure represented by one of the general formulae (B-1), the thermal flowability and the thermosetting property of the compound (A) for forming a metal-containing film can be further enhanced. When the compound is contained in a composition for forming a metal-containing film, it is possible to provide a composition for forming a metal-containing film that exhibits better planarizing property and/or filling property.

The organic group X in the formula (1) preferably represents a saturated hydrocarbon group having 2 to 20 carbon atoms or an unsaturated hydrocarbon group having 2 to 20 carbon atoms.

Such a structure makes it possible to enhance the thermal flowability of the compound (A) for forming a metal-containing film further. When such a compound is contained in a composition for forming a metal-containing film, it is possible to provide a composition for forming a metal-containing film that exhibits better planarizing property and/or filling property.

The organic group X in the formula (1) preferably represents a group represented by one of the following formulae (2).

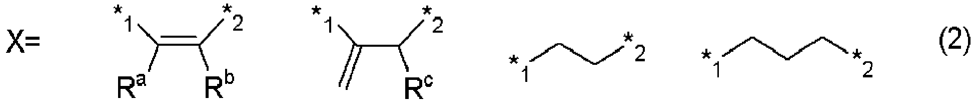

In the general formulae (2), R^{a} and R^{b} each represent a hydrogen atom or a monovalent organic group having 1 to 18 carbon atoms and R^{c} represents a hydrogen atom or a monovalent organic group having 1 to 17 carbon atoms, R^{a} and R^{b} optionally being bonded to each other to form a cyclic substituent; and "*1" and "*2" each represent an attachment point to a carbonyl group, "*1" and "*2" optionally being reversed.

When the organic group X in the formula (1) has such a structure, the thermal flowability of the compound (A) for forming a metal-containing film can be enhanced further, and when the compound is contained in a composition for forming a metal-containing film, it is possible to provide a composition for forming a metal-containing film that exhibits better planarizing property and/or filling property.

As preferable structures of the formula (1), for example, the following compounds can be shown, but the present invention is not limited thereto.

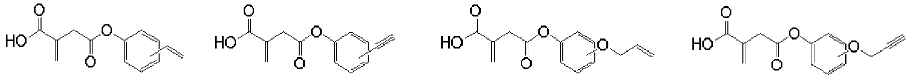

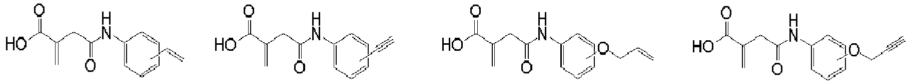

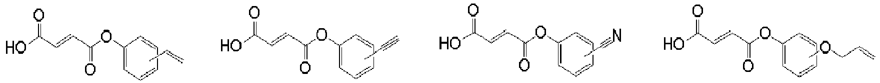

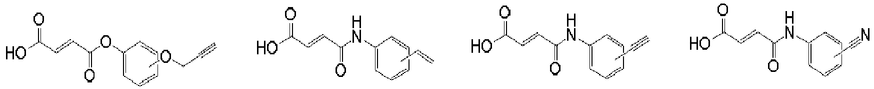

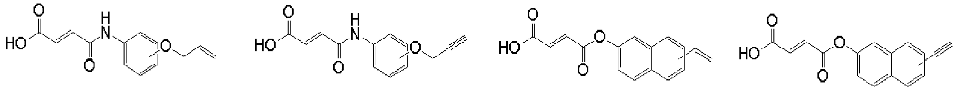

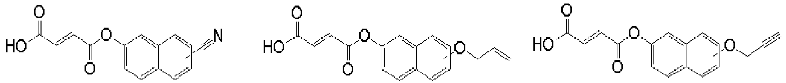

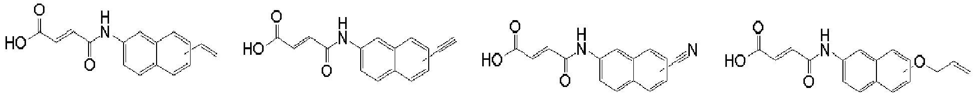

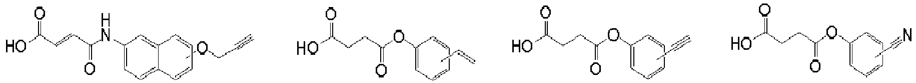

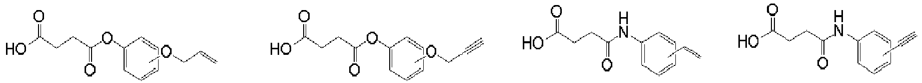

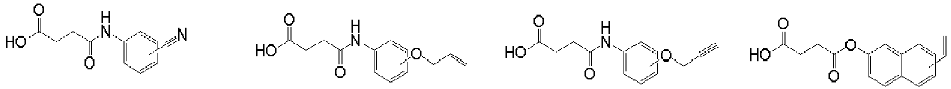

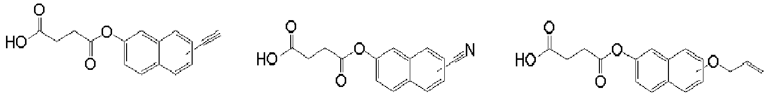

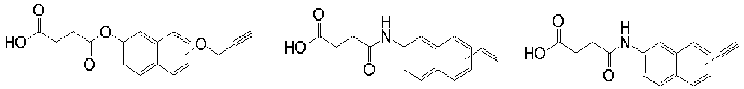

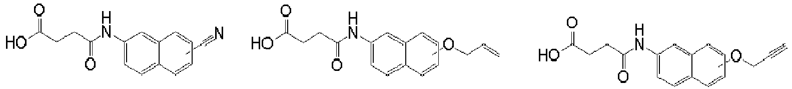

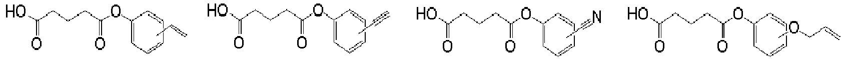

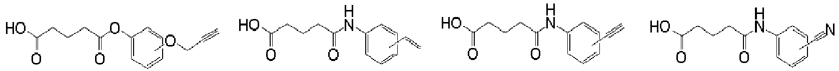

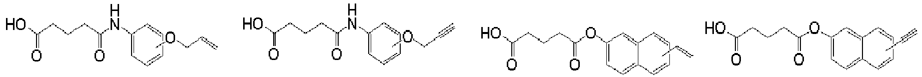

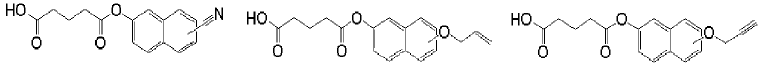

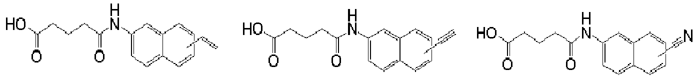

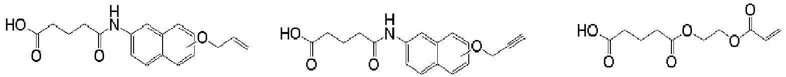

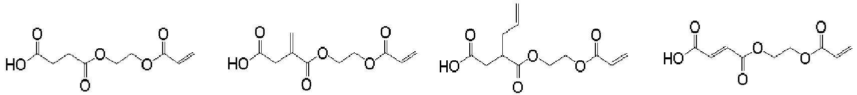

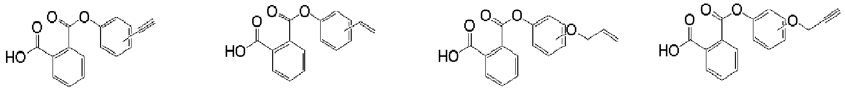

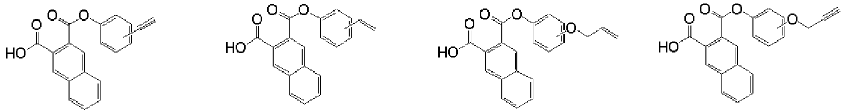

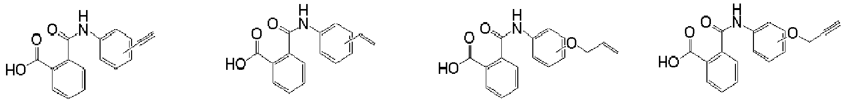

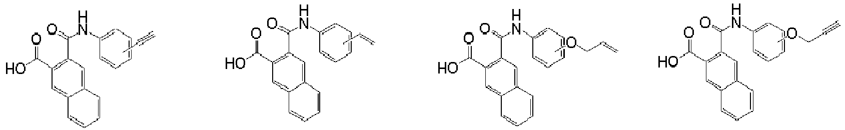

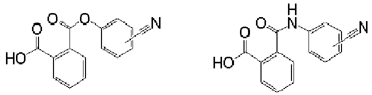

From the viewpoint of filling property, the Z in the formula (B-1) is more preferably a secondary amine.

The compound (A) for forming a metal-containing film may contain one kind of the ligand derived from an organic compound represented by the formula (1) or may contain multiple kinds of ligands having different structures, and the ligands can be adjusted appropriately in accordance with necessary properties required when the compound is used for a composition for forming a metal-containing film. In addition, the compound may also have a ligand other than the ligand derived from an organic compound represented by the formula (1). For example, the compound may contain a ligand derived from an alkyl group having 1 to 10 carbon atoms.

The compound (A) for forming a metal-containing film preferably contains a compound having a structure represented by the following general formula (m-1).

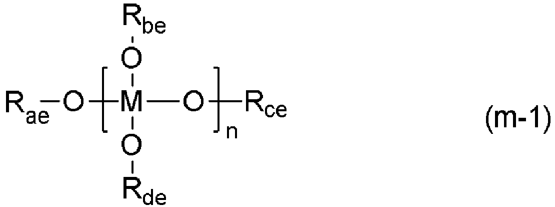

In the formula (m-1), Rₐₑ to R_{de} each independently represent the R^{1A} in the formula (A-1) or the COXCOR^{2A} in the formula (1), provided that at least one of Rₐₑ to R_{de} represents the COXCOR^{2A} in the formula (1); "n" represents 1 to 20; and M is identical to the M in the formula (A-1).

Preferably, the compound (A) for forming a metal-containing film is a compound derived from the metal-containing compound, being a hydrolysate, condensate, or hydrolysis condensate of the metal compound represented by the formula (A-1), and further contains, besides the ligand derived from the organic compound represented by the formula (1), at least one additional ligand selected from the group consisting of a ligand derived from an organic compound represented by the following formula (3) and a ligand derived from any of succinic anhydride, maleic anhydride, glutaric anhydride, phthalic anhydride, and cyclohexanedicarboxylic anhydride. More preferably, the additional ligand does not contain a crosslinking group represented by any of the general formulae (a-1) to (a-4).

R^{3A}COOH (3)

In the formula, R^{3A} represents a monovalent organic group having 1 to 20 carbon atoms.

When a compound further containing such an additional ligand is contained in a composition for forming a metal-containing film, the crosslinking reaction during baking can be promoted, and the baking temperature in this event can be in a low temperature range. Furthermore, such a compound is preferable since a dense metal-containing film can be formed by the crosslinking reaction being promoted, and etching resistance can be enhanced.

The ligand derived from an organic compound represented by the formula (3) preferably contains at least one of aromatic ring, heteroaromatic ring, and alicyclic structures, and examples include the following.

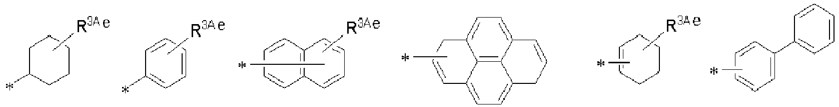

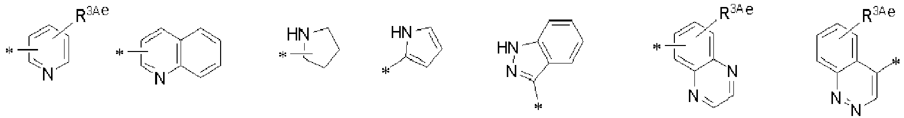

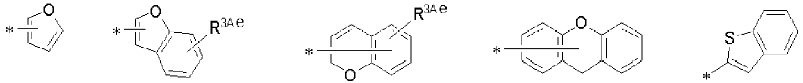

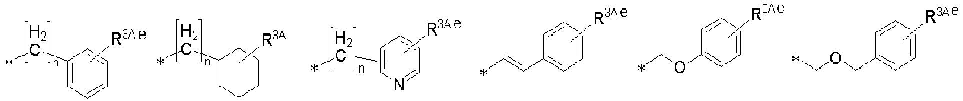

In the formulae, R^{3Ae} represents a monovalent organic group having 1 to 10 carbon atoms; "n" represents 1 to 10; and "*" represents an attachment point to a carbon atom of a carbonyl group.

The ligand derived from any of succinic anhydride, maleic anhydride, glutaric anhydride, phthalic anhydride, and cyclohexanedicarboxylic anhydride is preferably unsubstituted or substituted with a monovalent organic group having 1 to 10 carbon atoms, more preferably unsubstituted.

When a compound further containing an additional ligand derived from such an organic compound is contained in a composition for forming a metal-containing film, dry etching resistance can be enhanced while minimizing the degradation of filling property. Therefore, such a compound is favorable.

When the compound (A) for forming a metal-containing film contains at least one additional ligand selected from the group consisting of a ligand derived from an organic compound represented by the formula (3) and a ligand derived from any of succinic anhydride, maleic anhydride, glutaric anhydride, phthalic anhydride, and cyclohexanedicarboxylic anhydride, the compound preferably contains a compound having one of the following structures or a mixture of these compounds.

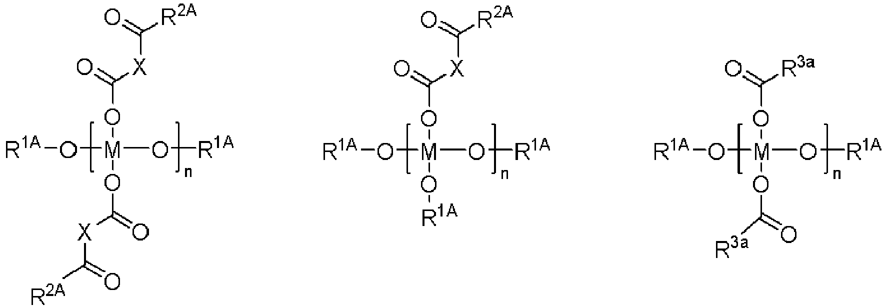

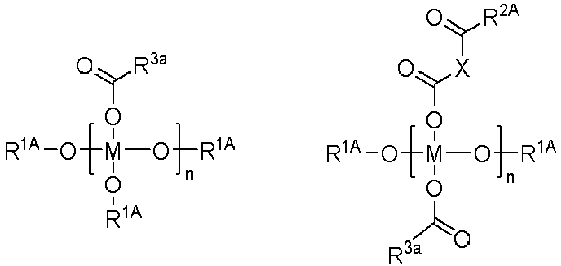

The R^{3a} represents a monovalent organic group having 1 to 20 carbon atoms and not containing a crosslinking group represented by any of the general formulae (a-1) to (a-4) or has a structure of any of the following formulae; R^{1A} is identical to the R^{1A} in the formula (A-1); R^{2A} is identical to the R^{2A} in the formula (1); "n" represents 1 to 20; and M is identical to the M in the formula (A-1).

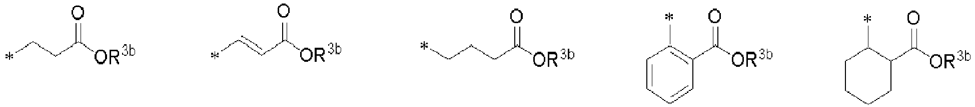

In the formulae, R^{3b} represents an alkyl group having 1 to 10 carbon atoms; and "*" represents an attachment point to a carbon atom of a carbonyl group.

In addition, besides the ligand derived from an organic compound represented by the formula (1) and the additional ligand, the compound may further contain a ligand derived from a dihydric or trihydric alcohol and/or a ligand derived from β-diketone.

When such a compound is contained in a composition for forming a metal-containing film, the crosslinking reaction during baking can be promoted, and the baking temperature in this event can be in a low temperature range. Furthermore, such a compound is preferable since a dense metal-containing film can be formed by the crosslinking reaction being promoted, and etching resistance can be enhanced.

Examples of dihydric or trihydric alcohols include compounds disclosed in paragraphs [0055] to [0060] of JP6189758B2, and in particular, the alcohol is preferably any of the following compounds disclosed in paragraph [0061].

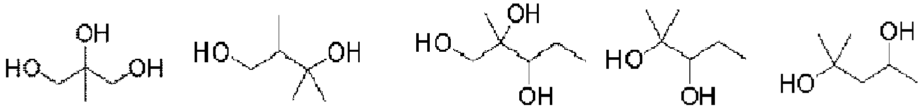

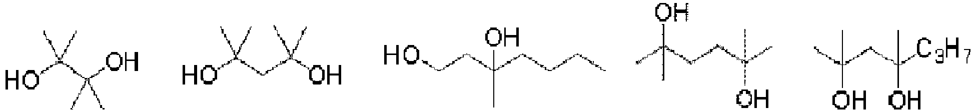

The β-diketone preferably has a structure represented by the following formula (3-a).

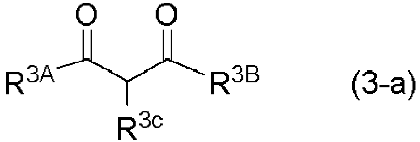

In the formula, R^{3A} and R^{3B} each independently represent a monovalent organic group having 1 to 20 carbon atoms; and R^{3c} represents a hydrogen atom or a monovalent organic group having 1 to 20 carbon atoms.

The R^{3A} and R^{3B} each independently represent a monovalent hydrocarbon group having 1 to 20 carbon atoms, preferably an alkyl group, an aryl group, an alkoxy group, an alkoxycarbonylalkyl group, or a hydrocarbon group substituted with carbonyloxy hydrocarbon, more preferably an alkyl group, an aryl group, an alkoxy group, or an alkoxycarbonylalkyl group, and further preferably a methyl group, an ethyl group, a propyl group, a butyl group, a methoxy group, an ethoxy group, a propoxy group, a butoxy group, or a methoxycarbonylmethyl group.

The R^{3c} represents a hydrogen atom or a monovalent organic group having 1 to 20 carbon atoms, preferably a hydrogen atom or an alkyl group, more preferably a hydrogen atom or a methyl group, and further preferably a hydrogen atom.

Specific examples of β-diketone include 2,4-pentanedione, 3-methyl-2,4-pentanedione, 3-ethyl-2,4-pentanedione, acetoacetic esters, α-alkyl-substituted acetoacetic esters, β-ketopentanoic acid esters, benzoylacetic acid esters, 1,3-acetonedicarboxylic acid esters, malonic acid diesters, malonic acid di-tert-butyl, α-alkyl-substituted malonic acid diesters, α-cycloalkyl-substituted malonic acid diesters, α-aryl-substituted malonic acid diesters, etc. Preferable are 2,4-pentanedione, 3-methyl-2,4-pentanedione, ethyl acetoacetate, diethyl malonate, and malonic acid di-tert-butyl, and further preferable are 2,4-pentanedione, 3-methyl-2,4-pentanedione, and malonic acid di-tert-butyl.

When such a compound is contained in a composition for forming a metal-containing film, the crosslinking reaction during baking can be promoted, and the baking temperature in this event can be in a low temperature range. Furthermore, such a compound is preferable since a dense metal-containing film can be formed by the crosslinking reaction being promoted, and etching resistance can be enhanced.

The compound (A) for forming a metal-containing film may contain, besides the ligand derived from the organic compound represented by the formula (1), any one additional ligand or a plurality of ligands having different structures, selected from the group consisting of a ligand derived from an organic compound represented by the formula (3) and a ligand derived from any of succinic anhydride, maleic anhydride, glutaric anhydride, phthalic anhydride, and cyclohexanedicarboxylic anhydride, and the additional ligands can be adjusted appropriately in accordance with necessary properties required when the compound is used for a composition for forming a metal-containing film. Furthermore, the above-described ligand derived from a dihydric or trihydric alcohol and/or the above-described ligand derived from β-diketone may be contained, and the ligands can be adjusted appropriately in accordance with necessary properties required when the compound is used for a composition for forming a metal-containing film.

When the compound (A) for forming a metal-containing film contains a ligand that is different from the ligand derived from an organic compound represented by the formula (1), the compound preferably contains any ligand derived from succinic anhydride, maleic anhydride, glutaric anhydride, phthalic anhydride, or cyclohexanedicarboxylic anhydride, or a plurality of ligands having different structures, and more preferably contains any one kind of ligand derived from succinic anhydride, maleic anhydride, glutaric anhydride, phthalic anhydride, or cyclohexanedicarboxylic anhydride. When the compound contains a carbonyl ligand as well as the organic compound represented by the formula (1), storage stability of the compound (A) for forming a metal-containing film can be enhanced.

In the compound (A) for forming a metal-containing film, the contained amount of the ligand derived from an organic compound represented by the formula (1) is preferably 10 mol% or more of the total amount of ligands coordinated to the metal atom M, more preferably 30 mol% or more, further preferably 50 mol% or more, and the upper limit is preferably 100 mol%. The amount of the ligands other than the ligand derived from an organic compound represented by the formula (1) is preferably 90 mol% or less of the total amount of ligands coordinated to the metal atom M, more preferably 70 mol% or less, further preferably 50% mol% or less, and the lower limit is preferably 0 mol%. The compound may further contain a ligand other than the above-described ligands, for example, a ligand derived from an alkyl group having 1 to 10 carbon atoms, and such a ligand is preferably contained in an amount of 0 mol% to 50 mol%, more preferably 0 mol% to 30 mol% of the total amount of ligands coordinated to the metal atom M.

When the contained amount of the ligand derived from an organic compound represented by the formula (1) is 10 mol% or more, excellent filling property of the composition for forming a metal-containing film can be achieved. Therefore, this range is favorable. When the composition for forming a metal-containing film is to be used in a process of filling a finer pattern, the contained amount of the ligand derived from an organic compound represented by the formula (1) is preferably increased, and a contained amount of 50 mol% or more is particularly favorable.

### <Synthesis of Compound for Forming Metal-Containing Film>

The inventive compound (A) for forming a metal-containing film is, for example, a compound derived from one or more selected from a hydrolysate of only the metal compound represented by the formula (A-1), a condensate of only the metal compound represented by the formula (A-1), and a hydrolysis condensate of only the metal compound represented by the formula (A-1), and the compound contains a ligand derived from an organic compound represented by the formula (1). Methods for synthesizing the compound are not particularly limited as long as such a compound can be obtained by the method. For example, the compound can be obtained by allowing one or more selected from the group consisting of a hydrolysate of only the metal compound represented by the formula (A-1), a condensate of only the metal compound represented by the formula (A-1), and a hydrolysis condensate of only the metal compound represented by the formula (A-1) to react with the organic compound represented by the formula (1).

Alternatively, the compound (A) for forming a metal-containing film may be obtained by hydrolyzing, condensing, or hydrolysis-condensing a metal compound represented by the following general formula (A-2), having a ligand derived from an organic compound represented by the formula (1).

(R^{2A}COXCOO)ₓM(OR^{1A})_{y} (A-2)

In the formula, M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the general formulae (a-1) to (a-4); X represents a divalent organic group having 2 to 20 carbon atoms; x + y = 4; and "x" and "y" each represent an integer of 1 or more.

That is, the inventive method for manufacturing a compound for forming a metal-containing film includes
allowing one or more selected from the group consisting of a hydrolysate of only the metal compound represented by the following formula (A-1), a condensate of only the metal compound represented by the following formula (A-1), and a hydrolysis condensate of only the metal compound represented by the following formula (A-1) to react with an organic compound represented by the following formula (1) or
hydrolyzing, condensing, or hydrolysis-condensing a metal compound represented by the following general formula (A-2).

   M(OR^{1A})₄ (A-1)

   R^{2A}COXCOOH (1)

In the formulae, M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the following general formulae (a-1) to (a-4); and X represents a divalent organic group having 2 to 20 carbon atoms.

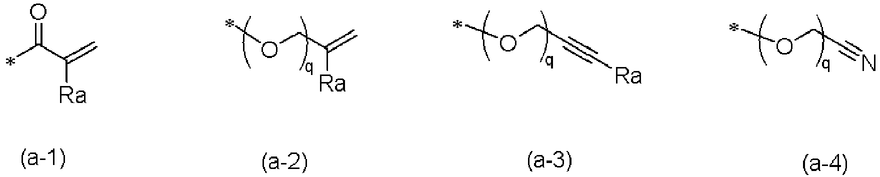

In the general formulae (a-1) to (a-4), Rₐ represents a hydrogen atom or a monovalent organic group having 1 to 10 carbon atoms; "q" represents 0 or 1; and "*" represents an attachment point.

(R^{2A}COXCOO)ₓM(OR^{1A})_{y} (A-2)

In the formula, M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the general formulae (a-1) to (a-4); X represents a divalent organic group having 2 to 20 carbon atoms; x + y = 4; and "x" and "y" each represent an integer of 1 or more.

A compound derived from one or more selected from a hydrolysate of only a metal compound represented by the formula (A-1), a condensate of only a metal compound represented by the formula (A-1), and a hydrolysis condensate of only a metal compound represented by the formula (A-1) has at least one [metal]-[oxygen]-[metal] bond, and therefore, when a metal-containing film is formed using this compound, it is possible to provide a metal-containing film having high hardness and excellent denseness. Moreover, by performing hydrolysis, condensation, or hydrolysis condensation when synthesizing the compound, it is possible to reduce volume shrinkage that accompanies a condensation reaction during baking of the film, and therefore, filling property can be enhanced further.

The hydrolysis or hydrolysis condensation of the metal compound represented by the formula (A-1) or the metal compound represented by the formula (A-2) (hereinafter, metal monomer) can be performed without a catalyst or in the presence of an acid or alkali catalyst to manufacture the inventive compound. In this event, as the acid catalyst, it is possible to use one or more compounds selected from inorganic acids, aliphatic sulfonic acids, aromatic sulfonic acids, aliphatic carboxylic acids, and aromatic carboxylic acids to manufacture the target product. Specific examples of acid catalysts include hydrofluoric acid, hydrochloric acid, hydrobromic acid, sulfuric acid, nitric acid, perchloric acid, phosphoric acid, methanesulfonic acid, benzenesulfonic acid, toluenesulfonic acid, formic acid, acetic acid, propionic acid, oxalic acid, malonic acid, maleic acid, fumaric acid, benzoic acid, etc. The catalyst is preferably used in an amount of 1×10⁻⁶ to 10 mol, more preferably 1×10⁻⁵ to 5 mol, and further preferably 1×10⁻⁴ to 1 mol based on 1 mol of the metal-M-containing monomer.

Alternatively, the inventive compound may be manufactured by hydrolysis-condensing a metal-M-containing monomer in the presence of an alkali catalyst. Examples of the alkali catalyst used in this event include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethyl monoethanolamine, monomethyl diethanolamine, triethanolamine, diazabicyclooctane, diazabicyclocyclononene, diazabicycloundecene, hexamethylenetetramine, aniline, N,N-dimethylaniline, pyridine, N,N-dimethylethanolamine, N,N-diethylethanolamine, N-(β-aminoethyl)ethanolamine, N-methylethanolamine, N-methyldiethanolamine, N-ethylethanolamine, N-n-butylethanolamine, N-n-butyldiethanolamine, N-tert-butylethanolamine, N-tert-butyldiethanolamine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, calcium hydroxide, and the like. The catalyst is preferably used in an amount of 1×10⁻⁶ mol to 10 mol, more preferably 1×10⁻⁵ mol to 5 mol, and further preferably 1×10⁻⁴ mol to 1 mol relative to 1 mol of the metal-M-containing monomer.

When the metal-containing compound is obtained from these metal-M-containing monomers by hydrolysis or hydrolysis condensation thereof, water is preferably added in an amount of 0.01 to 10 mol, more preferably 0.05 to 5 mol, further preferably 0.1 to 3 mol, and particularly preferably 0.1 to 1 mol, per mol of the hydrolysable substituent bonded to the metal-M-containing monomer. The added amount is preferably 10 mol or less, since an apparatus used for the reaction does not become excessively large and is therefore economical, and there is no risk of the metal-containing compound losing stability.

As the operation method, the metal-M-containing monomer is added to an aqueous solution of catalyst to initiate the hydrolysis condensation reaction. In this event, an organic solvent may be added to the aqueous solution of catalyst, or the metal-M-containing monomer may be diluted with an organic solvent, or both of these operations may be performed. The reaction temperature is preferably 0 to 200°C, more preferably 5 to 150°C. As a preferable method, when the metal-M-containing monomer is added dropwise, the temperature is maintained at 5 to 150°C, and then the mixture is aged at 20 to 150°C.

As an alternative reaction operation, water or a water-containing organic solvent is added to the metal-M-containing monomer or an organic solvent containing the metal-M-containing monomer to initiate the hydrolysis reaction. In this event, the catalyst may be added to the metal-M-containing monomer or the organic solvent containing the metal-M-containing monomer, or may be added to the water or the water-containing organic solvent. The reaction temperature is preferably 0 to 200°C, more preferably 5 to 150°C. As a preferable method, when the metal-M-containing monomer is added dropwise, the temperature is maintained at 5 to 150°C, and then the mixture is aged at 20 to 150°C.

The organic solvent which can be added to the aqueous solution of catalyst or with which the metal-containing compound can be diluted is preferably methanol, ethanol, 1-propanol, 2-propanol, 1-butanol, 2-butanol, 2-methyl-1-propanol, acetone, acetonitrile, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, t-butyl propionate, propylene glycol mono-t-butyl ether acetate, γ-butyrolactone, acetylacetone, methyl acetoacetate, ethyl acetoacetate, propyl acetoacetate, butyl acetoacetate, methyl pivaloylacetate, methyl isobutyroyl acetate, methyl caproyl acetate, methyl lauroyl acetate, 1,2-ethanediol, 1,2-propanediol, 1,2-butanediol, 1,2-pentanediol, 2,3-butanediol, 2,3-pentanediol, glycerin, diethylene glycol, hexylene glycol, mixtures thereof, and the like.

Incidentally, the used amount of the organic solvent is preferably 0 to 1,000 ml, particularly preferably 0 to 500 ml per mol of the metal-containing compound. When the organic solvent is used in an amount of 1,000 ml or less, the required reaction vessel does not become too large and is economical.

After that, if necessary, neutralization reaction of the catalyst is carried out and the alcohol generated in the hydrolysis condensation reaction is removed under reduced pressure to obtain an aqueous solution of reaction mixture. In this event, the amount of an acid or alkali usable for the neutralization is preferably 0.1 to 2 equivalents relative to the acid or alkali used as the catalyst, and any substance may be used as long as neutralization can be achieved.

Subsequently, by-products such as alcohol produced by the hydrolysis condensation reaction are preferably removed from the reaction mixture. In this event, the reaction mixture is heated at a temperature of preferably 0 to 200°C, more preferably 10 to 150°C, and further preferably 15 to 150°C, although the temperature depends on the kinds of the added organic solvent, the alcohol produced in the reaction, and so forth. Additionally, in this event, the degree of vacuum is preferably atmospheric pressure or less, more preferably 80 kPa or less in absolute pressure, and further preferably 50 kPa or less in absolute pressure, although the degree of vacuum varies depending on the kinds of the organic solvent, alcohol, etc. to be removed, as well as exhausting equipment, condensation equipment, and heating temperature. In this case, it is difficult to know accurately the amount of alcohol to be removed, but it is desirable to remove about 80 mass% or more of the produced alcohol, etc.

Preferable examples of the final solvent to be added to the metal-containing compound solution include butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, etc.

Such a metal-containing compound makes it possible to provide a composition for forming a metal-containing film that is excellent in storage stability and whose properties do not change over a long period.

The inventive compound (A) for forming a metal-containing film can be manufactured by adding the organic compound represented by the formula (1) to the metal-containing compound obtained by hydrolysis or hydrolysis condensation or to a reaction mixture containing the metal-containing compound.

In a case where a compound (A) for forming a metal-containing film containing a ligand other than the ligand of the formula (1) is to be manufactured, the compound (A) can be manufactured in a similar manner by adding an organic compound derived from the ligand to the metal-containing compound obtained by hydrolysis or hydrolysis condensation or to a reaction mixture containing the metal-containing compound.

### <Composition for Forming Metal-Containing Film>

The present invention can also provide a composition for forming a metal-containing film containing: (A) the above-described compound for forming a metal-containing film; and (B) an organic solvent.

Such a composition for forming a metal-containing film contains the compound for forming a metal-containing film, the compound having high levels of both thermal flowability and thermosetting property, and therefore, can provide a metal-containing film material having better dry etching resistance than that of conventional organic underlayer film materials and also having high filling property and/or high planarizing property.

In the following, the components contained in the inventive composition for forming a metal-containing film other than the compound (A) for forming a metal-containing film will be described.

### <(B) Organic Solvent>

The organic solvent (B) usable in the inventive composition for forming a metal-containing film is not particularly limited, but is preferably capable of dissolving and/or dispersing the compound (A) for forming a metal-containing film and, when contained, (C) a crosslinking agent, (D) a surfactant, (E) an acid generator, (F) metal oxide nanoparticles having an average primary particle size of 100 nm or less, other additives, etc. described below.

Specifically, an organic solvent disclosed in paragraphs [0091] and [0092] in JP2007-199653A may be contained. Furthermore, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts, more preferably 250 to 5,000 parts relative to 100 parts by mass of the compound (A) for forming a metal-containing film.

### <(B-1) High-Boiling-Point Solvent>

In the inventive composition for forming a metal-containing film, the organic solvent (B) may be a mixture of one or more kinds of organic solvent having a boiling point of lower than 180°C and one or more kinds of organic solvent having a boiling point of 180°C or higher ((B-1) a high-boiling-point solvent). That is, the organic solvent (B) may include a high-boiling-point solvent (B-1), and the high-boiling-point solvent (B-1) may be one or more kinds of organic solvent having a boiling point of 180 degrees (180°C) or higher.

The high-boiling-point solvent (B-1) is not particularly limited to hydrocarbons, alcohols, ketones, esters, ethers, or chlorine-based solvents, but can preferably dissolve and/or disperse the components of the inventive composition for forming a metal-containing film. Specific examples of the high-boiling-point solvent (B-1) include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B-1) may be selected suitably from the solvents above, for example, depending on the temperature at which the inventive composition for forming a metal-containing film is heat-treated, etc. The boiling point of the high-boiling-point solvent is preferably 180°C to 300°C, further preferably 200°C to 300°C. It is considered that the solvent having the described-above boiling point can achieved sufficient thermal flowability at the time of film formation, since there is no risk of excessive evaporation rate at the baking (heating), resulting in a resist underlayer film excellent in filling and planarizing properties. Moreover, a solvent having such a boiling point does not remain in the film without evaporating even after the baking. Therefore, there is no risk of the solvent adversely affecting the physical properties, such as etching resistance, of the film.

Furthermore, when the high-boiling-point solvent (B-1) is used, the contained amount is preferably 1 to 30 parts by mass per 100 parts by mass of the organic solvent, having a boiling point lower than 180°C. When the contained amount is as described, sufficient thermal flowability can be imparted at the time of baking, so that the solvent does not remain in the film and cause degradation in the physical properties, such as etching resistance, of the film. Therefore, such an amount is preferable.

When the composition for forming a metal-containing film is usable as a resist underlayer film used in a multilayer resist method, one or more kinds of the compound (A) for forming a metal-containing film and the organic solvent (B) can be contained, and as necessary, the composition may contain additives such as a crosslinking agent (C), a surfactant (D), an acid generator (E), and metal oxide nanoparticles (F) having an average primary particle size of 100 nm or less. On another aspect, the inventive composition for forming a metal-containing film may further contain one or more of a crosslinking agent (C), a surfactant (D), and an acid generator (E).

The inventive composition for forming a metal-containing film can further contain components other than the above-described components, for example, an additive for imparting filling property and/or planarizing property.

In the following, examples of components to be contained in the inventive composition for forming a metal-containing film other than the compound (A) for forming a metal-containing film and the organic solvent (B) will be described.

### [(C) Crosslinking Agent]

To increase the curability of the compound for forming a metal-containing film and thereby further inhibit intermixing with a layer formed on the metal-containing film, for example, the resist upper layer film, the inventive composition for forming a metal-containing film may also contain a crosslinking agent (C). The crosslinking agent is not particularly limited, and various known crosslinking agents can be widely used. Examples include melamine-based crosslinking agents, acrylate-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g. polynuclear phenol-based, such as methylol or alkoxymethyl-based crosslinking agents). The crosslinking agent (C) is preferably contained in an amount of 5 to 50 parts by mass, more preferably 10 to 40 parts by mass relative to 100 parts by mass of the compound (A) for forming a metal-containing film.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the acrylate-based crosslinking agents include dipentaerythritol hexaacrylate.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate] .

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (XL-1).

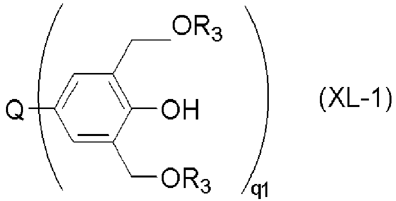

In the formula, Q represents a single bond or a q1-valent hydrocarbon group having 1 to 20 carbon atoms. R₃ represents a hydrogen atom or an alkyl group having 1 to 20 carbon atoms. "q1" represents an integer of 1 to 5.

Q represents a single bond or a q1-valent hydrocarbon group having 1 to 20 carbon atoms. *"*q1*"* represents an integer of 1 to 5, more preferably 2 or 3. Specific examples of Q include groups obtained by removing "q1" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₃ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. R₃ is preferably a hydrogen atom or a methyl group.

Specific examples of the compounds represented by the general formula (XL-1) include the following compounds. Among these, triphenolmethane, triphenolethane, 1,1,1,-tris(4-hydroxyphenyl)ethane, and a hexamethoxymethylated derivative of tris(4-hydroxyphenyl)-1-ethyl-4-isopropylbenzene are preferable from the viewpoint of improving the curability and film thickness uniformity of the organic film. R₃ is as defined above.

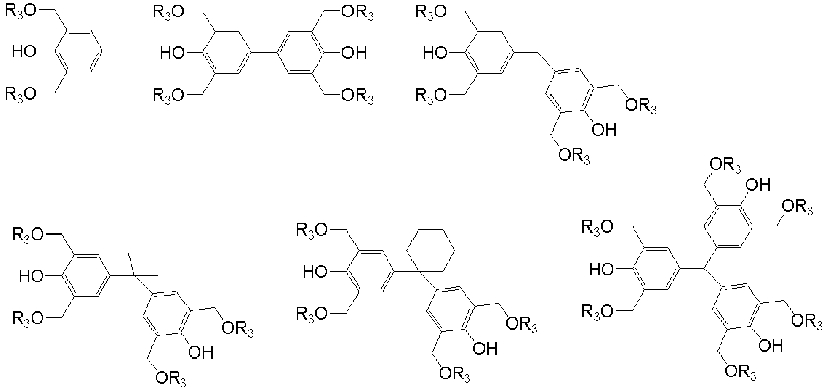

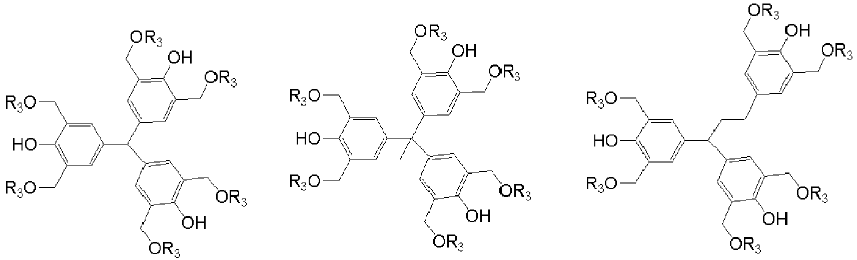

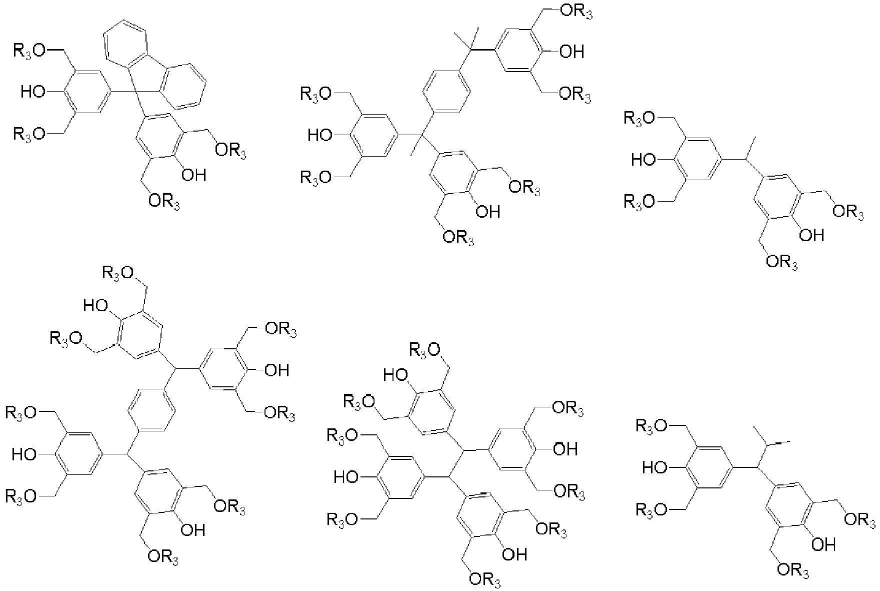

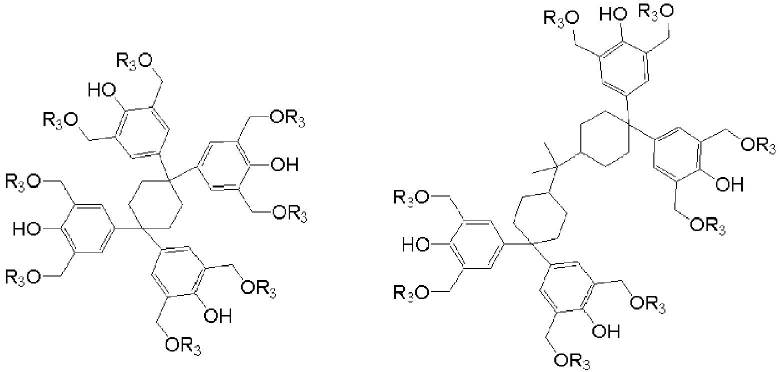

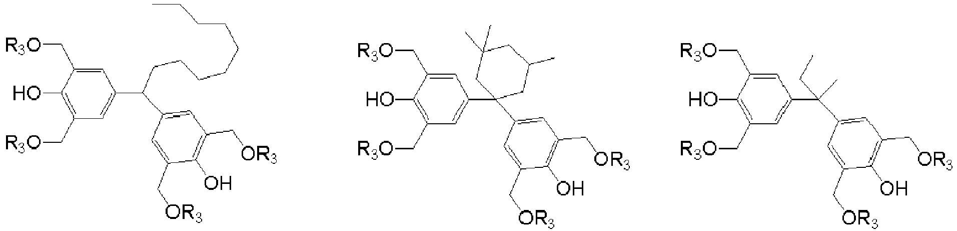

### < (D) Surfactant>

A surfactant (D) may be contained in the inventive composition for forming a metal-containing film in order to improve coating property in spin-coating. Examples of the surfactant include those disclosed in paragraphs [0142] to [0147] of JP2009-269953A. When the surfactant is contained, the contained amount is preferably 0.01 to 10 parts, more preferably 0.05 to 5 parts per 100 parts by mass of the compound (A) for forming a metal-containing film.

### <(E) Acid Generator>

An acid generator may be contained in the inventive composition for forming a metal-containing film in order to promote the curing reaction of the compound (A) for forming a metal-containing film further. The acid generator can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator can be used, or two or more kinds can be used in combination. When an acid generator is contained, the contained amount is preferably 0.05 to 50 parts, more preferably 0.1 to 10 parts relative to 100 parts by mass of the compound (A) for forming a metal-containing film.

### <(F) Metal Oxide Nanoparticles>

The inventive composition for forming a metal-containing film can also contain metal oxide nanoparticles (F) in order to improve dry etching resistance further. Specifically, metal oxide nanoparticles selected from the group consisting of zirconium oxide nanoparticles, hafnium oxide nanoparticles, titanium oxide nanoparticles, tin oxide nanoparticles, and tungsten oxide nanoparticles are preferable.

By selecting such metal oxide, it is possible to form a metal-containing film having better dry etching resistance.

The metal oxide nanoparticles (F) preferably have an average primary particle size of 100 nm or less, more preferably an average primary particle size of 50 nm or less, further preferably an average primary particle size of 30 nm or less, and particularly preferably 15 nm or less. The average primary particle size of the metal oxide nanoparticles before being dispersed in an organic solvent can be determined by a method of measuring the size of primary particles directly from an electron microscope photograph. Specifically, the minor axis diameter and the major axis diameter of each primary particle are measured, and the average of the values is defined as the particle size of the particle. Then, for 100 or more particles, the volume (mass) of each particle is approximated to a cuboid of the determined particle size, and this volume average particle size is determined as the average particle size. Identical results can be obtained when any of a transmission type electron microscope (TEM), a scanning type electron microscope (SEM), and a scanning transmission type electron microscope (STEM) are used.

When the particle size is within such ranges, the particles can exhibit excellent dispersity in a composition for forming a metal-containing film, and can enhance the dry etching resistance of a metal-containing film without causing the degradation of filling and planarizing properties in dense portions of a fine pattern structure.

When the metal oxide nanoparticles (F) are contained, the contained amount is preferably 5 to 50 parts, more preferably 10 to 30 parts per 100 parts by mass of the compound (A) for forming a metal-containing film.

### <Liquid Additive and Thermo-Decomposable Polymer>

In addition, in the inventive composition for forming a metal-containing film, it is preferable to use, as an additive for imparting filling and planarizing properties, for example, a liquid additive having a polyethylene glycol or polypropylene glycol structure, or a thermo-decomposable polymer having a weight reduction rate of 40% by mass or more on heating from 30°C to 250°C and a weight-average molecular weight of 300 to 200,000. This thermo-decomposable polymer preferably contains a repeating unit having an acetal structure represented by the following general formula (DP1) or (DP1a).

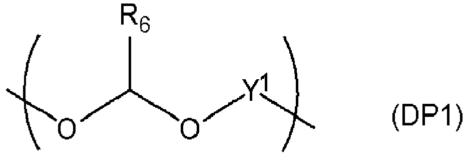

In the formula, R₆ represents a hydrogen atom or a saturated or unsaturated monovalent organic group having 1 to 30 carbon atoms and optionally being substituted. Y¹ represents a saturated or unsaturated divalent organic group having 2 to 30 carbon atoms.

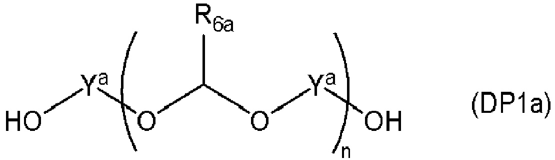

In the formula, R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

When the liquid additive or thermo-decomposable polymer is contained, the contained amount thereof is preferably 5 to 100 parts, more preferably 10 to 50 parts per 100 parts by mass of the compound (A) for forming a metal-containing film.

### <Flowability Accelerator (BP)>

A flowability accelerator (BP) may be contained in the inventive composition for forming a metal-containing film as an additive for providing filling property and/or planarizing property. The flowability accelerator (BP) preferably has one of the organic groups represented by the following general formulae (bpla) and an aromatic ring.

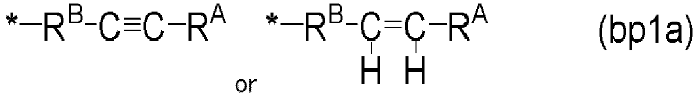

In the formulae, "*" represents an attachment point to an oxygen atom. R^{B} represents a divalent organic group having 1 to 10 carbon atoms. R^{A} represents a hydrogen atom or a monovalent organic group having 1 to 10 carbon atoms.

When the flowability accelerator (BP) contains the organic group represented by one of the general formulae (bp1a), thermal flowability and thermosetting property can be imparted to the compound (A) for forming a metal-containing film. Furthermore, when the flowability accelerator (BP) has an aromatic ring, degradation of the compound (A) for forming a metal-containing film in dry etching resistance can be alleviated.

The flowability accelerator (BP) preferably has at least one constitutional unit represented by any of the following general formulae (BP-1), (BP-2), (BP-3), (BP-4), and (BP-5).

### (Constitutional Units: BP-1, BP-2, and BP-3)

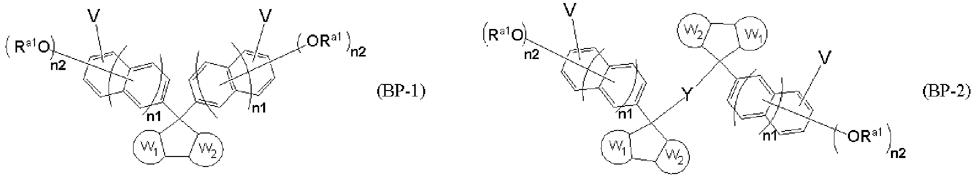

In the general formulae (BP-1) and (BP-2), W₁ and W₂ each independently represent a benzene ring or a naphthalene ring, part of hydrogen atoms in the benzene ring and the naphthalene ring optionally being substituted with a hydrocarbon group having 1 to 6 carbon atoms. R^{a1} represents either group represented by the following general formulae (4). Y represents any group represented by the following general formulae (5). "n₁" represents 0 or 1, *"*n₂*"* represents 1 or 2, and each V independently represents a hydrogen atom or an attachment point.

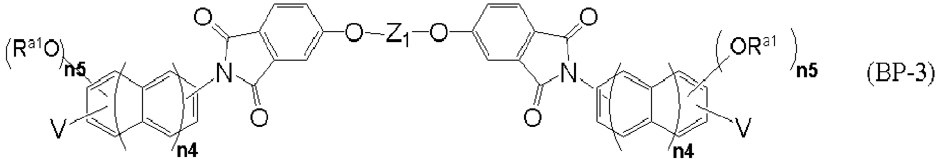

In the general formula (BP-3), Z₁ represents any group represented by the following general formulae (6), and R^{a1} represents either group represented by the following general formulae (4). *"*n₄*"* represents 0 or 1, "n₅" represents 1 or 2, and each V independently represents a hydrogen atom or an attachment point. 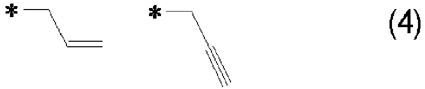
"*" represents an attachment point to an oxygen atom. 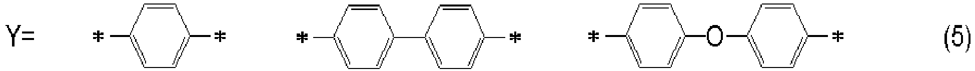
"*" represents an attachment point.

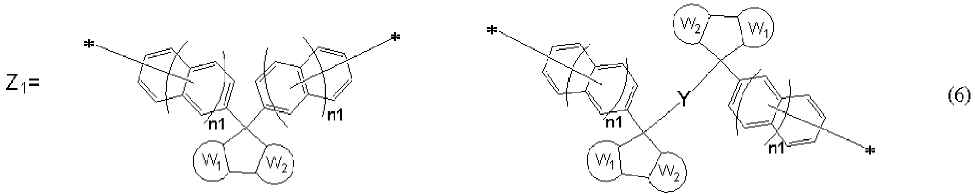

In the general formulae (6), W₁, W₂, Y, and *"*n₁*"* are as defined above.

A resin having a constitutional unit represented by any of the general formulae (BP-1), (BP-2), and (BP-3) has excellent heat resistance, since a condensed carbon ring having a high carbon density including a cardo structure is introduced to the resin. Because the resin has such a characteristic, it is possible to form a metal-containing film that can fill a stepped substrate without generating voids even when baked at a high temperature. Moreover, the resin is also excellent in dry etching resistance, and therefore, when the resin is contained in the inventive composition for forming a metal-containing film, heat resistance and thermal flowability can be imparted without great degradation of the excellent dry etching resistance that the composition for forming a metal-containing film has.

The resin having a constitutional unit represented by any of the general formulae (BP-1), (BP-2), and (BP-3) can be a compound represented by the following general formulae (bp-1) and/or (bp-2) and/or (bp-3).

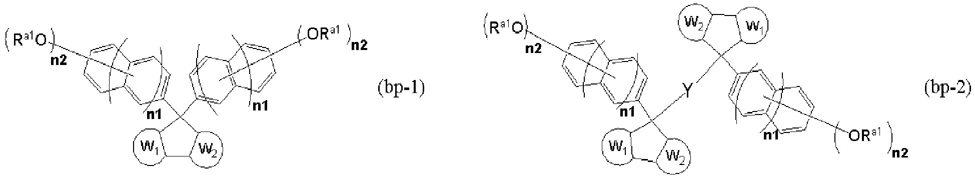

In the general formulae (bp-1) and (bp-2), W₁, W₂, R^{a1}, Y, *"*n₁*"*, and *"*n₂*"* are as described in the description of the general formulae (BP-1) and (BP-2).

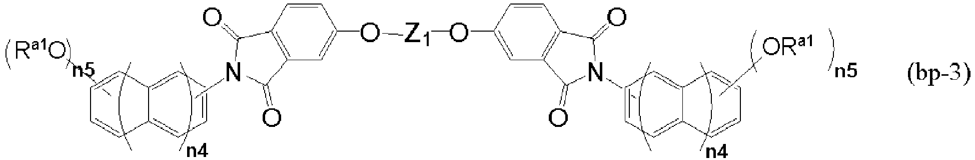

In the general formula (bp-3), Z₁, R^{a1}, *"*n₄*"*, and *"*n₅*"* are as described in the description of the general formula (BP-3).

Specific examples of resins having a constitutional unit represented by any of the general formulae (bp-1), (bp-2), and (bp-3) include the following compounds, but are not limited thereto.

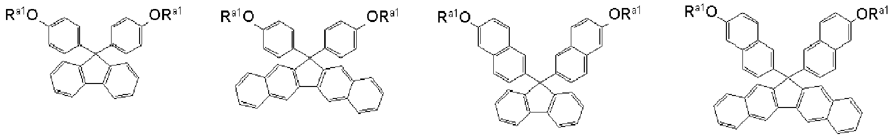

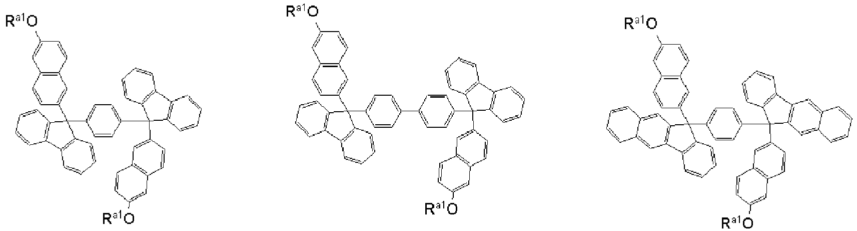

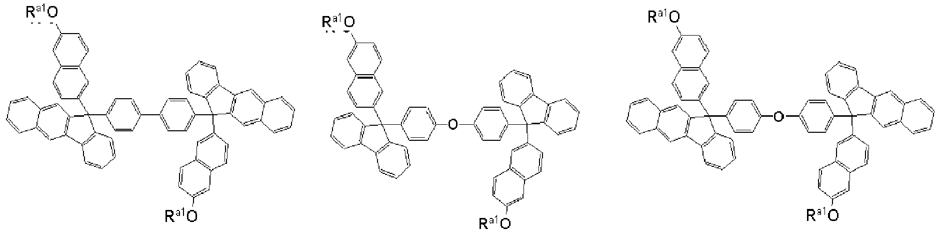

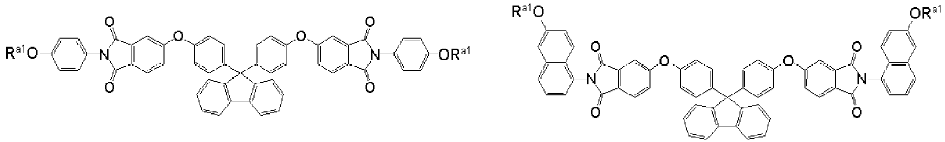

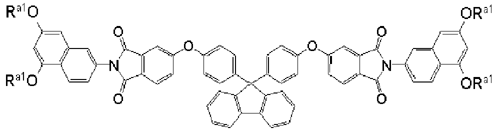

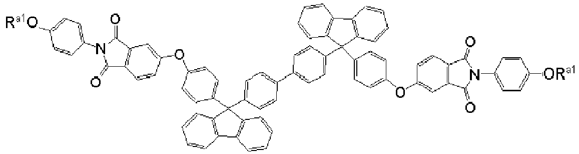

Regarding the resins (bp-1), (bp-2), and (bp-3), the Mw/Mn (that is, the dispersity) is preferably within the range of 1.00 ≤ Mw/Mn ≤ 1.25, further preferably 1.00 ≤ Mw/Mn ≤ 1.10, where Mw is a weight-average molecular weight and Mn is a number-average molecular weight measured by gel permeation chromatography in terms of polystyrene.

A compound having a dispersity within such a range can provide the composition for forming a metal-containing film with even better thermal flowability. Thus, it is possible to provide a composition for forming a metal-containing film having even better filling and/or planarizing properties when the compound is contained in the composition.

Alternatively, the resin having a constitutional unit represented by any of the general formulae (BP-1), (BP-2), and (BP-3) may be a polymer having a repeating unit represented by the following general formula (bp-4) and/or (bp-5) and/or (bp6).

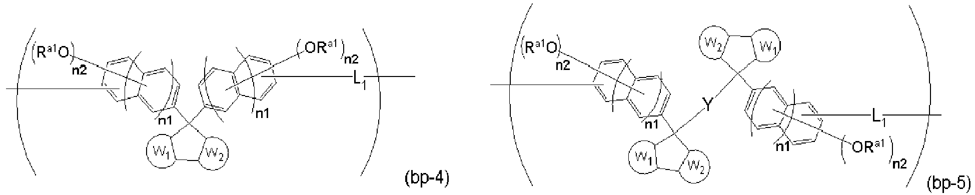

In the general formulae (bp-4) and (bp-5), W₁, W₂, R^{a1}, Y, *"*n₁*"*, and *"*n₂*"* are as described in the description of the general formulae (BP-1) and (BP-2), and L₁ represents a divalent organic group having 1 to 40 carbon atoms.

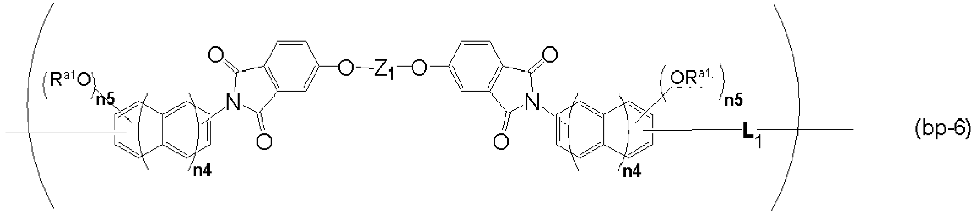

In the general formula (bp-6), Z₁, R^{a1}, *"*n₄*"*, and "n₅" are as described in the description of the general formula (BP-3), and L₁ represents a divalent organic group having 1 to 40 carbon atoms.

The polymer is obtained with compounds represented by any of the general formulae (bp-1), (bp-2), and (bp-3), and because the compounds are used, the polymer has excellent dry etching resistance and heat resistance. In addition, since the polymer is not a monomer but a polymer having repeating units, the amount of outgas component is small, and the polymer has a molecular weight distribution; therefore, crystallinity is alleviated, and improved film forming property can also be expected.

L₁, which is a linking group contained in the repeating units of any of the general formulae (bp-4), (bp-5), and (bp-6), is a divalent organic group having 1 to 40 carbon atoms, and specific examples include the following.

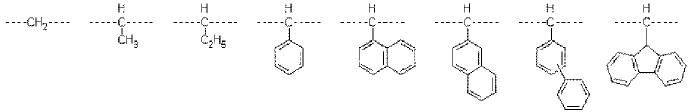

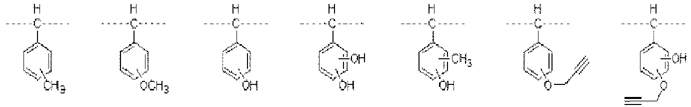

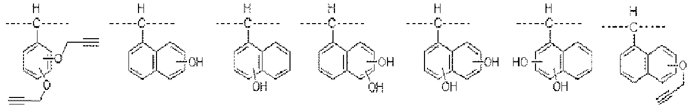

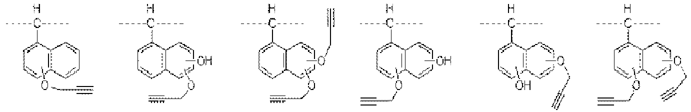

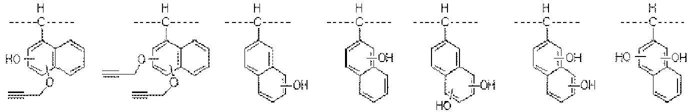

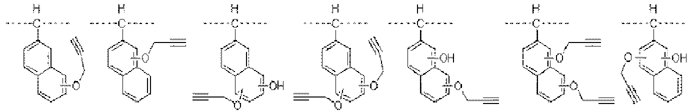

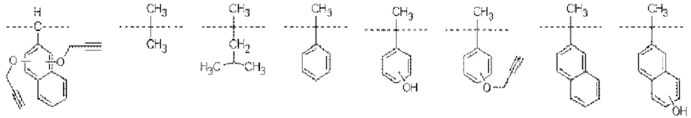

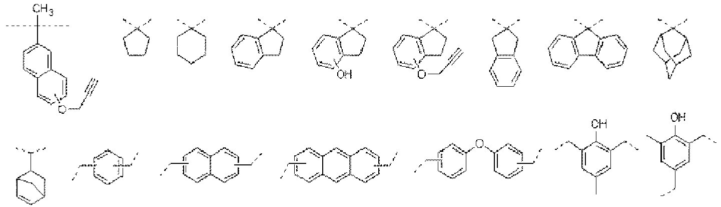

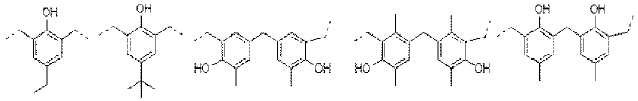

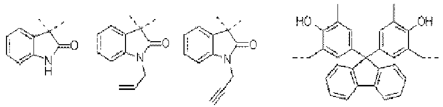

Furthermore, the linking group L₁ of the polymer is preferably as in the following general formula (10).

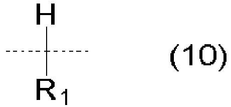

In the general formula (10), R₁ represents a hydrogen atom or an organic group having 6 to 20 carbon atoms and including an aromatic ring, and a broken line represents an attachment point.

Specific examples of the general formula (10) include the following. In particular, in view of the availability of raw materials, a methylene group is preferable, that is, R₁ is preferably a hydrogen atom.

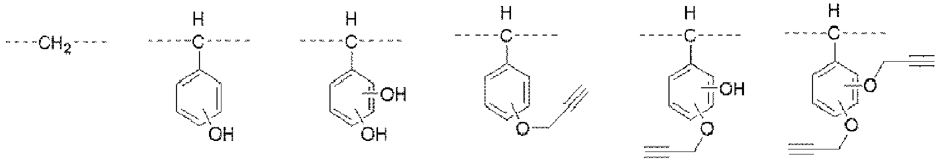

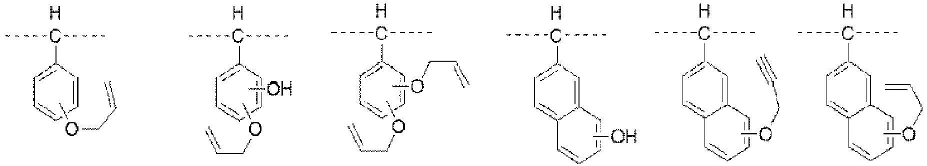

Furthermore, the polymer having the repeating structural units represented by any of the general formulae (bp-4), (bp-5), and (bp-6) preferably has a weight-average molecular weight Mw of 1,000 to 12,000, further preferably 2,000 to 10,000 as measured by gel permeation chromatography in terms of polystyrene.

When the molecular weight is within such a range, solubility in an organic solvent can be ensured, and it is possible to suppress sublimation products that are generated during baking. Furthermore, the thermal flowability of the composition for forming a metal-containing film can be improved, and therefore, it is possible to provide a composition for forming a metal-containing film having better filling and/or planarizing properties when the polymer is contained in the composition.

### (Constitutional Unit: BP-4)

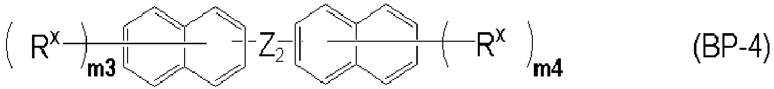

In the formula, *"*m₃*"* and *"*m₄*"* each represent 1 or 2. Z₂ represents a single bond or any structure represented by the following general formulae (7). R^{x} represents any structure represented by the following general formulae (8) .

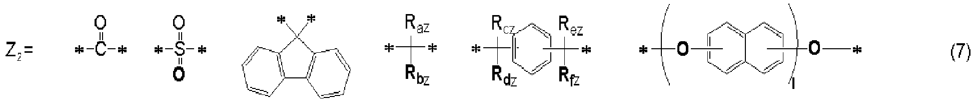

In the formulae, "*" represents an attachment point. "l" represents an integer of 0 to 3. R_{az} to R_{fz} each independently represent a hydrogen atom, an alkyl group having 1 to 10 carbon atoms and optionally having a substituent fluorine atom, a phenyl group optionally having a substituent fluorine atom, or a phenylethyl group optionally having a substituent fluorine atom, R_{az} and R_{bz} optionally being bonded to each other to form a cyclic compound.

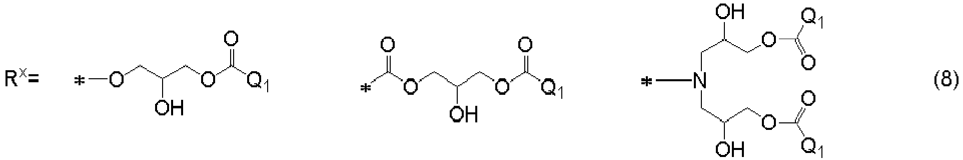

In the formulae, "*" represents an attachment point to an aromatic ring. Q₁ represents a linear saturated hydrocarbon group having 1 to 30 carbon atoms or a structure represented by the following general formula (9) .

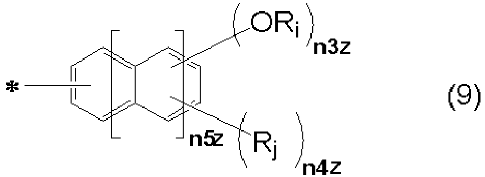

In the formula, "*" represents an attachment point to a carbonyl group. Rᵢ represents either of the general formulae (4). Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 1 to 10 carbon atoms. *"*n_{3z}*"* and "n_{4z}" each represent a number of substituents on an aromatic ring, the number each representing an integer of 0 to 7, provided that n_{3z}+n_{4z} is 0 or more and 7 or less. *"*n_{5z}*"* represents 0 to 2.

From the viewpoint of dry etching resistance and heat resistance, the Z₂ in the general formula (BP-4) is preferably a single bond or one of the structures represented by the formulae (7).

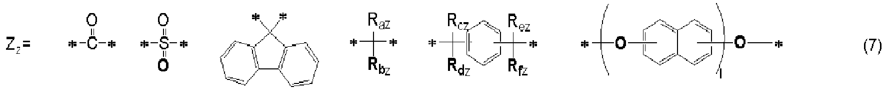

In the formulae, "*" represents an attachment point, and "l" is as in the formulae (7).

In the general formulae (8), when Q₁ represents a linear hydrocarbon group having 1 to 30 carbon atoms, methylene groups constituting Q₁ may be substituted with an oxygen atom or a carbonyl group. From the viewpoints of dry etching resistance and heat resistance, Q₁ preferably has a structure represented by the general formula (9).

A compound containing a constitutional unit represented by the general formula (BP-4) has a structure in which aromatic rings are linked by a single bond or one of the general formulae (7), and therefore, has a high carbon density. Accordingly, a composition for forming a metal-containing film containing such a compound has excellent heat resistance. Meanwhile, the structure of the linking group Z₂ can be selected appropriately from various linking groups in accordance with the desired performance, as shown in the formulae (7). In particular, by introducing a structure represented by one of the formulae (7) as the linking group Z₂, heat resistance and/or etching resistance can be provided without film forming property being degraded. Moreover, since the compound has a highly flexible terminal moiety R^{x}, the composition for forming a metal-containing film can be formed into a thick film without generating defects such as cracks, even though the compound includes a rigid aromatic ring structure. Furthermore, the terminal moiety R^{x} includes a terminal group Q₁ that provides thermal flowability. As the terminal group Q₁, it is possible to introduce at any proportion a flexible hydrocarbon structure that contributes to the improvement of thermal flowability and a rigid aromatic ring structure that contributes to etching resistance and heat resistance, depending on the required performance. As described above, a composition for forming a metal-containing film containing such a compound can realize high levels of filling and/or planarizing properties and heat resistance, and in accordance with required properties, a thick film can be formed.

### (Constitutional Unit: BP-5)

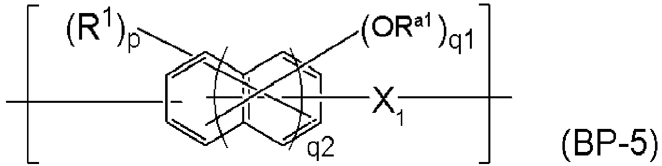

In the general formula (BP-5), R¹ represents a saturated monovalent organic group having 1 to 30 carbon atoms or an unsaturated monovalent organic group having 2 to 30 carbon atoms. X₁ represents a divalent organic group having 1 to 30 carbon atoms. R^{a1} represents either of the general formulae (4). "p" represents an integer of 0 to 5 and *"*q₁*"* represents an integer of 1 to 6, provided that p+q₁ is an integer of 1 or more and 6 or less. *"*q₂*"* represents 0 or 1.

Examples of the divalent organic group having 1 to 30 carbon atoms represented by X₁ in the general formula (BP-5) include: alkanediyl groups, such as a methylene group, an ethanediyl group, a propanediyl group, a butanediyl group, a pentanediyl group, a hexanediyl group, an octanediyl group, and a decanediyl group; monocyclic cycloalkanediyl groups, such as a cyclopropanediyl group, a cyclobutanediyl group, a cyclopentanediyl group, a cyclohexanediyl group, a cycloheptanediyl group, a cyclooctanediyl group, a cyclodecanediyl group, a methylcyclohexanediyl group, and an ethylcyclohexanediyl group; polycyclic cycloalkanediyl groups, such as a bicyclo[2.2.1]heptanediyl group, a bicyclo[2.2.2]octanediyl group, a tricyclo[5.2.1.0^{2.6}]decanediyl group (a dicyclopentylene group), a tricyclo[3.3.1.1^{3.7}]decanediyl group, a tetracyclo [6.2.1.1^{3,6}.0^{2,7}] dodecanediyl group, and an adamantanediyl group; and arenediyl groups, such as a phenylene group and a naphthylene group.

Examples of alkanediyloxy groups represented by the X₁ include groups containing a combination of the above alkanediyl group and an oxygen atom. Meanwhile, examples of cycloalkanediyloxy groups represented by the X₁ include groups containing a combination of the above cycloalkanediyl group and an oxygen atom.

Part or all of the hydrogen atoms in the alkanediyl groups, cycloalkanediyl groups, alkanediyloxy groups, cycloalkanediyloxy groups, arenediyl groups, etc. may be substituted, and examples of substituents include the groups that are examples of substituents that the organic group represented by R^{a} may have.

Examples of the organic group represented by X₁ include groups represented by the following formulae and so forth.

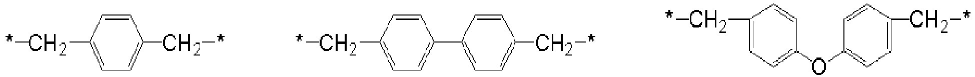

In the formulae, "*" represents an attachment point.

The X₁ is preferably a methylene group from the viewpoint of the availability of raw materials.

Specific examples of the resin having a structural unit represented by the general formula (BP-5) include the following.

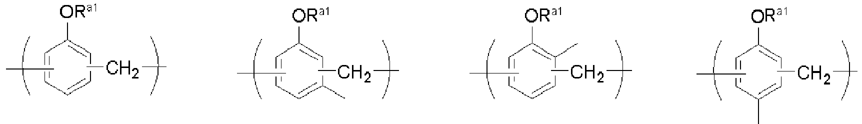

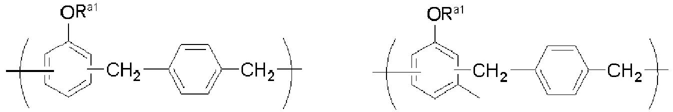

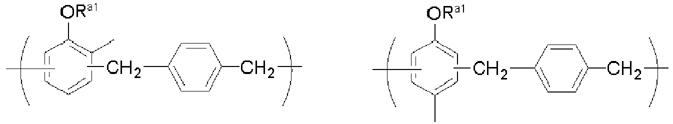

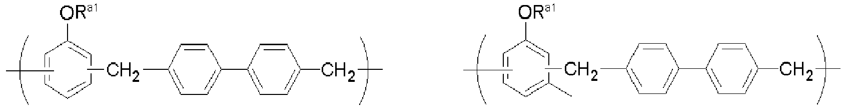

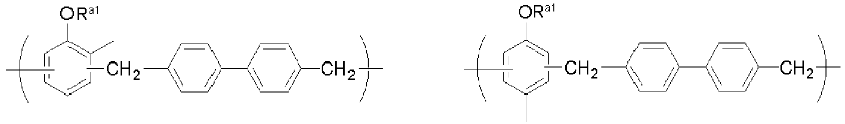

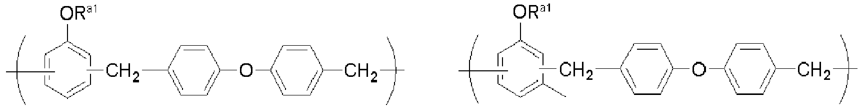

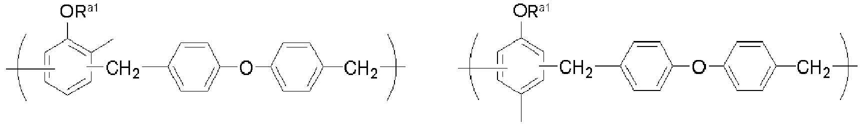

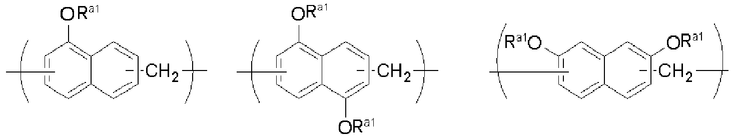

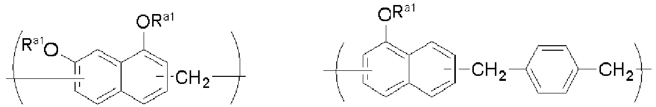

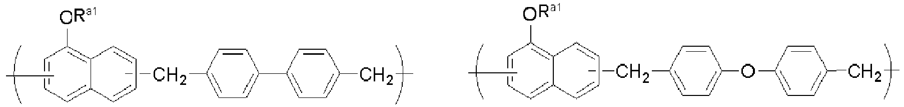

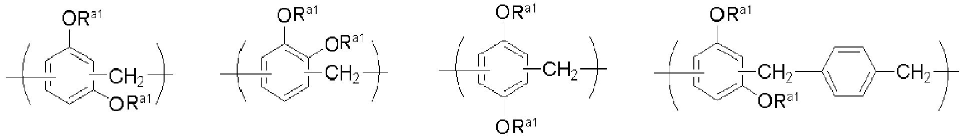

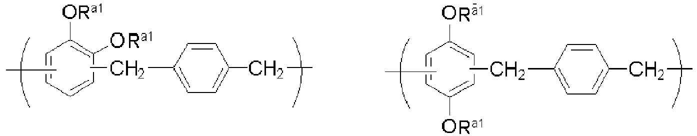

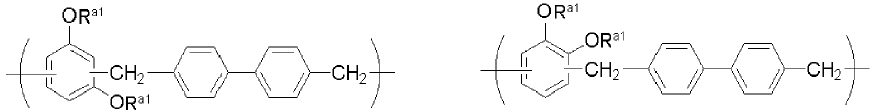

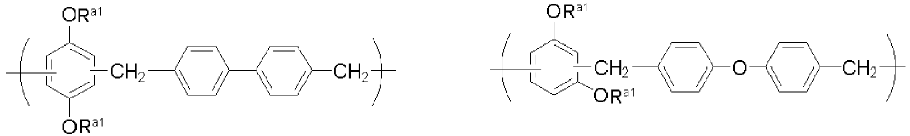

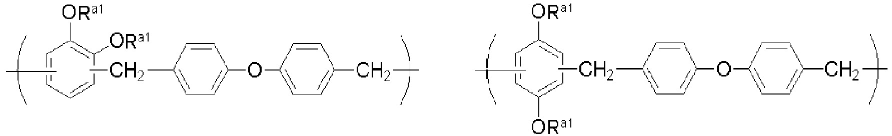

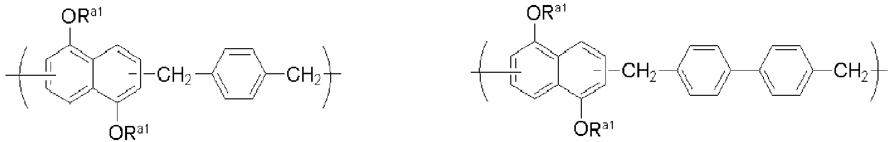

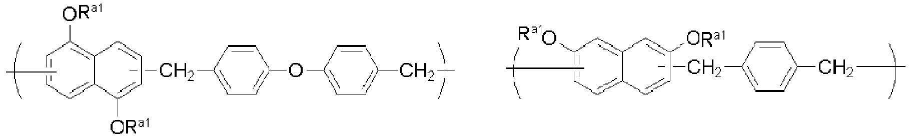

A polymer containing the constitutional unit represented by the general formula (BP-5) has a structure in which aromatic rings are linked by an organic group (X₁), and has a high carbon density. Accordingly, a composition for forming a metal-containing film containing such a compound exhibits high dry etching resistance, and also has excellent heat resistance. Furthermore, an organic group, which contributes to the improvement of thermal flowability, having a structure represented by the general formulae (4) is bonded directly to an aromatic ring via an oxygen atom, the aromatic ring being a mother nucleus structure of the resin. Therefore, a composition for forming a metal-containing film containing such a polymer can achieve high levels of filling property and/or planarizing property, and also of heat resistance and/or etching resistance. Furthermore, the aromatic structure of the mother nucleus is not excessively rigid, and forms a repeating structure through the organic group (X₁), being a linking group, and therefore, a composition for forming a metal-containing film can be formed without generating defects such as cracks.

In the inventive composition for forming a metal-containing film, the flowability accelerator (BP) is preferably contained in an amount of 50% by mass or less, more preferably 30% by mass or less, and further preferably 20% by mass or less based on 100 parts by mass of the compound for forming a metal-containing film.

The amount of the flowability accelerator to be contained can be adjusted to any proportion, depending on the properties required in the process in which the inventive composition for forming a metal-containing film is used. When it is desired to minimize the degradation of dry etching resistance, the proportion of the flowability accelerator can be reduced. When the degradation of dry etching resistance can be tolerated to some extent, and it is desired to improve the filling and planarizing properties further, the proportion of the flowability accelerator can be increased.

### <Method for Forming Metal-Containing Film>

The present invention provides a method for forming, by using the above-described composition for forming a metal-containing film, for example, a resist underlayer film of a multilayer resist film used in lithography or a metal-containing film (filling film) that serves as a planarizing film for the manufacture of semiconductor.

In the method for forming a resist underlayer film by using the inventive composition for forming a metal-containing film, a substrate to be processed is coated with the above-described composition for forming a metal-containing film by a spin-coating method or the like. Using the spin-coating method or the like ensures a desirable filling property. After spin-coating, baking (heating) is performed so as to evaporate the solvent and promote a crosslinking reaction to prevent mixing with the resist upper layer film and the resist middle layer film. The baking is preferably performed at a temperature of 100°C or higher and 600°C or lower for 10 to 600 seconds, more preferably at a temperature of 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

In the method for forming a resist underlayer film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film.

By baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal-containing film during the baking, the absorption does not increase and the etching resistance does not decrease, which is preferable.

### <Patterning Process Using Composition for Forming Metal-Containing Film>

The present invention provides, as a patterning process according to a two-layer resist process using the above-described composition for forming a metal-containing film, a patterning process for forming a pattern in a substrate to be processed, including the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas.

The present invention also provides, as a patterning process according to a three-layer resist process using the above-described composition for forming a metal-containing film, a patterning process for forming a pattern in a substrate to be processed, including the steps of:
(II-1) applying the above-described composition for forming a metal-containing film onto a substrate to be processed, followed by heating to form a metal-containing film;
(II-2) forming a resist middle layer film on the metal-containing film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal-containing film by dry etching while using the resist middle layer film having the transferred pattern as a mask; and
(II-7) processing the substrate to be processed while using the metal-containing film having the formed pattern as a mask to form the pattern in the substrate to be processed.

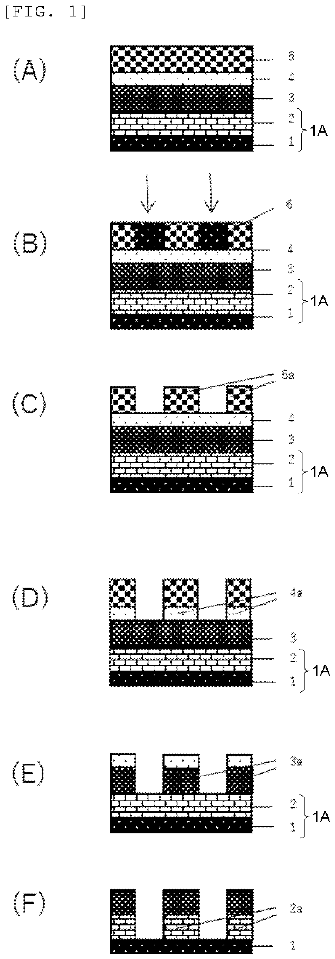

With reference to FIG. 1, an example of a patterning process according to a three-layer resist process will be described. In the present invention, as a patterning process according to a three-layer resist process using the above-described composition for forming a metal-containing film, a metal-containing film 3 is formed on a layer 2 to be processed of a substrate 1A to be processed, including the layer 2 to be processed formed on a substrate 1, by using the above-described composition for forming a metal-containing film, a resist middle layer film 4 is formed on the metal-containing film 3 by using a resist middle layer film material, and a resist upper layer film 5 is formed on the middle layer film 4 by using a photoresist material, as in FIG. 1(A). Subsequently, an exposure portion 6 of the resist upper layer film is subjected to pattern exposure as in FIG. 1(B). Then, development is performed with a developer to form a resist upper layer film pattern 5a in the resist upper layer film as in FIG. 1(C). Next, the pattern is transferred to the resist middle layer film by dry etching while using the resist upper layer film having the formed pattern as a mask to form a resist middle layer film pattern 4a, as in FIG. 1(D). Subsequently, the pattern is transferred to the metal-containing film by dry etching while using the resist middle layer film having the transferred pattern as a mask to form a metal-containing film pattern 3a, as in FIG. 1(E). Subsequently, the layer 2 to be processed of the substrate 1A to be processed is processed while using the metal-containing film having the formed pattern as a mask to form a pattern 2a in the substrate 1A to be processed, as in FIG. 1(F).

A silicon-containing resist middle layer film, which can be used as an example of the middle layer film of the above-described three-layer resist process, exhibits etching resistance with respect to a chlorine-based gas. Therefore, when a silicon-containing resist middle layer film is used as the middle layer film in the three-layer resist process, the dry etching of the metal-containing film that is performed while using the silicon-containing resist middle layer film as a mask is preferably performed using an etching gas mainly containing a chlorine-based gas.

As the silicon-containing resist middle layer film that can be used in the three-layer resist process, a polysiloxane-based middle layer film is also favorably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is to be cross-linked by an acid or heat.

In addition, the present invention provides, as another embodiment of a patterning process by way of a four-layer resist process using the above-described composition for forming a metal-containing film, a patterning process including the steps of:
forming a metal-containing film on a substrate to be processed by using the above-described composition for forming a metal-containing film;
forming a silicon-containing resist middle layer film on the metal-containing film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the metal-containing film by dry etching while using the silicon-containing resist middle layer film having the transferred pattern as a mask; and
processing the substrate to be processed while using the metal-containing film having the formed pattern as a mask, thereby forming the pattern in the substrate to be processed.

Alternatively, an inorganic hard mask may be formed instead of the silicon-containing middle layer film. In this case, a pattern, for example, a semiconductor device circuit pattern, can be formed in a substrate to be processed by a patterning process for forming a pattern in a substrate to be processed, including the steps of:
(III-1) applying the above-described composition for forming a metal-containing film onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

When the inorganic hard mask is formed on the metal-containing film as described above, a silicon oxide film, a silicon nitride film, and a silicon oxynitride film (SiON film) can be formed by a CVD method, an ALD method, etc. Examples of the method for forming the silicon nitride film are disclosed, for example, in JP2002-334869A and WO2004/066377A1. The film thickness of the inorganic hard mask is preferably 5 to 200 nm, more preferably 10 to 100 nm. The SiON film, which has a high function as an antireflective film, is the most favorably used as the inorganic hard mask. Since the substrate temperature increases to 300 to 500°C when the SiON film is formed, the metal-containing film needs to withstand a temperature of 300 to 500°C. The composition for forming a metal-containing film used in the present invention has high heat resistance and can withstand a high temperature of 300 to 500°C. Thus, the metal-containing film formed by spin-coating and the inorganic hard mask formed by the CVD method or the ALD method can be combined.

A photoresist film may be formed on the inorganic hard mask as the resist upper layer film as described above. Alternatively, an organic antireflective film (BARC) or an adhesive film may be formed on the inorganic hard mask by spin-coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

For example, one embodiment of the inventive patterning process is a patterning process for forming a pattern in a substrate to be processed, including the steps of:
(IV-1) applying the above-described composition for forming a metal-containing film onto a substrate to be processed, followed by heating to form a metal-containing film;
(IV-2) forming an organic middle layer film on the metal-containing film;
(IV-3) forming a silicon-containing resist middle layer film or a combination of an organic thin film and an inorganic hard mask middle layer film selected from a silicon oxide film, a silicon nitride film, and a silicon oxynitride film on the organic middle layer film;
(IV-4) forming a resist upper layer film on the silicon-containing resist middle layer film or the organic thin film by using a photoresist material;
(IV-5) subjecting the resist upper layer film to pattern exposure and then development with a developer to form a pattern in the resist upper layer film;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the organic middle layer film by dry etching while using the silicon-containing resist middle layer film or the inorganic hard mask middle layer film having the transferred pattern as a mask;
(IV-8) transferring the pattern to the metal-containing film by dry etching while using the organic middle layer film having the transferred pattern as a mask; and
(IV-9) processing the substrate to be processed while using the metal-containing film having the formed pattern as a mask to form the pattern in the substrate to be processed.

In the above-described patterning process, the resist upper layer film may be either a positive type or a negative type, and it is possible to use a composition similar to the typically used photoresist composition. The photoresist composition may also contain a metal atom such as Sn, In, Ga, Ge, Al, Ce, La, Cs, Zr, Hf, Ti, Bi, Sb, and Zn. In a case where the resist upper layer film is formed with the photoresist composition, a spin-coating method may be employed, or the film may be formed by a deposition treatment according to CVD or ALD.

In a case where the photoresist composition is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

In a case where the photoresist composition is to be formed by a deposition treatment according to CVD or ALD, the resist composition is a metal oxide film having photosensitivity to EUV, and the metal is selected from Sn, Zr, Hf, Ti, Bi, Sb, etc. In particular, Sn, which has excellent photosensitivity to EUV, is preferable. The metal oxide-containing film may be a photosensitive organometallic oxide-containing film such as an organotin oxide (for example, haloalkyl Sn, alkoxyalkyl Sn, or amidoalkyl Sn). Some specific examples of suitable precursors include trimethyltin chloride, dimethyltin dichloride, methyltin trichloride, tris(dimethylamino)methyl tin(IV), and (dimethylamino)trimethyl tin(IV).

The metal oxide-containing film may be deposited PECVD or PEALD, for example, by using a Lam Vector (registered trademark) tool, separating the Sn oxide precursor from O precursor/plasma in the ALD implementation. Deposition temperature is preferably 50°C to 600°C. Deposition pressure is preferably between 100 and 6000 mTorr. Precursor liquid flow rates for metal oxide-containing film (e.g., an organotin oxide precursor) can be 0.01 to 10 ccm, and gas flow rates (CO₂, CO, Ar, and N₂) can be 100 to 10000 sccm. Plasma powers can be 200 to 1000 W per 300 mm wafer station, using a high-frequency plasma (e.g., 13.56 MHz, 27.1 MHz, or higher). Deposited thickness is preferably 100 to 2000 Å.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask in the three-layer resist process is performed while using the upper layer resist pattern as a mask by using a fluorocarbon-based gas. In this manner, a silicon-containing resist middle layer film pattern or an inorganic hard mask pattern is formed.

Next, the metal-containing film is etched while using the obtained silicon-containing resist middle layer film pattern or inorganic hard mask pattern as a mask. The etching of the metal-containing film is preferably performed using an etching gas mainly containing a chlorine-based gas.

The subsequent etching of a body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal-containing film obtained by using the inventive composition for forming a metal-containing film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the patterning processes using the inventive composition for forming a metal-containing film, it is preferable to use a substrate to be processed having a structure or step having a height of 30 nm or more. As described above, the inventive composition for forming a metal-containing film has excellent filling and planarizing properties, so that a flat cured film can be formed even when the substrate to be processed has a step (irregularities) or structure having a height of 30 nm or more. The height of the structure or step of the substrate to be processed is preferably 30 nm or more, more preferably 50 nm or more, and more preferably 100 nm or more. In the method of processing a stepped substrate having a pattern of the above-described height, filling and planarizing by forming a film of the inventive composition for forming a metal-containing film makes it possible to achieve a uniform film thickness in the subsequently formed resist middle layer film and resist upper layer film. Therefore, it is easy to ensure the exposure depth margin (DOF) at the time of photolithography, which is very desirable.

Furthermore, the present invention provides, as a patterning process by way of a four-layer resist process using the above-described composition for forming a metal-containing film, a patterning process including the steps of:
forming a metal-containing film on a substrate to be processed by using the above-described composition for forming a metal-containing film;
forming an organic middle layer film on the metal-containing film by using an organic middle layer film material;
forming a silicon-containing resist middle layer film on the organic middle layer film by using a silicon-containing resist middle layer film material;
if necessary, forming an organic antireflective film (BARC) or an adhesive film on the silicon-containing resist middle layer film;
forming a resist upper layer film on the BARC or on the adhesive film by using a photoresist material;
subjecting the resist upper layer film to pattern exposure and then development with a developer, thereby forming a pattern in the resist upper layer film;
transferring the pattern to the BARC or the adhesive film and to the silicon-containing resist middle layer film by dry etching while using the resist upper layer film having the formed pattern as a mask;
transferring the pattern to the organic middle layer film by dry etching while using the silicon-containing resist middle layer film having the transferred pattern as a mask;
transferring the pattern to the metal-containing film while using the organic middle layer film as a mask; and
processing the substrate to be processed while using the metal-containing film having the formed pattern as a mask, thereby forming the pattern in the substrate to be processed.

As an organic middle layer film material that can be used for the organic middle layer film, it is possible to use: materials already known as materials for three-layer resist methods or materials for an underlayer film containing a silicon resist composition for two-layer resist methods; materials known as resist underlayer film materials for two-layer resist methods and three-layer resist methods, the materials including various resins, such as a 4,4'-(9-fluorenylidene)bisphenol novolak resin (molecular weight: 11,000) disclosed in JP2005-128509A, and also other novolak resins; etc. Furthermore, if it is desired for the resin to have a higher heat resistance than ordinary novolaks, a polycyclic skeleton can be introduced, as in a 6,6'-(9-fluorenylidene)-di(2-naphthol) novolak resin, and furthermore, a polyimide-based resin can also be selected (e.g. JP2004-153125A).

The organic middle layer film can be formed on the substrate to be processed by using a composition solution and by a spin-coating method or the like in the same manner as the photoresist composition. After forming the organic underlayer film by a spin-coating method or the like, it is desirable to bake the substrate in order to evaporate the organic solvent. The baking temperature is preferably 80 to 400°C, and the baking time is preferably 10 to 300 seconds.

Instead of the organic resist underlayer film material, it is also possible to adopt an organic hard mask formed by a CVD method or an ALD method.

The organic middle layer film in the multilayer resist process described above exhibits etching resistance with respect to chlorine-based gas. Therefore, the dry etching of the metal-containing film that is performed while using the organic middle layer film as a mask in the multilayer resist process is preferably performed using an etching gas mainly containing a chlorine-based gas.

### <Tone-Reversal Patterning Process Using Composition for Forming Metal-Containing Film>

Furthermore, the present invention provides, as a tone-reversal patterning process using the above-described composition for forming a metal-containing film, a tone-reversal patterning process for forming a pattern in a substrate to be processed, including the steps of:
(V-1) forming a resist underlayer film on a substrate to be processed;
(V-2) forming a resist middle layer film or a combination of an organic thin film and an inorganic hard mask middle layer film selected from a silicon oxide film, a silicon nitride film, and a silicon oxynitride film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the above-described composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

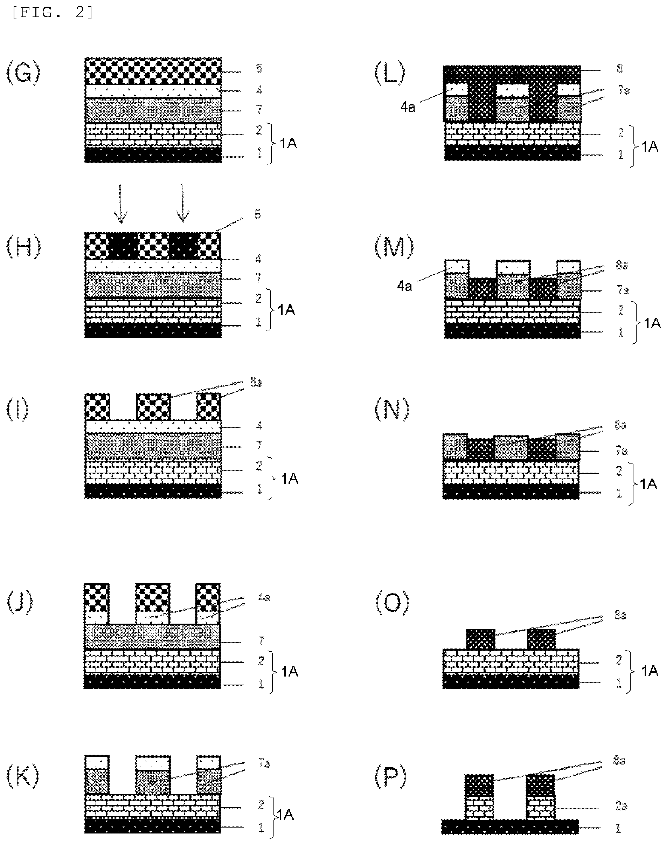

With reference to FIG. 2, a tone-reversal patterning process using a composition for forming a metal-containing film will be described. In the present invention, as a tone-reversal patterning process using such a composition for forming a metal-containing film, a resist underlayer film 7 is formed on a layer 2 to be processed of a substrate 1A to be processed, including the layer 2 to be processed formed on a substrate 1, a resist middle layer film 4 or a combination of an organic thin film and an inorganic hard mask middle layer film selected from a silicon oxide film, a silicon nitride film, and a silicon oxynitride film is formed on the resist underlayer film 7, a resist upper layer film 5 is formed on the resist middle layer film 4 or the combination of the organic thin film and the inorganic hard mask middle layer film by using a photoresist material, as in FIG. 2(G). Subsequently, an exposure portion 6 of the resist upper layer film is subjected to pattern exposure as in FIG. 2(H). Then, development is performed with a developer to form a resist upper layer film pattern 5a in the resist upper layer film as in FIG. 2(I). Next, the pattern is transferred to the resist middle layer film or to the organic thin film and the inorganic hard mask middle layer film by dry etching while using the resist upper layer film having the formed pattern as a mask to form a resist middle layer film pattern 4a or an inorganic hard mask middle layer film pattern, as in FIG. 2(J). Subsequently, the pattern is transferred to the resist underlayer film by dry etching while using the resist middle layer film or the inorganic hard mask middle layer film having the transferred pattern as a mask to form a resist underlayer film pattern 7a, as in FIG. 2(K). Subsequently, the resist underlayer film having the formed pattern is covered with a metal-containing film 8 by using the above-described composition for forming a metal-containing film, thereby filling a space between the resist underlayer film patterns 7a with the metal-containing film 8, as in FIG. 2 (L). Subsequently, the metal-containing film covering the resist underlayer film having the formed pattern is etched back by a chemical stripper or dry etching to form a reversed metal-containing film pattern 8a, as in FIG. 2(M). Subsequently, the resist middle layer film 4a or the hard mask middle layer film remaining on the upper surface of the resist underlayer film pattern 7a is removed by dry etching to expose the upper surface of the resist underlayer film pattern 7a as in FIG. 2(N). Subsequently, the resist underlayer film pattern 7a with its surface exposed is removed by dry etching to obtain a metal-containing film having a reverse pattern 8a of the original pattern formed as in FIG. 2(O). Subsequently, the layer 2 to be processed is processed while using the metal-containing film having the reversed pattern as a mask to form the reverse pattern 2b in the layer to be processed of the substrate to be processed as in FIG. 2(P).

When the resist underlayer film is formed on the substrate to be processed as described above, the resist underlayer film can be formed by a method using a coating-type organic underlayer film material, a CVD method, an ALD method, or the like. Examples of the coating-type organic underlayer film material include resins and compositions disclosed in JP2012-1687A, JP2012-77295A, JP2004-264710A, JP2005-043471A, JP2005-250434A, JP2007-293294A, JP2008-65303A, JP2004-205685A, JP2007-171895A, JP2009-14816A, JP2007-199653A, JP2008-274250A, JP2010-122656A, JP2012-214720A, JP2014-29435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-44022A, etc.

In the tone-reversal patterning process, after the obtained resist underlayer film pattern is coated with the composition for forming a metal-containing film, it is preferable to remove the metal-containing film by using a dry etching gas mainly containing a chlorine-based gas so as to expose the upper surface of the resist underlayer film pattern. Thereafter, the resist middle layer film or the hard mask middle layer film remaining on the resist underlayer film is removed by dry etching using a fluorocarbon-based gas, and the resist underlayer film pattern having an exposed surface is removed by dry etching using an oxygen-based gas to form a metal-containing film pattern.

In the tone-reversal patterning process described above, the resist underlayer film pattern preferably has a step or a structure with a height of 30 nm or more. As described above, the inventive composition for forming a metal-containing film has excellent filling and/or planarizing properties. Thus, even when the film to be processed has a step (irregularities) or a structure with a height of 30 nm or more, a flat cured film can be formed. The height of the structure or the step of the resist underlayer film pattern is preferably 30 nm or more, more preferably 50 nm or more, and still more preferably 100 nm or more. In the method of reversing the resist underlayer film pattern having a pattern with the above-described height, by performing filling and planarization by forming a film from the inventive composition for forming a metal-containing film, inversion and transfer of the pattern can be performed with high accuracy, which is very desirable. Reversing the resist underlayer film pattern by using the composition for forming a metal-containing film allows a desired resist pattern to be formed on a film to be processed with high accuracy by virtue of the excellence in resistance in dry etching using a fluorocarbon-based gas relative to the resist underlayer film using a previously-known coating-type organic underlayer film material.

### EXAMPLES

The present invention is specifically described below with reference to Synthesis Examples, Comparative Synthesis Examples, Examples, and Comparative Examples. However, the present invention is not limited to these Examples.

### [Synthesis Examples]

In the following Synthesis Examples and Comparative Synthesis Examples, the following organic group starting material group G ((G1) to (G14)) and silicon-containing organic group starting material group H ((H1)) were used.

The starting material group G ((G1) to (G14)) is shown below.

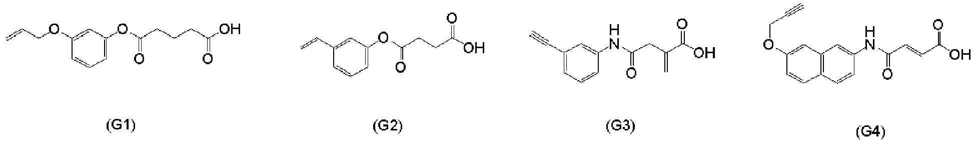

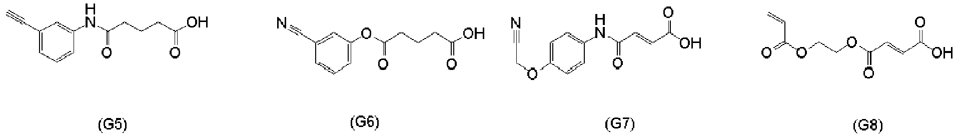

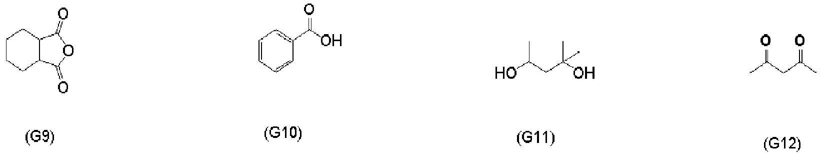

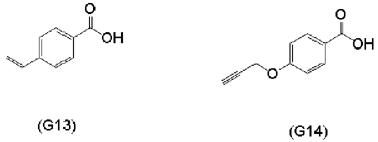

The starting material group H ((H1)) is shown below.

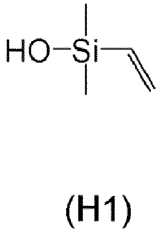

As a metal source M, the following metal compounds were used.
(M1): titanium tetraisopropoxide (377996 available from Sigma-Aldrich Corp)
(M2): titanium butoxide tetramer (FUJIFILM Wako Pure Chemical Corporation)
(M3): Zr(OBu)₄: zirconium(IV) tetrabutoxide (80 mass% solution in 1-butanol) (Z0016 available from Tokyo Chemical Industry Co., Ltd.)
(M4): Hf(OBu)₄: hafnium(IV) n-butoxide (667943 available from Sigma-Aldrich Corp)

### [Synthesis Example 1] Synthesis of Compound (A-1) for Forming Metal-Containing Film

Under a nitrogen atmosphere, while stirring, a solution (54.5 g) of deionized water (1.6 g) in n-butanol was dropped to a solution (40.5 g) of a titanium tetraisopropoxide (M1) (28.4 g) in n-butanol at room temperature for 2 hours. In this manner, hydrolysis condensation of the metal compound M1 was carried out. The organic group starting material (G1) (26.4 g) was added to the obtained solution and agitated at room temperature for 30 minutes. After the solution was concentrated under reduced pressure at 30°C, it was heated to 60°C and heating was continued under reduced pressure to generate no distillate. Then, a PGMEA/PGME (ratio by weight: 70/30) solution (69.0 g) was added thereto and heated under reduced pressure at 40°C until no IPA was distilled to obtain a solution of a compound (A-1) for forming a metal-containing film in PGMEA/PGME. The concentration of the components in the solution other than the solvent was 20 mass%.

### [Synthesis Examples 2 to 12 and Comparative Synthesis Examples 13 to 16] Synthesis of Compounds (A-2) to (A-12) for Forming Metal-Containing Film and Comparative Compounds (R-1) to (R-4) for Forming Metal-Containing Film

The compounds (A-2) to (A-12) for forming a metal-containing film and comparative compounds (R-1) to (R-4) for forming a metal-containing film shown in Table 1 were obtained under the same reaction conditions as in Synthesis Example 1, except that one of the metal sources M and one or two of the compound group G were used at the charging amounts shown in Table 1.

**[Table 1]**

| Synthesis Example | Metal starting material | | Compound group 1 | | Compound group 2 | | Compound |
|---|---|---|---|---|---|---|---|
| | Starting material | g | Starting material | g | Starting material | g | |
| 1 | M1 | 28.4 | G1 | 26.4 | - | | A-1 |
| 2 | M2 | 25.5 | G2 | 44.0 | - | | A-2 |
| 3 | M3 | 48.0 | G3 | 22.9 | - | | A-3 |
| 4 | M4 | 47.5 | G4 | 29.5 | - | | A-4 |
| 5 | M3 | 48.0 | G5 | 23.1 | - | | A-5 |
| 6 | M3 | 48.0 | G6 | 23.3 | - | | A-6 |
| 7 | M3 | 48.0 | G7 | 21.6 | - | | A-7 |
| 8 | M3 | 48.0 | G8 | 42.8 | - | | A-8 |
| 9 | M1 | 28.4 | G1 | 15.9 | G9 | 6.2 | A-9 |
| 10 | M3 | 48.0 | G2 | 17.6 | G10 | 2.4 | A-10 |
| 11 | M3 | 48.0 | G3 | 20.6 | G11 | 1.2 | A-11 |
| 12 | M4 | 47.5 | G4 | 23.6 | G12 | 2.0 | A-12 |
| Comparative 13 | M3 | 48.0 | G9 | 15.4 | - | | R-1 |
| Comparative 14 | M3 | 48.0 | G11 | 11.8 | - | | R-2 |
| Comparative 15 | M3 | 48.0 | G13 | 14.8 | - | | R-3 |
| Comparative 16 | M3 | 48.0 | G14 | 17.6 | - | | R-4 |

### [Comparative Synthesis Example 17] Synthesis of Comparative Compound (R-5) for Forming Metal-Containing Film

Under a nitrogen atmosphere, 48.0 g of zirconium(IV) tetrabutoxide (80 mass% solution in 1-butanol) (M3) was dissolved in 59.4 g of a PGMEA/PGME (ratio by weight: 70/30) solution. The reaction temperature was raised to 50°C while stirring, and 20.4 g of the compound H1 was added dropwise to the solution. After the addition, stirring was continued for 2 hours at a reaction temperature of 60°C. Subsequently, 29.6 g of the compound G9 was suspended in 24.8 g of a PGMEA/PGME (ratio by weight: 70/30) solution to obtain a mixture, the mixture was added to the reaction system, and stirring was continued for 1 hour with the reaction temperature still at 60°C. After cooling to room temperature, the obtained reaction solution was filtered with a 0.45-µm PTFE filter. Thus, a solution of a comparative compound (R-5) for forming a metal-containing film in PGMEA/PGME was obtained. The concentration of the components in the solution other than the solvent was 21 mass%.

**[Table 2]**

| Synthesis Example | Metal starting material | | Compound group G | | Compound group H | | Compound |
|---|---|---|---|---|---|---|---|
| | Starting material | g | Starting material | g | Starting material | g | |
| Comparative 17 | M3 | 48.0 | G13 | 29.6 | H1 | 20.4 | R-5 |

### [Synthesis of Resin (R-6) for Forming Organic Film for Comparative Example]

Under a nitrogen atmosphere, 160.2 g of 1,5-dihydroxynaphthalene, 56.8 g of formaldehyde, and 300 g of PGME (propylene glycol monomethyl ether) were mixed, and homogenized at an internal temperature of 100°C. After that, a mixed solution of 8.0 g of p-toluenesulfonic acid monohydrate and 8.0 g of PGME that had been mixed and homogenized beforehand was added dropwise slowly, and a reaction was allowed to take place at an internal temperature of 80°C for 8 hours. After the reaction was completed, the resultant was cooled to room temperature, and 2,000 ml of MIBK was added thereto. The resultant was washed six times with 500 ml of pure water, and the organic layer was evaporated under reduced pressure to dryness. After adding 300 g of THF to the residue to yield a homogeneous solution, a crystal was precipitated in 2,000 g of hexane. The precipitated crystal was separated by filtration, washed twice with 500 g of hexane, and collected. The collected crystal was vacuum-dried at 70°C, thereby obtaining a resin (R-6).

The weight-average molecular weight (Mw) and the dispersity (Mw/Mn) were determined by gel permeation chromatography (GPC) using tetrahydrofuran as an eluent, and the following results were obtained.
(R-6): Mw=3,300, Mw/Mn=2.54

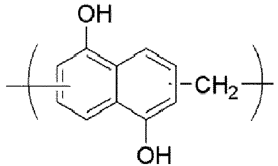

### (Synthesis of Flowability Accelerator)

For the synthesis of flowability accelerators, the following organic group starting material group G ((G19) to (G21)) and modifying agents K ((K1) to (K2)) were used.

The organic group starting material group G ((G19) to (G21)) is shown below.

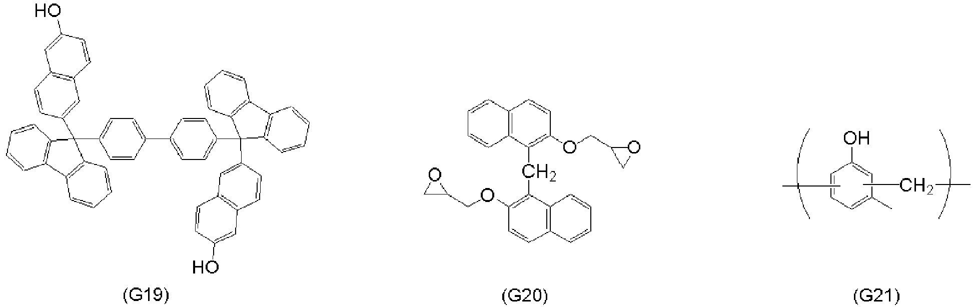

The modifying agents K ((K1) to (K2)) are shown below.

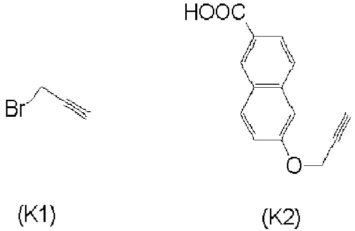

### [Synthesis of Flowability Accelerator (BPA-1)]

Under a nitrogen atmosphere, 45.5 g of the compound (G19) in the organic group starting material group G, 9.8 g of potassium carbonate, and 150 g of DMF were mixed to obtain a homogeneous dispersion liquid at an internal temperature of 50°C. 17.6 g of the modifying agent (K1) was slowly added, followed by a reaction at an internal temperature of 50°C for 24 hours. 300 ml of methylisobutylketone and 300 g of pure water were added to the reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a flowability accelerator (BPA-1).

The weight-average molecular weight (Mw) and the dispersity (Mw/Mn) were determined by GPC, and the following results were obtained.
(BPA-1): Mw=965, Mw/Mn=1.08

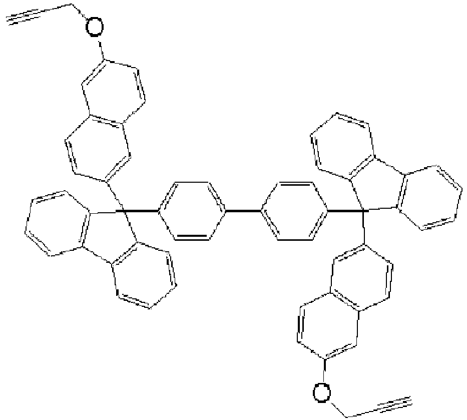

### [Synthesis of Flowability Accelerator (BPA-2)]

Under a nitrogen atmosphere, 80.0 g of the epoxy compound (G20) in the organic group starting material group G, 51.0 g of the modifying agent (K2), and 600 g of 2-methoxy-1-propanol were mixed to yield a homogeneous solution at an internal temperature of 100°C, and then 5.7 g of benzyltriethylammonium chloride was added thereto, followed by stirring at an internal temperature of 120°C for 12 hours. After cooling to room temperature, 1,500 g of methylisobutylketone was added and the organic layer was washed with 300 g of pure water five times. The organic layer was solidified under reduced pressure, thereby obtaining a flowability accelerator (BPA-2).

The weight-average molecular weight (Mw) and the dispersity (Mw/Mn) were determined by GPC, and the following results were obtained.
(BPA-2): Mw=900, Mw/Mn=1.04

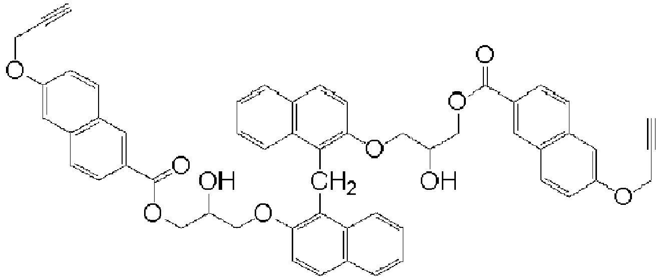

### [Synthesis of Flowability Accelerator (BPA-3)]

Under a nitrogen atmosphere, 20.0 g of the resin (G21) in the organic group starting material group G, 34.5 g of potassium carbonate, and 100 g of DMF were mixed to yield a homogeneous dispersion liquid at an internal temperature of 50°C. 23.8 g of the modifying agent (K1) was slowly added, followed by a reaction at an internal temperature of 50°C for 24 hours. 300 ml of methylisobutylketone and 300 g of pure water were added to the reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a flowability accelerator (BPA-3).

The weight-average molecular weight (Mw) and the dispersity (Mw/Mn) were determined by GPC, and the following results were obtained.
(BPA-3): Mw=9,400, Mw/Mn=3.59

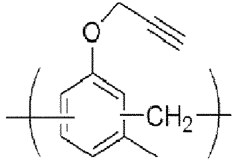

### [Preparation of composition (MUL-1) for forming a metal-containing film]

The compound (A-1) for forming a metal-containing film was dissolved at a ratio shown in Table 3 in a mixed solvent (organic solvent (B)) of propylene glycol monomethyl ether acetate (PGMEA) and propylene glycol monomethyl ether (PGME) containing 0.5 mass% of a surfactant (D) FC-4430 (available from Sumitomo 3M Limited), and the solution was filtered through a 0.02-µm membrane filter to prepare a composition (MUL-1) for forming a metal-containing film.

### [Preparation of Compositions (MUL-2 to -18) for Forming Metal-Containing Film and Compositions (Comparative MUL-1 to -6) for Forming Metal-Containing Film for Comparative Examples]

Each composition was prepared in the same manner as the composition (MUL-1) for forming a metal-containing film, except that the type and contained amount of each component were as shown in Table 3. It should be noted that in Table 3, "-" indicates that the component was not used. As a crosslinking agent, a crosslinking agent represented by the following formula (C-1) was used. As an acid generator (TAG), an acid generator represented by the following formula (E-1) was used. As a high-boiling-point solvent (B-1), ethylene glycol dibenzyl ether (boiling point: 364°C) was used.

### [Crosslinking Agent and Acid Generator]

The crosslinking agent (C-1) and acid generator (E-1) used in compositions for forming a metal-containing film are shown below.

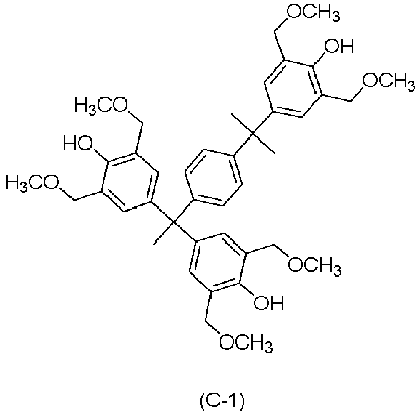

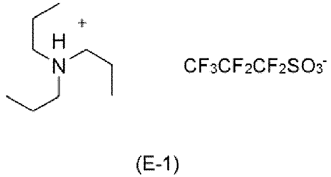

**[Table 3]**

| Composition for forming metal-containing film | (A) Compound for forming metal-containing film | Additive | (B) Organic solvent (containing (D) surfactant) |
|---|---|---|---|
| | (parts by mass) | (parts by mass) | (parts by mass) |
| MUL-1 | A-1(10) | - | PGMEA/PGME(55/25) |
| MUL-2 | A-2(10) | - | PGMEA/PGME(55/25) |
| MUL-3 | A-3(10) | - | PGMEA/PGME(55/25) |
| MUL-4 | A-4(10) | - | PGMEA/PGME(55/25) |
| MUL-5 | A-5(10) | - | PGMEA/PGME(55/25) |
| MUL-6 | A-6(10) | - | PGMEA/PGME(55/25) |
| MUL-7 | A-7(10) | - | PGMEA/PGME(55/25) |
| MUL-8 | A-8(10) | - | PGMEA/PGME(55/25) |
| MUL-9 | A-9(10) | - | PGMEA/PGME(55/25) |
| MUL-10 | A-10(10) | - | PGMEA/PGME(55/25) |
| MUL-11 | A-11(10) | - | PGMEA/PGME(55/25) |
| MUL-12 | A-12(10) | - | PGMEA/PGME(55/25) |
| MUL-13 | A-1(10) | C-1(5) | PGMEA/PGME(55/25) |
| MUL-14 | A-2(10) | | PGMEA/PGME(55/25) (containing B-1(50)) |
| MUL-15 | A-3(10) | E-1(0.5) | PGMEA/PGME(55/25) |
| MUL-16 | A-4(10) | BPA-1(10) | PGMEA/PGME(55/25) |
| MUL-17 | A-5(10) | BPA-2(10) | PGMEA/PGME(55/25) |
| MUL-18 | A-6(10) | BPA-3(10) | PGMEA/PGME(55/25) |
| Comparative MUL-1 | R-1(10) | - | PGMEA/PGME(55/25) |
| Comparative MUL-2 | R-2(10) | - | PGMEA/PGME(55/25) |
| Comparative MUL-3 | R-3(10) | - | PGMEA/PGME(55/25) |
| Comparative MUL-4 | R-4(10) | - | PGMEA/PGME(55/25) |
| Comparative MUL-5 | R-5(10) | - | PGMEA/PGME(55/25) |
| Comparative MUL-6 | R-6(5) | - | PGMEA(95) |

### [Example 1 and Comparative Example 1: Filling Property Evaluation]

Each of the compositions (MUL-1 to -18 and comparative MUL-1 to -6) prepared above was respectively applied onto an SiO₂ wafer substrate (substrate A) having a dense line-and-space pattern (line width = 60 nm, line depth = 100 nm, distance between the centers of two adjacent lines 120 nm), followed by heating by using a hot plate at 350°C for 60 seconds. Thus, a metal-containing film having a film thickness of 80 nm was formed.

Furthermore, each of the compositions (MUL-1 to -18 and comparative MUL-1 to -6) prepared above was respectively applied onto an SiO₂ wafer substrate (substrate B) having a dense line-and-space pattern (line width = 40 nm, line depth = 120 nm, distance between the centers of two adjacent lines 80 nm), followed by heating by using a hot plate at 350°C for 60 seconds. Thus, a metal-containing film having a film thickness of 80 nm was formed.

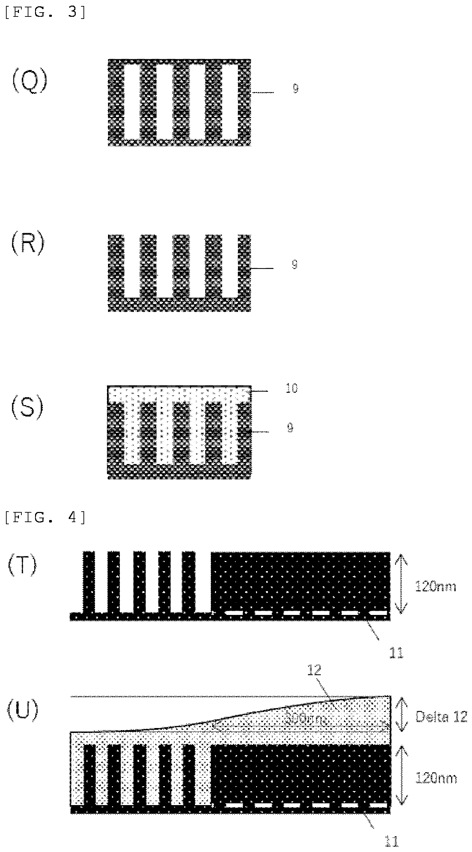

The substrates A and B used were base substrates 9 (SiO₂ wafer substrates) each having a dense line-and-space pattern shown in FIG. 3(Q) (downward view) and (R) (cross-sectional view). In the filling evaluation, the cross-sectional shape of each of the obtained wafer substrates was observed using an electron microscope (S-4700: manufactured by Hitachi, Ltd.), and the presence/absence of voids (gaps) inside the metal-containing film filling the space between the lines was confirmed. Table 4 shows the results. In this evaluation, when a composition for forming a metal-containing film having a poor filling property is used, voids are generated inside the metal-containing film filling the space between the lines. In this evaluation, when a composition for forming a metal-containing film having a desirable filling property is used, the inside of the metal-containing film filling the space between the lines of the base substrate 9 having the dense line-and-space pattern is filled with a void-free metal-containing film 10, as shown in FIG. 3(S).

**[Table 4]**

| Example 1 and Comparative Example 1 | Composition for forming metal-containing film | Baking temperature | Filling property | |
|---|---|---|---|---|
| | | | Substrate 1 | Substrate 2 |
| Example 1-1 | MUL-1 | 350°C | Good | Good |
| Example 1-2 | MUL-2 | 350°C | Good | Good |
| Example 1-3 | MUL-3 | 350°C | Good | Good |
| Example 1-4 | MUL-4 | 350°C | Good | Good |
| Example 1-5 | MUL-5 | 350°C | Good | Good |
| Example 1-6 | MUL-6 | 350°C | Good | Good |
| Example 1-7 | MUL-7 | 350°C | Good | Good |
| Example 1-8 | MUL-8 | 350°C | Good | Good |
| Example 1-9 | MUL-9 | 350°C | Good | Good |
| Example 1-10 | MUL-10 | 350°C | Good | Good |
| Example 1-11 | MUL-11 | 350°C | Good | Good |
| Example 1-12 | MUL-12 | 350°C | Good | Good |
| Example 1-13 | MUL-13 | 350°C | Good | Good |
| Example 1-14 | MUL-14 | 350°C | Good | Good |
| Example 1-15 | MUL-15 | 350°C | Good | Good |
| Example 1-16 | MUL-16 | 350°C | Good | Good |
| Example 1-17 | MUL-17 | 350°C | Good | Good |
| Example 1-18 | MUL-18 | 350°C | Good | Good |
| Comparative Example 1-1 | Comparative MUL-1 | 350°C | Voids present | Voids present |
| Comparative Example 1-2 | Comparative MUL-2 | 350°C | Voids present | Voids present |
| Comparative Example 1-3 | Comparative MUL-3 | 350°C | Good | Voids present |
| Comparative Example 1-4 | Comparative MUL-4 | 350°C | Good | Voids present |
| Comparative Example 1-5 | Comparative MUL-5 | 350°C | Good | Voids present |
| Comparative Example 1-6 | Comparative MUL-6 | 350°C | Good | Good |

It was successfully confirmed that, as shown in Table 4, in Examples 1-1 to 1-18, where the inventive compositions (MUL-1 to -18) for forming a metal-containing film were used, it was possible to fill the dense line-and-space pattern of each substrate without the generation of voids even after baking at 350°C, and excellent filling property was provided even under high-temperature baking conditions.

On the other hand, voids were observed at the bottom of the pattern after baking at 350°C in the cases of both the substrate A and the substrate B in Comparative Examples 1-1 and 1-2, using comparative compositions (comparative MUL-1 and -2) for forming a metal-containing film each containing a compound for forming a metal-containing film having an organic ligand containing no crosslinking groups of the formulae (a-1) to (a-4), unlike the inventive compounds for forming a metal-containing film. It can be conjectured that the metal-containing films made of these comparative compositions for forming a metal-containing film had low heat resistance, accordingly underwent great volume shrinkage caused by high-temperature baking, and thus, voids were generated.

Meanwhile, in Comparative Examples 1-3 to -5, where the used comparative compositions (comparative UDL-3 to -5) for forming a metal-containing film each contained a compound for forming a metal-containing film containing a crosslinking group of any one of the formulae (a-1) to (a-4) but did not containing a ligand derived from an organic compound represented by the formula (1), in the case of substrate A, it was possible to fill the dense line-and-space pattern without void generation, but, in the case of the substrate B, including finer patterns, generation of voids was observed. It is conjectured that these comparative compositions for forming a metal-containing film contained a crosslinking group of any one of the formulae (a-1) to (a-4) but did not contain a ligand derived from an organic compound represented by the formula (1) of the present invention, and as a result, heat resistance was insufficient, and therefore, voids were generated in the case of substrate B, including fine patterns that receive heat from the substrate more readily.

### [Example 2 and Comparative Example 2: Planarizing Property Evaluation]

Flatness evaluation was carried out using the substrate B used in the filling property evaluation. Specifically, regarding base substrates 11 (SiO₂ wafer substrates) each having a dense line-and-space pattern as shown in FIG. 4(T), the cross sectional shape of each of the wafer substrates in which no voids were observed in the filling property evaluation after baking at 350°C as shown in FIG. 4(U) was observed using a scanning electron microscope (SEM), and the step (Delta 12 in FIG. 4(U)) between the line-pattern-dense portion and the non-line-pattern portion of the filling film 12 was observed using an electron microscope (S-4700: manufactured by Hitachi, Ltd.). Table 5 shows the results. In the present evaluation, it can be said that the smaller the step, the better the planarizing property.

**[Table 5]**

| Example | Composition for forming metal-containing film | Baking temperature | Flatness (nm) |
|---|---|---|---|
| | | | Substrate B |
| Example 2-1 | MUL-1 | 350°C | 59 |
| Example 2-2 | MUL-2 | 350°C | 57 |
| Example 2-3 | MUL-3 | 350°C | 60 |
| Example 2-4 | MUL-4 | 350°C | 60 |
| Example 2-5 | MUL-5 | 350°C | 58 |
| Example 2-6 | MUL-6 | 350°C | 57 |
| Example 2-7 | MUL-7 | 350°C | 57 |
| Example 2-8 | MUL-8 | 350°C | 56 |
| Example 2-9 | MUL-9 | 350°C | 63 |
| Example 2-10 | MUL-10 | 350°C | 63 |
| Example 2-11 | MUL-11 | 350°C | 64 |
| Example 2-12 | MUL-12 | 350°C | 64 |
| Example 2-13 | MUL-13 | 350°C | 59 |
| Example 2-14 | MUL-14 | 350°C | 55 |
| Example 2-15 | MUL-15 | 350°C | 60 |
| Example 2-16 | MUL-16 | 350°C | 58 |
| Example 2-17 | MUL-17 | 350°C | 56 |
| Example 2-18 | MUL-18 | 350°C | 54 |
| Comparative Example 2-1 | Comparative MUL-6 | 350°C | 65 |

As shown in Table 5, it was observed in Examples 2-1 to 2-18, where the inventive compositions (MUL-1 to - 18) for forming a metal-containing film were used, that the step in the film between the patterned portion and the non-patterned portion was small and the planarizing property compared favorably with that of Comparative Example 2-1, where an organic resist underlayer film material was used. Meanwhile, MDL-14, containing the high-boiling-point solvent (B-1), and MDL-16 to -18, respectively containing the flowability accelerators (BPA-1 to -3), exhibited better planarizing property than the compositions not containing these additives. It is conjectured that the thermal flowability of the compositions for forming a metal-containing film were further improved by the additives being contained. Meanwhile, better flatness was observed in the compound (A-1) for forming a metal-containing film, containing only a ligand derived from an organic compound represented by the formula (1), compared to the compound (A-9) for forming a metal-containing film, further containing a ligand other than the ligand derived from the organic compound represented by the formula (1).

### [Example 3 and Comparative Example 3: Etching Resistance Evaluation]

Each of the compositions (MUL-1 to -18 and comparative MUL-1 to -6) for forming a metal-containing film was respectively applied onto a silicon substrate and heated by using a hot plate at 350°C for 60 seconds to form a metal-containing film having a film thickness of 80 nm, and the film thickness "a" was measured. Subsequently, etching was performed with CF₄ gas under the following conditions (conditions 1 and conditions 2) by using an etching apparatus TE8500 manufactured by Tokyo Electron Ltd., and the film thickness "b" was measured. Then, the film thickness etched in 1 minute was calculated as an etching rate (nm/min) from the film thickness etched (film thickness "a" - film thickness "b") in the specified time.

In the case of the conditions 1, a case where the etching rate was 50 nm/min or lower was judged as "very good (A)", a case where the etching rate was 50 nm/min to 60 nm/min as "good (B)", and a case where the etching rate was higher than 60 nm/min as "poor (C)". In the case of the conditions 2, a case where the etching rate was 35 nm/min or lower was judged as "very good (A)", a case where the etching rate was 35 nm/min to 40 nm/min as "good (B)", and a case where the etching rate was higher than 40 nm/min as "poor (C)". Table 6 shows the results.
Dry etching conditions 1
   Pressure: 200 mT
   RF power: 300 W
   CF₄ gas flow rate: 100 sccm
   Time: 20 sec
Dry etching conditions 2
   Pressure: 160 mT
   RF power: 1000 W
   CF₄ gas flow rate: 20 sccm
   Ar gas flow rate: 1000 sccm
   Time: 60 sec

**[Table 6]**

| Example | Composition for forming metal-containing film | Baking temperature | Etching resistance | |
|---|---|---|---|---|
| | | | Conditions 1 | Conditions 2 |
| Example 3-1 | MUL-1 | 350°C | B | B |
| Example 3-2 | MUL-2 | 350°C | B | B |
| Example 3-3 | MUL-3 | 350°C | B | B |
| Example 3-4 | MUL-4 | 350°C | B | B |
| Example 3-5 | MUL-5 | 350°C | B | B |
| Example 3-6 | MUL-6 | 350°C | B | B |
| Example 3-7 | MUL-7 | 350°C | B | B |
| Example 3-8 | MUL-8 | 350°C | B | B |
| Example 3-9 | MUL-9 | 350°C | A | A |
| Example 3-10 | MUL-10 | 350°C | A | A |
| Example 3-11 | MUL-11 | 350°C | A | A |
| Example 3-12 | MUL-12 | 350°C | A | A |
| Example 3-13 | MUL-13 | 350°C | A | B |
| Example 3-14 | MUL-14 | 350°C | B | B |
| Example 3-15 | MUL-15 | 350°C | B | B |
| Example 3-16 | MUL-16 | 350°C | B | B |
| Example 3-17 | MUL-17 | 350°C | B | B |
| Example 3-18 | MUL-18 | 350°C | B | B |
| Comparative Example 3-1 | Comparative MUL-1 | 350°C | A | A |
| Comparative Example 3-2 | Comparative MUL-2 | 350°C | A | A |
| Comparative Example 3-3 | Comparative MUL-3 | 350°C | B | B |
| Comparative Example 3-4 | Comparative MUL-4 | 350°C | B | B |
| Comparative Example 3-5 | Comparative MUL-5 | 350°C | C | C |
| Comparative Example 3-6 | Comparative MUL-6 | 350°C | C | C |

As shown in Table 6, it was shown that better etching resistance to CF₄ gas was exhibited in Examples 3-1 to 3-18, where the inventive compositions (MUL-1 to -18) for forming a metal-containing film were used, than the organic underlayer film material (Comparative Example 3-6, where the comparative compound (R-6) for forming a metal-containing film was used). Better dry etching resistance was also exhibited in the Examples compared to Comparative Example 3-5, where the compound (R-5) for forming a metal-containing film, which was not subjected to hydrolysis condensation, was used. In particular, the inventive compositions (MUL-1 to -18) for forming a metal-containing film also exhibited high resistance under the conditions 2, where the Ar flow rate was high. For this reason, it is thought that the compositions also exhibit excellent resistance to physical etching, which is used in the etching of an oxide film of an advanced device and in which the Ar flow rate is high.

An improvement in dry etching resistance was observed in the compound (A-9) for forming a metal-containing film, further containing a ligand other than the ligand derived from the organic compound represented by the formula (1), compared to the compound (A-1) for forming a metal-containing film, containing only the ligand derived from the organic compound represented by the formula (1). That is, in the present invention, dry etching resistance and planarizing property can be adjusted appropriately in accordance with the properties required in the used process by adjusting the proportion of the ligand derived from an organic compound represented by the formula (1), contained in the compound for forming a metal-containing film.

### [Example 4 and Comparative Example 4: Patterning Process]

Each of the compositions (MUL-1 to -18 and comparative MUL-6) for forming a metal-containing film was respectively applied onto an SiO₂ wafer substrate having a trench pattern (trench width: 10 µm, trench depth: 0.10 µm), and baked at 350°C for 60 seconds in the atmosphere to form a metal-containing film having a thickness of 80 nm. A silicon-containing resist middle layer film material (SOG-1) was applied thereto, followed by baking at 220°C for 60 seconds to form a resist middle layer film having a thickness of 50 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to a photoresist film, followed by baking at 90°C for 60 seconds to form a top coat having a thickness of 50 nm.

The silicon-containing resist middle layer film material (SOG-1) was prepared in the following manner. Firstly, a polymer represented by an ArF silicon-containing middle layer film polymer (SiP1) and a thermal crosslinking catalyst (CAT1) were dissolved in an organic solvent containing 0.1 mass% of FC-4430 (manufactured by Sumitomo 3M Limited) in the proportion shown in Table 7. The mixture thus obtained was then filtered through a filter made of a fluororesin and having a pore size of 0.1 µm to prepare the silicon-containing resist middle layer film material (SOG-1).

**[Table 7]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4,000) |

The structural formulae of the used ArF silicon-containing middle layer film polymer (SiP1) and thermal crosslinking catalyst (CAT1) are shown below.

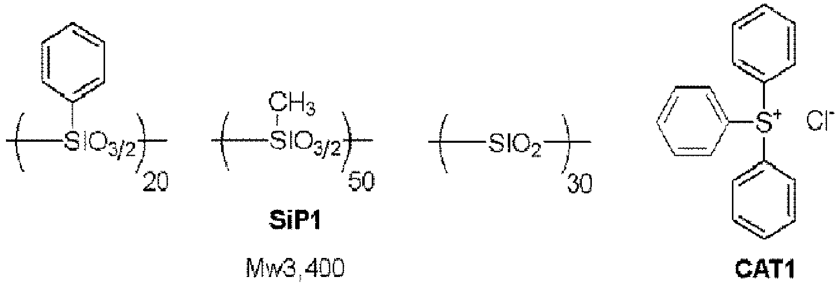

The resist upper layer film material (monolayer resist for ArF) was prepared in the following manner. Firstly, a polymer (RP1), an acid generator (PAG1), and a basic compound (Amine1), were each dissolved in the proportion shown in Table 8, in a solvent containing 0.1% by mass of a surfactant (FC-4430: manufactured by Sumitomo 3M Limited), then the solution was filtered through a 0.1-µm filter made of a fluororesin to prepare the resist upper layer film material.

**[Table 8]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2, 500) |

The polymer (RP1), the acid generator (PAG1), and the basic compound (Amine1) used for the resist upper layer film material (monolayer resist for ArF) are shown below.

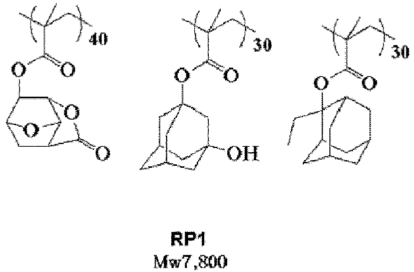

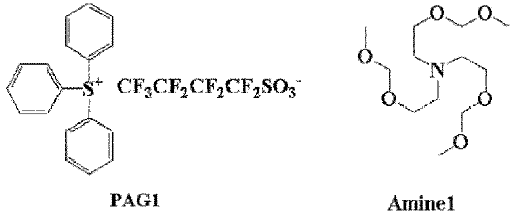

The liquid immersion top coat composition (TC-1) was prepared by dissolving a top coat polymer (PP1) in an organic solvent at the proportion shown in Table 9, and filtering the solution through a 0.1-µm filter made of a fluororesin.

**[Table 9]**

| | Top coat polymer (parts by mass) | Organic solvent (parts by mass) |
|---|---|---|
| TC-1 | PP1 (100) | Diisoamyl ether (2,700) 2-methyl-1-butanol (270) |

The top coat polymer (PP1) used for the liquid immersion top coat composition (TC-1) is shown below.

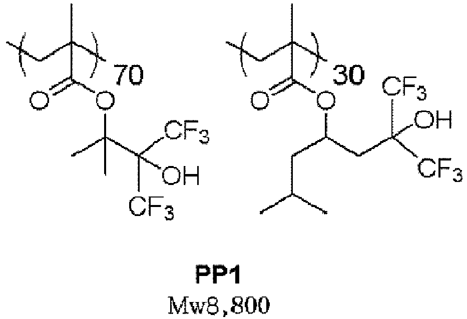

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern).

Subsequently, the resist middle layer film was etched by dry etching while using the resist upper layer film pattern as a mask to form a hard mask pattern. A metal-containing film was then etched while using the obtained hard mask pattern as a mask to form a metal-containing film pattern, and the SiO₂ film was etched while using the obtained metal-containing film pattern as a mask. The etching was performed using an etching apparatus CE-300I manufactured by ULVAC, Inc. and under the following conditions.
Conditions in transferring resist upper layer film pattern to resist middle layer film
Conditions of dry etching with CF₄ gas
   Pressure: 1 Pa
   Antenna RF power: 100 W
   Bias RF power: 15 W
   CF₄ gas flow rate: 15 sccm
   Time: 60 sec
Conditions in transferring hard mask pattern to metal-containing film
Conditions of dry etching with Cl₂ gas
   Pressure: 1 Pa
   Antenna RF power: 320 W
   Bias RF power: 30 W
   Cl₂ gas flow rate: 25 sccm
   Time: 45 sec
Conditions in transferring metal-containing film pattern to SiO₂ film
Conditions of dry etching with CF₄ gas
   Pressure: 1 Pa
   Antenna RF power: 100 W
   Bias RF power: 15 W
   CF₄ gas flow rate: 15 sccm
   Time: 60 sec

Table 10 shows the results obtained by observation of the pattern cross section with an electron microscope (S-4700) manufactured by Hitachi, Ltd.

**[Table 10]**

| Example | Composition for forming metal-containing film | Baking temperature | Pattern profile after etching for transferring to substrate |
|---|---|---|---|
| Example 4-1 | MUL-1 | 350°C | Vertical profile |
| Example 4-2 | MUL-2 | 350°C | Vertical profile |
| Example 4-3 | MUL-3 | 350°C | Vertical profile |
| Example 4-4 | MUL-4 | 350°C | Vertical profile |
| Example 4-5 | MUL-5 | 350°C | Vertical profile |
| Example 4-6 | MUL-6 | 350°C | Vertical profile |
| Example 4-7 | MUL-7 | 350°C | Vertical profile |
| Example 4-8 | MUL-8 | 350°C | Vertical profile |
| Example 4-9 | MUL-9 | 350°C | Vertical profile |
| Example 4-10 | MUL-10 | 350°C | Vertical profile |
| Example 4-11 | MUL-11 | 350°C | Vertical profile |
| Example 4-12 | MUL-12 | 350°C | Vertical profile |
| Example 4-13 | MUL-13 | 350°C | Vertical profile |
| Example 4-14 | MUL-14 | 350°C | Vertical profile |
| Example 4-15 | MUL-15 | 350°C | Vertical profile |
| Example 4-16 | MUL-16 | 350°C | Vertical profile |
| Example 4-17 | MUL-17 | 350°C | Vertical profile |
| Example 4-18 | MUL-18 | 350°C | Vertical profile |
| Comparative Example 4-1 | Comparative MUL-6 | 350°C | Distorted pattern |

As shown in Table 10, in Examples 4-1 to 4-18, where the inventive compositions (MUL-1 to -18) for forming a metal-containing film were used, the resist upper layer film pattern was successfully transferred to the substrate in the end in every case. Thus, it was confirmed that the inventive composition for forming a metal-containing film can be used suitably for fine processing using a multilayer resist method. On the other hand, in Comparative Example 4-1, where insufficient performance was observed in the dry etching resistance evaluation, distortion of the pattern profile occurred at the time of pattern processing, and it was not possible to obtain a favorable pattern in the end.

### [Example 5 and Comparative Example 5: SOC Pattern Inversion Method]

The coating-type resist underlayer film composition (SOC-1) was applied as a resist underlayer film onto a silicon wafer substrate on which an SiO₂ film was formed, and the substrate was then baked at 350°C for 60 seconds to form a resist underlayer film having a thickness of 150 nm. A silicon atom-containing resist middle layer film composition (SOG-1) was applied thereto, followed by baking at 220°C for 60 seconds to form a resist middle layer film having a thickness of 40 nm. Then, a monolayer resist for ArF as a resist upper layer film composition was applied thereto, followed by baking at 105°C for 60 seconds to form a photoresist film having a thickness of 100 nm. A liquid immersion top coat composition (TC-1) was applied to a photoresist film, followed by baking at 90°C for 60 seconds to form a top coat having a thickness of 50 nm.

The silicon atom-containing resist middle layer film composition (SOG-1), the resist upper layer film composition (monolayer resist for ArF), and the liquid immersion top coat composition (TC-1) on the photoresist film were made of the same composition as that used in the patterning process (Example 4).

The coating-type resist underlayer film composition (SOC-1) was prepared by dissolving the polymer denoted by the resist underlayer film polymer (SOP1) in an organic solvent containing 0.1% by mass of FC-4430 (manufactured by Sumitomo 3M Limited) at the proportions shown in Table 11 and filtering the resulting solution through a filter made of a fluororesin having a pore size of 0.2 µm.

**[Table 11]**

| | Resist underlayer film polymer | Organic solvent |
|---|---|---|
| | (parts by mass) | (parts by mass) |
| SOC-1 | SOP1(7) | PGMEA(93) |

The structural formula of the resist underlayer film polymer (SOP1) used herein is shown in Table 12.

**[Table 12]**

| Compound or polymer | Mw | Mw/Mn |
|---|---|---|
| 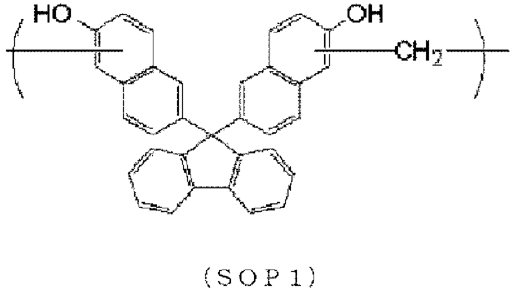 | 3,700 | 2.82 |

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass of aqueous tetramethylammonium hydroxide (TMAH) solution for 30 seconds, thereby obtaining a 55 nm 1:1 positive line-and-space pattern (resist upper layer film pattern).

Then, the resist middle layer film was etched by dry etching while using the resist upper layer film pattern as a mask and using an etching apparatus Telius manufactured by Tokyo Electron Ltd. to form a hard mask pattern. Then, a resist underlayer film (SOC-1) was etched while using the obtained hard mask pattern as a mask to form a SOC-1 film pattern. The etching conditions are as follows.
Conditions in transferring resist upper layer film pattern to resist middle layer film
   Chamber pressure: 50 mT
   RF-power (upper portion): 500 W
   RF-power (lower portion): 300 W
   CF₄ gas flow rate: 150 sccm
   CHF₃ gas flow rate: 50 sccm
   Time: 20 sec
Conditions in transferring hard mask pattern to resist underlayer film
   Chamber pressure: 10 mT
   RF-power (upper portion): 1,000 W
   RF-power (lower portion): 300 W
   CO₂ gas flow rate: 150 sccm
   CO gas flow rate: 50 sccm
   N₂ gas flow rate: 50 sccm
   H₂ gas flow rate: 150 sccm
   Time: 90 sec

Next, each of the compositions (MUL-1 to -18 and comparative MUL-1 to -2) for forming a metal-containing film was respectively applied onto the obtained SOC-1 film pattern, followed by baking in the atmosphere at 350°C for 60 seconds to form a metal-containing film having a thickness of 80 nm. Thereafter, the metal-containing film covering the SOC-1 film pattern was etched to expose the upper surface of the SOC-1 film pattern. The resist middle layer film remaining on the surface of the SOC-1 film pattern with the exposed upper surface was removed by etching, then the exposed SOC-1 film pattern was removed by etching to invert the above pattern onto a metal-containing film, and the SiO₂ film was etched while using the obtained metal-containing film pattern as a mask. As a Comparative Example (Comparative Example 5-3), etching of the SiO₂ film was performed while using the SOC-1 film pattern as a mask without using the composition for forming a metal-containing film. The etching conditions are as follows.
Conditions in etch-back of metal-containing film (exposure of SOC-1 film pattern).
   Pressure: 1 Pa
   Antenna RF power: 320 W
   Bias RF power: 30 W
   Cl₂ gas flow rate: 25 sccm
   Time: 20 sec
Removal of resist middle layer film remaining on SOC-1 film pattern
Conditions of dry etching with CF₄ gas
   Pressure: 1 Pa
   Antenna RF power: 100 W
   Bias RF power: 15 W
   CF₄ gas flow rate: 15 sccm
   Time: 45 sec
Removal of SOC-1 film pattern
Conditions of dry etching with O₂ gas
   Pressure: 1 Pa
   Antenna RF power: 300 W
   Bias RF power: 0 W
   O₂ gas flow rate: 25 sccm
   Time: 35 sec
Conditions in transferring metal-containing film pattern to SiO₂ film
Conditions of dry etching with CF₄ gas
   Pressure: 1 Pa
   Antenna RF power: 100 W
   Bias RF power: 15 W
   CF₄ gas flow rate: 15 sccm
   Time: 60 sec
Comparative Example 5-3: conditions in transferring SOC-1 film pattern to SiO₂ film
Conditions of dry etching with CF₄ gas
   Pressure: 1 Pa
   Antenna RF power: 100 W
   Bias RF power: 15 W
   CF₄ gas flow rate: 15 sccm
   Time: 60 sec

Table 13 shows the results obtained by observation of the pattern cross section with an electron microscope (S-4700) manufactured by Hitachi, Ltd.

**[Table 13]**

| Example | Composition for forming metal-containing film | Baking temperature | Pattern profile after etching for transferring to substrate |
|---|---|---|---|
| Example 5-1 | MUL-1 | 350°C | Vertical profile |
| Example 5-2 | MUL-2 | 350°C | Vertical profile |
| Example 5-3 | MUL-3 | 350°C | Vertical profile |
| Example 5-4 | MUL-4 | 350°C | Vertical profile |
| Example 5-5 | MUL-5 | 350°C | Vertical profile |
| Example 5-6 | MUL-6 | 350°C | Vertical profile |
| Example 5-7 | MUL-7 | 350°C | Vertical profile |
| Example 5-8 | MUL-8 | 350°C | Vertical profile |
| Example 5-9 | MUL-9 | 350°C | Vertical profile |
| Example 5-10 | MUL-10 | 350°C | Vertical profile |
| Example 5-11 | MUL-11 | 350°C | Vertical profile |
| Example 5-12 | MUL-12 | 350°C | Vertical profile |
| Example 5-13 | MUL-13 | 350°C | Vertical profile |
| Example 5-14 | MUL-14 | 350°C | Vertical profile |
| Example 5-15 | MUL-15 | 350°C | Vertical profile |
| Example 5-16 | MUL-16 | 350°C | Vertical profile |
| Example 5-17 | MUL-17 | 350°C | Vertical profile |
| Example 5-18 | MUL-18 | 350°C | Vertical profile |
| Comparative Example 5-1 | Comparative MUL-1 | 350°C | Pattern collapse |
| Comparative Example 5-2 | Comparative MUL-2 | 350°C | Pattern collapse |
| Comparative Example 5-3 | SOC-1 film pattern | - | Distorted pattern |

As shown in Table 13, Example 5-1 to 5-18, using the inventive compositions (MUL-1 to -18) for forming a metal-containing film, were all capable of accurately inverting the SOC-1 film pattern, and the reverse pattern was desirably transferred to the substrate in the end without pattern collapse. It was thus confirmed that the inventive composition for forming a metal-containing film can be suitably used for fine processing using the tone-reversal etching method of the multilayer resist process method. On the other hand, in Comparative Example 5-3, in which the SOC-1 film pattern was directly transferred to the SiO₂ film, the etching resistance of the SOC-1 film was insufficient, and therefore, the distortion of the pattern shape was observed. Meanwhile, in Comparative Examples 5-1 to 5-2, in which insufficient performance was observed in the filling property evaluation (substrate B), the space between the SOC-1 film patterns was not filled to the bottom with the metal-containing film, and therefore, it was not possible to invert the pattern, and a desirable reverse pattern could not be obtained in the end.

It was thus revealed that a composition for forming a metal-containing film containing the inventive compound for forming a metal-containing film has both high filling and planarizing properties and dry etching resistance, and therefore, is significantly useful as a metal-containing film (resist underlayer film) composition used in the multilayer resist method and as an inverting agent used in the tone-reversal etching method, and that the inventive patterning process using this composition is capable of forming fine patterns with high accuracy even when a body to be processed is a substrate having a step.

The present description includes the following embodiments.
[1] A compound (A) for forming a metal-containing film, wherein
   the compound (A) for forming a metal-containing film is a compound derived from a metal-containing compound, being a hydrolysate, condensate, or hydrolysis condensate of a metal compound represented by the following formula (A-1), and the compound (A) further has a ligand derived from an organic compound represented by the following formula (1),

   M(OR^{1A})₄ (A-1)

   R^{2A}COXCOOH (1)

   wherein M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the following general formulae (a-1) to (a-4); and X represents a divalent organic group having 2 to 20 carbon atoms, 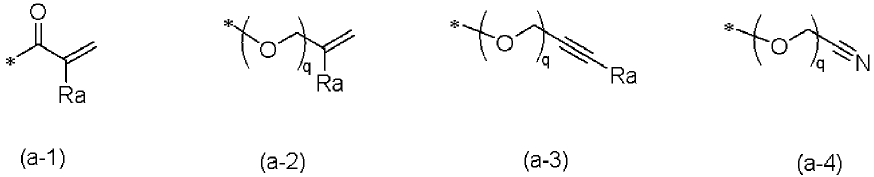 wherein Rₐ represents a hydrogen atom or a monovalent organic group having 1 to 10 carbon atoms; "q" represents 0 or 1; and "*" represents an attachment point.
[2] The compound for forming a metal-containing film according to [1], wherein the compound (A) for forming a metal-containing film is a metal-containing compound, being a reaction product of a reaction between:
   one or more selected from a hydrolysate of only the metal compound represented by the formula (A-1), a condensate of only the metal compound represented by the formula (A-1), and a hydrolysis condensate of only the metal compound represented by the formula (A-1); and
   the organic compound represented by the formula (1).
[3] The compound for forming a metal-containing film according to [1] or [2], wherein the R^{2A} in the formula (1) has a structure represented by one of the following general formulae (B-1), 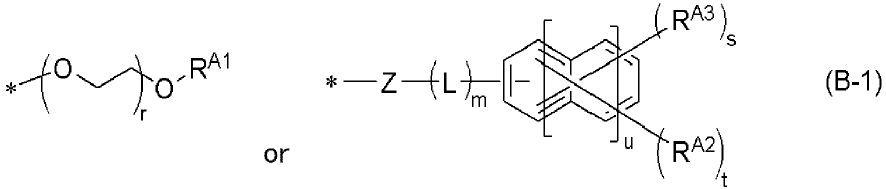 wherein R^{A1} has a structure represented by the general formula (a-1); R^{A2} has a structure represented by the general formula (a-2) or (a-3); Z represents an oxygen atom or a secondary amine; L represents a divalent hydrocarbon group having 1 to 10 carbon atoms; R^{A3} represents a saturated divalent organic group having 1 to 20 carbon atoms or an unsaturated divalent organic group having 2 to 20 carbon atoms; "t" represents 1 to 6 and "s" represents 0 to 5, provided that t+s is 1 or more and 6 or less; "r" represents 1 to 10; "u" represents 0 or 1; "m" represents 0 or 1; and "*" represents an attachment point to a carbon atom of a carbonyl group.
[4] The compound for forming a metal-containing film according to any one of [1] to [3], wherein the organic group X in the formula (1) is a saturated hydrocarbon group having 2 to 20 carbon atoms or an unsaturated hydrocarbon group having 2 to 20 carbon atoms.
[5] The compound for forming a metal-containing film according to any one of [1] to [4], wherein the organic group X in the formula (1) is a group represented by one of the following formulae (2), 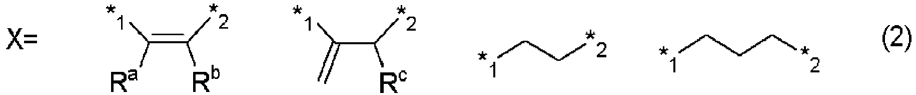 wherein R^{a} and R^{b} each represent a hydrogen atom or a monovalent organic group having 1 to 18 carbon atoms and R^{c} represents a hydrogen atom or a monovalent organic group having 1 to 17 carbon atoms, R^{a} and R^{b} optionally being bonded to each other to form a cyclic substituent; and "*1" and "*2" each represent an attachment point to a carbonyl group, "*1" and "*2" optionally being reversed.
[6] The compound for forming a metal-containing film according to any one of [1] to [5], wherein the compound (A) for forming a metal-containing film comprises a compound having a structure represented by the following general formula (m-1), 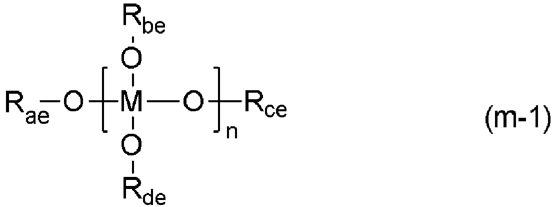 wherein Rₐₑ to R_{de} each independently represent the R^{1A} in the formula (A-1) or the COXCOR^{2A} in the formula (1), provided that at least one of Rₐₑ to R_{de} represents the COXCOR^{2A} in the formula (1); "n" represents 1 to 20; and M is identical to the M in the formula (A-1).
[7] The compound for forming a metal-containing film according to any one of [1] to [5], wherein the compound (A) for forming a metal-containing film further comprises, besides the ligand derived from the organic compound represented by the formula (1), at least one additional ligand selected from the group consisting of a ligand derived from an organic compound represented by the following formula (3) and a ligand derived from any of succinic anhydride, maleic anhydride, glutaric anhydride, phthalic anhydride, and cyclohexanedicarboxylic anhydride, and
   the additional ligand does not contain a group represented by any of the general formulae (a-1) to (a-4),

   R^{3A}COOH (3)

   wherein R^{3A} represents a monovalent organic group having 1 to 20 carbon atoms.
[8] The compound for forming a metal-containing film according to [7], wherein the compound (A) for forming a metal-containing film comprises a compound having one of the following structures, 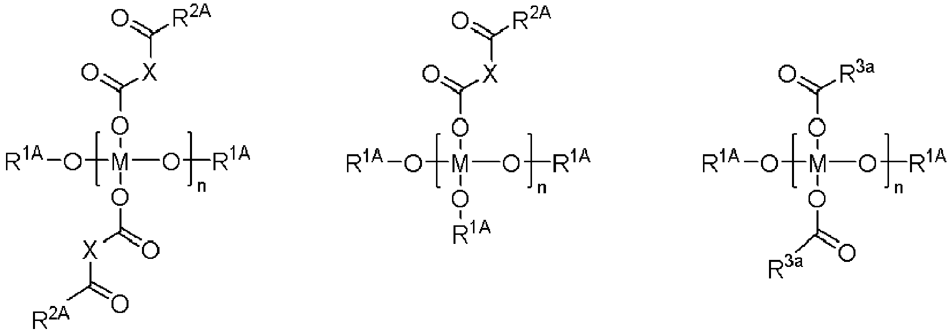 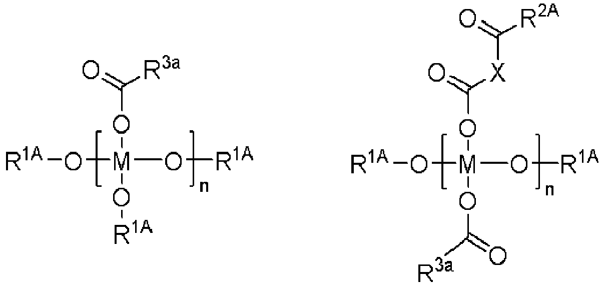 wherein the R^{3a} represents a monovalent organic group having 1 to 20 carbon atoms and not containing a crosslinking group represented by any of the general formulae (a-1) to (a-4) or has a structure of any of the following formulae; R^{1A} is identical to the R^{1A} in the formula (A-1); R^{2A} is identical to the R^{2A} in the formula (1); "n" represents 1 to 20; and M is identical to the M in the formula (A-1), 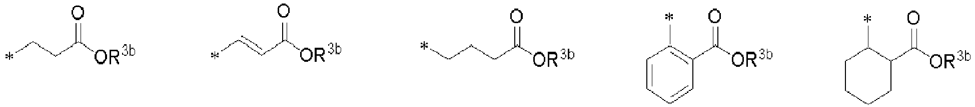 wherein R^{3b} represents an alkyl group having 1 to 10 carbon atoms; and "*" represents an attachment point to a carbon atom of a carbonyl group.
[9] A composition for forming a metal-containing film, comprising:
   (A) the compound for forming a metal-containing film according to any one of [1] to [8]; and
   (B) an organic solvent.
[10] The composition for forming a metal-containing film according to [9], further comprising one or more of:
   (C) a crosslinking agent;
   (D) a surfactant; and
   (E) an acid generator.
[11] The composition for forming a metal-containing film according to [9] or [10], wherein the organic solvent (B) contains a high-boiling-point solvent (B-1), and the high-boiling-point solvent (B-1) is one or more kinds of organic solvent having a boiling point of 180°C or higher.
[12] The composition for forming a metal-containing film according to any one of [9] to [11], further comprising (BP) a flowability accelerator having an organic group represented by one of the following general formulae (bp1a) and an aromatic ring, 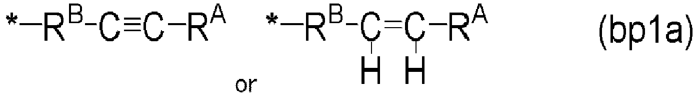 wherein "*" represents an attachment point to an oxygen atom; R^{B} represents a divalent organic group having 1 to 10 carbon atoms; R^{A} represents a hydrogen atom or a monovalent organic group having 1 to 10 carbon atoms.
[13] The composition for forming a metal-containing film according to [12], wherein the flowability accelerator (BP) has at least one constitutional unit represented by any of the following general formulae (BP-1), (BP-2), (BP-3), (BP-4), and (BP-5), 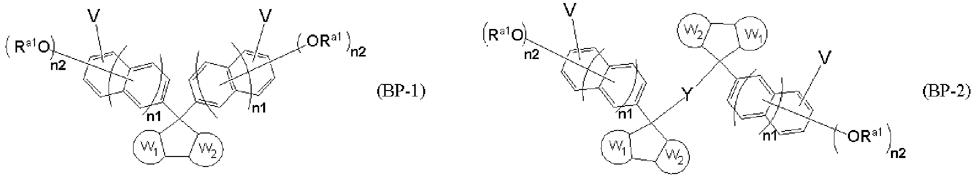 wherein W₁ and W₂ each independently represent a benzene ring or a naphthalene ring, part of hydrogen atoms in the benzene ring and the naphthalene ring optionally being substituted with a hydrocarbon group having 1 to 6 carbon atoms; R^{a1} represents either group represented by the following general formulae (4); Y represents any group represented by the following general formulae (5); "n₁" represents 0 or 1; "n₂" represents 1 or 2; and each V independently represents a hydrogen atom or an attachment point, 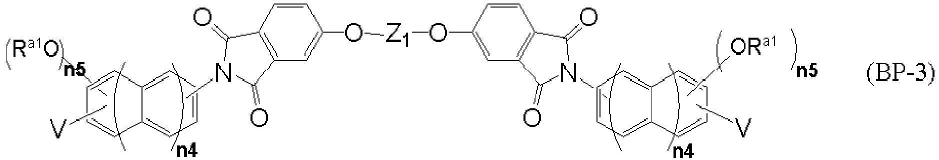 wherein Z₁ represents any group represented by the following general formulae (6); R^{a1} represents either group represented by the following general formulae (4); "n₄" represents 0 or 1; "n₅" represents 1 or 2; and each V independently represents a hydrogen atom or an attachment point, 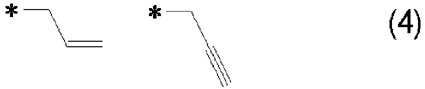 wherein "*" represents an attachment point to an oxygen atom, 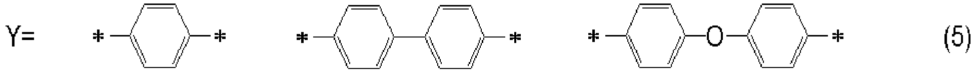 wherein "*" represents an attachment point, 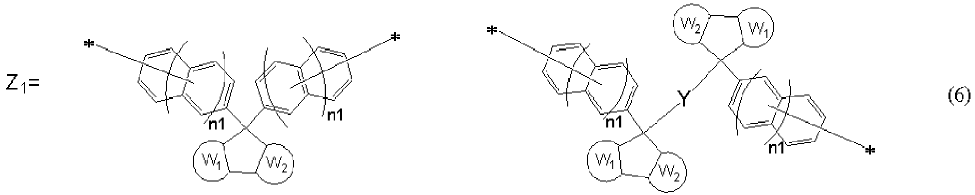 wherein W₁, W₂, Y, and "n₁" are as defined above, 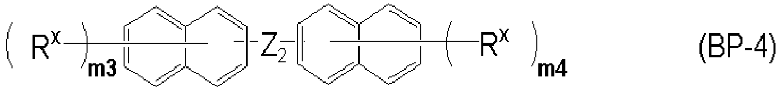 wherein "m₃" and "m₄" each represent 1 or 2; Z₂ represents a single bond or any structure represented by the following general formulae (7); and R^{x} represents any structure represented by the following general formulae (8), 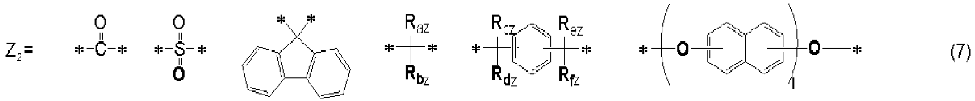 wherein "*" represents an attachment point; "l" represents an integer of 0 to 3; and R_{az} to R_{fz} each independently represent a hydrogen atom, an alkyl group having 1 to 10 carbon atoms and optionally having a substituent fluorine atom, a phenyl group optionally having a substituent fluorine atom, or a phenylethyl group optionally having a substituent fluorine atom, R_{az} and R_{bz} optionally being bonded to each other to form a cyclic compound, 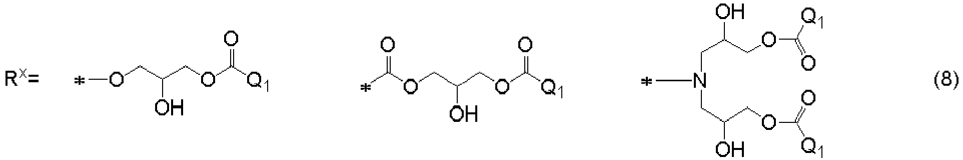 wherein "*" represents an attachment point to an aromatic ring; and Q₁ represents a linear saturated hydrocarbon group having 1 to 30 carbon atoms or a structure represented by the following general formula (9), 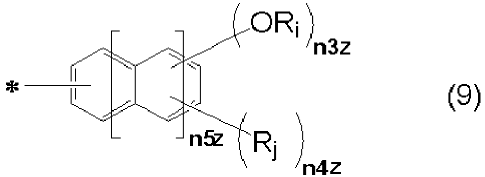 wherein "*" represents an attachment point to a carbonyl group; Rᵢ represents either of the general formulae (4); Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 1 to 10 carbon atoms; "n_{3z}" and "n_{4z}" each represent a number of substituents on an aromatic ring, the number each representing an integer of 0 to 7, provided that n_{3z}+n_{4z} is 0 or more and 7 or less; and "n_{5z}" represents 0 to 2, 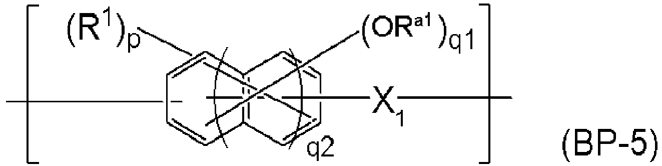 wherein R¹ represents a saturated monovalent organic group having 1 to 30 carbon atoms or an unsaturated monovalent organic group having 2 to 30 carbon atoms; X₁ represents a divalent organic group having 1 to 30 carbon atoms; R^{a1} represents either of the general formulae (4); "p" represents an integer of 0 to 5 and "q₁" represents an integer of 1 to 6, provided that p+q₁ is an integer of 1 or more and 6 or less; and "q₂" represents 0 or 1.
[14] A method for manufacturing a compound (A) for forming a metal-containing film, the method comprising
   allowing one or more selected from the group consisting of a hydrolysate of only a metal compound represented by the following formula (A-1), a condensate of only a metal compound represented by the following formula (A-1), and a hydrolysis condensate of only a metal compound represented by the following formula (A-1) to react with an organic compound represented by the following formula (1) or
   hydrolyzing, condensing, or hydrolysis-condensing a metal compound represented by the following general formula (A-2),

      M(OR^{1A})₄ (A-1)

      R^{2A}COXCOOH (1)

      wherein M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the following general formulae (a-1) to (a-4); and X represents a divalent organic group having 2 to 20 carbon atoms, 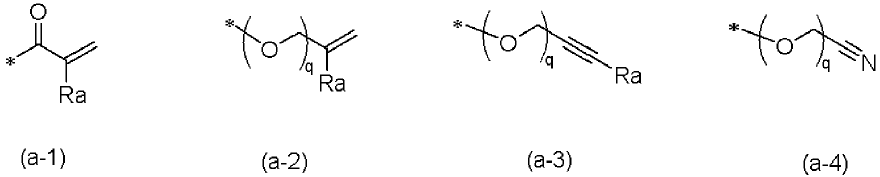 wherein Rₐ represents a hydrogen atom or a monovalent organic group having 1 to 10 carbon atoms; "q" represents 0 or 1; and "*" represents an attachment point,

      (R^{2A}COXCOO)ₓM(OR^{1A})_{y} (A-2)

      wherein M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the general formulae (a-1) to (a-4); X represents a divalent organic group having 2 to 20 carbon atoms; x + y = 4; and "x" and "y" each represent an integer of 1 or more.
[15] A patterning process for forming a pattern in a substrate to be processed, comprising the steps of:
   (I-1) applying the composition for forming a metal-containing film according to any one of [9] to [13] onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the formed pattern as a mask to form the pattern in the substrate to be processed.
[16] A patterning process for forming a pattern in a substrate to be processed, comprising the steps of:
   (II-1) applying the composition for forming a metal-containing film according to any one of [9] to [13] onto a substrate to be processed, followed by heating to form a metal-containing film;
   (II-2) forming a resist middle layer film on the metal-containing film;
   (II-3) forming a resist upper layer film on the resist middle layer film by using a photoresist material;
   (II-4) subjecting the resist upper layer film to pattern exposure and then development with a developer to form a pattern in the resist upper layer film;
   (II-5) transferring the pattern to the resist middle layer film by dry etching while using the resist upper layer film having the formed pattern as a mask;
   (II-6) transferring the pattern to the metal-containing film by dry etching while using the resist middle layer film having the transferred pattern as a mask; and
   (II-7) processing the substrate to be processed while using the metal-containing film having the formed pattern as a mask to form the pattern in the substrate to be processed.
[17] A patterning process for forming a pattern in a substrate to be processed, comprising the steps of:
   (III-1) applying the composition for forming a metal-containing film according to any one of [9] to [13] onto a substrate to be processed, followed by heating to form a metal-containing film;
   (III-2) forming an inorganic hard mask middle layer film selected from a silicon oxide film, a silicon nitride film, and a silicon oxynitride film on the metal-containing film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the metal-containing film by dry etching while using the inorganic hard mask middle layer film having the transferred pattern as a mask; and
   (III-8) processing the substrate to be processed while using the metal-containing film having the formed pattern as a mask to form the pattern in the substrate to be processed.
[18] A patterning process for forming a pattern in a substrate to be processed, comprising the steps of:
   (IV-1) applying the composition for forming a metal-containing film according to any one of [9] to [13] onto a substrate to be processed, followed by heating to form a metal-containing film;
   (IV-2) forming an organic middle layer film on the metal-containing film;
   (IV-3) forming a silicon-containing resist middle layer film or a combination of an organic thin film and an inorganic hard mask middle layer film selected from a silicon oxide film, a silicon nitride film, and a silicon oxynitride film on the organic middle layer film;
   (IV-4) forming a resist upper layer film on the silicon-containing resist middle layer film or the organic thin film by using a photoresist material;
   (IV-5) subjecting the resist upper layer film to pattern exposure and then development with a developer to form a pattern in the resist upper layer film;
   (IV-6) transferring the pattern to the silicon-containing resist middle layer film or the organic thin film and the inorganic hard mask middle layer film by dry etching while using the resist upper layer film having the formed pattern as a mask;
   (IV-7) transferring the pattern to the organic middle layer film by dry etching while using the silicon-containing resist middle layer film or the inorganic hard mask middle layer film having the transferred pattern as a mask;
   (IV-8) transferring the pattern to the metal-containing film by dry etching while using the organic middle layer film having the transferred pattern as a mask; and
   (IV-9) processing the substrate to be processed while using the metal-containing film having the formed pattern as a mask to form the pattern in the substrate to be processed.
[19] A tone-reversal patterning process for forming a pattern in a substrate to be processed, comprising the steps of:
   (V-1) forming a resist underlayer film on a substrate to be processed;
   (V-2) forming a resist middle layer film or a combination of an organic thin film and an inorganic hard mask middle layer film selected from a silicon oxide film, a silicon nitride film, and a silicon oxynitride film on the resist underlayer film;
   (V-3) forming a resist upper layer film on the resist middle layer film or the combination of the inorganic hard mask middle layer film and the organic thin film by using a photoresist material;
   (V-4) subjecting the resist upper layer film to pattern exposure and then development with a developer to form a pattern in the resist upper layer film;
   (V-5) transferring the pattern to the resist middle layer film or the organic thin film and the inorganic hard mask middle layer film by dry etching while using the resist upper layer film having the formed pattern as a mask;
   (V-6) transferring the pattern to the resist underlayer film by dry etching while using the resist middle layer film or the inorganic hard mask middle layer film having the transferred pattern as a mask;
   (V-7) applying the composition for forming a metal-containing film according to any one of [9] to [13] onto the resist underlayer film having the formed pattern, followed by heating to cover the resist underlayer film with a metal-containing film, thereby filling a space between the resist underlayer film patterns with the metal-containing film;
   (V-8) etching back the metal-containing film covering the resist underlayer film having the formed pattern by a chemical stripper or dry etching to expose an upper surface of the resist underlayer film having the formed pattern;
   (V-9) removing the resist middle layer film or the inorganic hard mask middle layer film remaining on the upper surface of the resist underlayer film by dry etching;
   (V-10) removing the resist underlayer film having the formed pattern with its surface exposed by dry etching to form a reverse pattern of an original pattern on the metal-containing film; and
   (V-11) processing the substrate to be processed while using the metal-containing film having the formed reverse pattern as a mask to form the reverse pattern in the substrate to be processed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A compound (A) for forming a metal-containing film, wherein
the compound (A) for forming a metal-containing film is a compound derived from a metal-containing compound, being a hydrolysate, condensate, or hydrolysis condensate of a metal compound represented by the following formula (A-1), and the compound (A) further has a ligand derived from an organic compound represented by the following formula (1),
M(OR^{1A})₄ (A-1)
R^{2A}COXCOOH (1)
wherein M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the following general formulae (a-1) to (a-4); and X represents a divalent organic group having 2 to 20 carbon atoms, 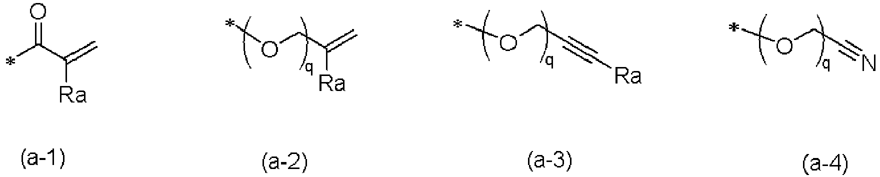 wherein Rₐ represents a hydrogen atom or a monovalent organic group having 1 to 10 carbon atoms; "q" represents 0 or 1; and "*" represents an attachment point.

2. The compound for forming a metal-containing film according to claim 1, wherein the compound (A) for forming a metal-containing film is a metal-containing compound, being a reaction product of a reaction between:
one or more selected from a hydrolysate of only the metal compound represented by the formula (A-1), a condensate of only the metal compound represented by the formula (A-1), and a hydrolysis condensate of only the metal compound represented by the formula (A-1); and
the organic compound represented by the formula (1).

3. The compound for forming a metal-containing film according to claim 1 or 2, wherein the R^{2A} in the formula (1) has a structure represented by one of the following general formulae (B-1), 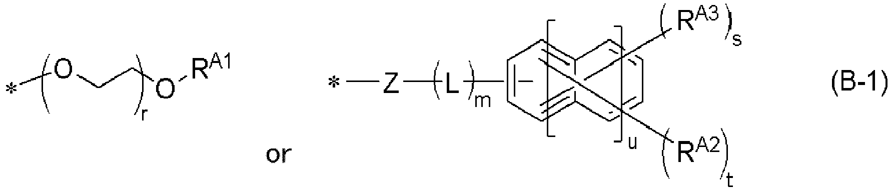 wherein R^{A1} has a structure represented by the general formula (a-1); R^{A2} has a structure represented by the general formula (a-2) or (a-3); Z represents an oxygen atom or a secondary amine; L represents a divalent hydrocarbon group having 1 to 10 carbon atoms; R^{A3} represents a saturated divalent organic group having 1 to 20 carbon atoms or an unsaturated divalent organic group having 2 to 20 carbon atoms; "t" represents 1 to 6 and "s" represents 0 to 5, provided that t+s is 1 or more and 6 or less; "r" represents 1 to 10; "u" represents 0 or 1; "m" represents 0 or 1; and "*" represents an attachment point to a carbon atom of a carbonyl group.

4. The compound for forming a metal-containing film according to any one of claims 1 to 3, wherein the organic group X in the formula (1) is a saturated hydrocarbon group having 2 to 20 carbon atoms or an unsaturated hydrocarbon group having 2 to 20 carbon atoms.

5. The compound for forming a metal-containing film according to any one of claims 1 to 4, wherein the organic group X in the formula (1) is a group represented by one of the following formulae (2), 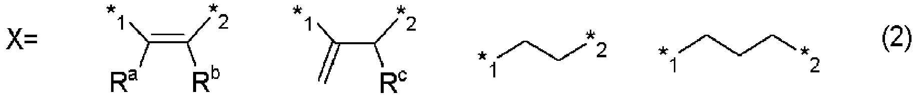 wherein R^{a} and R^{b} each represent a hydrogen atom or a monovalent organic group having 1 to 18 carbon atoms and R^{c} represents a hydrogen atom or a monovalent organic group having 1 to 17 carbon atoms, R^{a} and R^{b} optionally being bonded to each other to form a cyclic substituent; and "*1" and "*2" each represent an attachment point to a carbonyl group, "*1" and "*2" optionally being reversed.

6. The compound for forming a metal-containing film according to any one of claims 1 to 5, wherein the compound (A) for forming a metal-containing film comprises a compound having a structure represented by the following general formula (m-1), 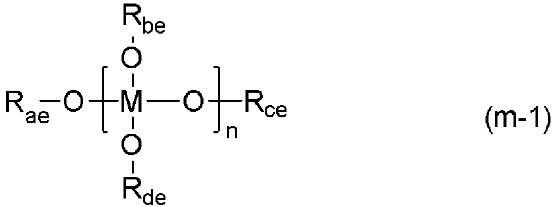 wherein Rₐₑ to R_{de} each independently represent the R^{1A} in the formula (A-1) or the COXCOR^{2A} in the formula (1), provided that at least one of Rₐₑ to R_{de} represents the COXCOR^{2A} in the formula (1); "n" represents 1 to 20; and M is identical to the M in the formula (A-1).

7. The compound for forming a metal-containing film according to any one of claims 1 to 5, wherein the compound (A) for forming a metal-containing film further comprises, besides the ligand derived from the organic compound represented by the formula (1), at least one additional ligand selected from the group consisting of a ligand derived from an organic compound represented by the following formula (3) and a ligand derived from any of succinic anhydride, maleic anhydride, glutaric anhydride, phthalic anhydride, and cyclohexanedicarboxylic anhydride, and
the additional ligand does not contain a group represented by any of the general formulae (a-1) to (a-4),
R^{3A}COOH (3)
wherein R^{3A} represents a monovalent organic group having 1 to 20 carbon atoms.

8. The compound for forming a metal-containing film according to claim 7, wherein the compound (A) for forming a metal-containing film comprises a compound having one of the following structures, 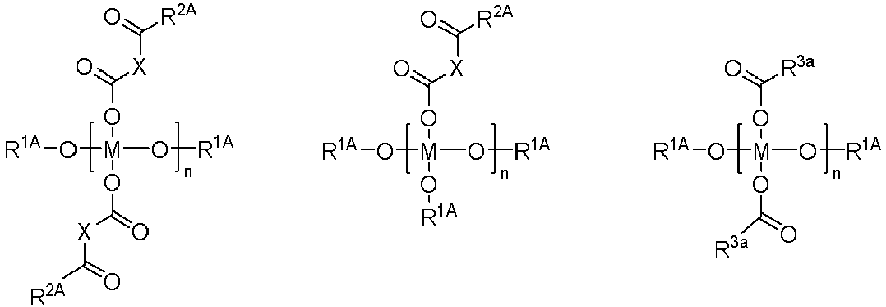 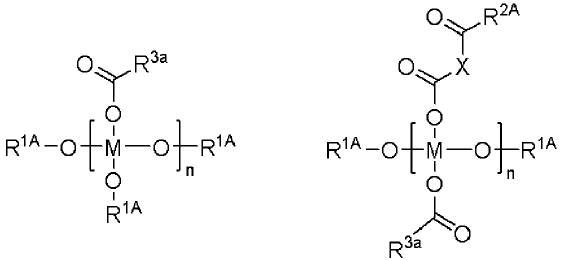 wherein the R^{3a} represents a monovalent organic group having 1 to 20 carbon atoms and not containing a crosslinking group represented by any of the general formulae (a-1) to (a-4) or has a structure of any of the following formulae; R^{1A} is identical to the R^{1A} in the formula (A-1); R^{2A} is identical to the R^{2A} in the formula (1); "n" represents 1 to 20; and M is identical to the M in the formula (A-1), 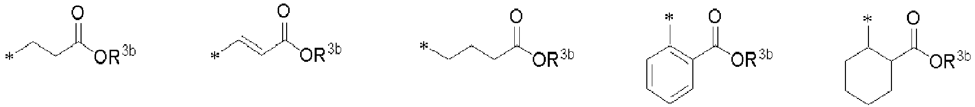 wherein R^{3b} represents an alkyl group having 1 to 10 carbon atoms; and "*" represents an attachment point to a carbon atom of a carbonyl group.

9. A composition for forming a metal-containing film, comprising:
(A) the compound for forming a metal-containing film according to any one of claims 1 to 8; and
(B) an organic solvent.

10. The composition for forming a metal-containing film according to claim 9, further comprising one or more of:
(C) a crosslinking agent;
(D) a surfactant; and
(E) an acid generator.

11. The composition for forming a metal-containing film according to claim 9 or 10, wherein the organic solvent (B) contains a high-boiling-point solvent (B-1), and the high-boiling-point solvent (B-1) is one or more kinds of organic solvent having a boiling point of 180°C or higher.

12. The composition for forming a metal-containing film according to any one of claims 9 to 11, further comprising (BP) a flowability accelerator having an organic group represented by one of the following general formulae (bp1a) and an aromatic ring, 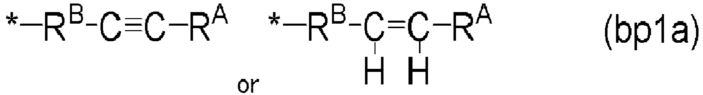 wherein "*" represents an attachment point to an oxygen atom; R³ represents a divalent organic group having 1 to 10 carbon atoms; R^{A} represents a hydrogen atom or a monovalent organic group having 1 to 10 carbon atoms.

13. The composition for forming a metal-containing film according to claim 12, wherein the flowability accelerator (BP) has at least one constitutional unit represented by any of the following general formulae (BP-1), (BP-2), (BP-3), (BP-4), and (BP-5), 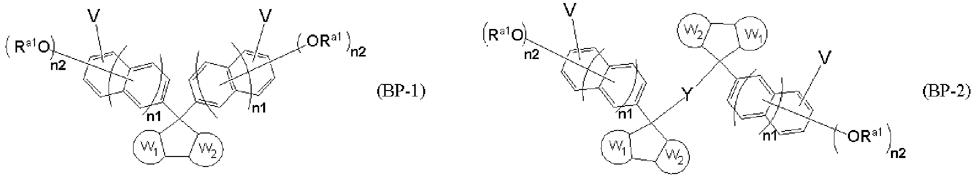 wherein W₁ and W₂ each independently represent a benzene ring or a naphthalene ring, part of hydrogen atoms in the benzene ring and the naphthalene ring optionally being substituted with a hydrocarbon group having 1 to 6 carbon atoms; R^{a1} represents either group represented by the following general formulae (4); Y represents any group represented by the following general formulae (5); "n₁" represents 0 or 1; "n₂" represents 1 or 2; and each V independently represents a hydrogen atom or an attachment point, 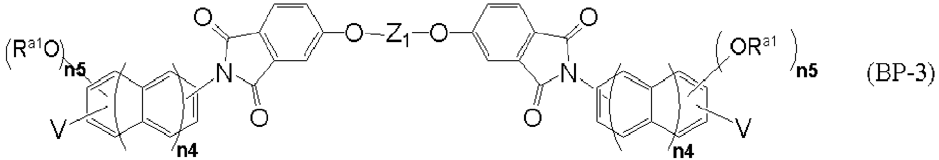 wherein Z₁ represents any group represented by the following general formulae (6); R^{a1} represents either group represented by the following general formulae (4); "n₄" represents 0 or 1; "n₅" represents 1 or 2; and each V independently represents a hydrogen atom or an attachment point, 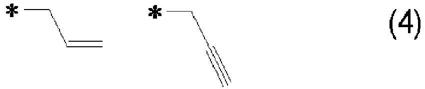 wherein "*" represents an attachment point to an oxygen atom, 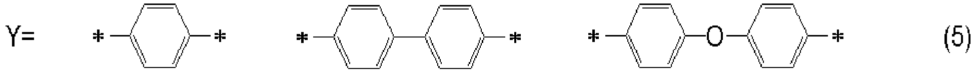 wherein "*" represents an attachment point, 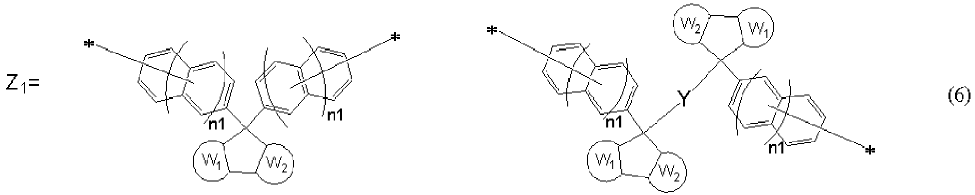 wherein W₁, W₂, Y, and "n₁" are as defined above, 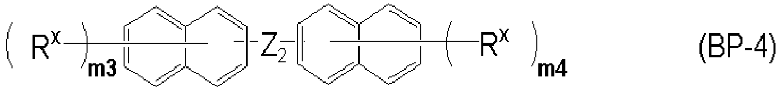 wherein "m₃" and "m₄" each represent 1 or 2; Z₂ represents a single bond or any structure represented by the following general formulae (7); and R^{x} represents any structure represented by the following general formulae (8), 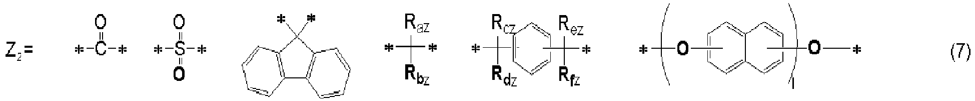 wherein "*" represents an attachment point; "l" represents an integer of 0 to 3; and R_{az} to R_{fz} each independently represent a hydrogen atom, an alkyl group having 1 to 10 carbon atoms and optionally having a substituent fluorine atom, a phenyl group optionally having a substituent fluorine atom, or a phenylethyl group optionally having a substituent fluorine atom, R_{az} and R_{bz} optionally being bonded to each other to form a cyclic compound, 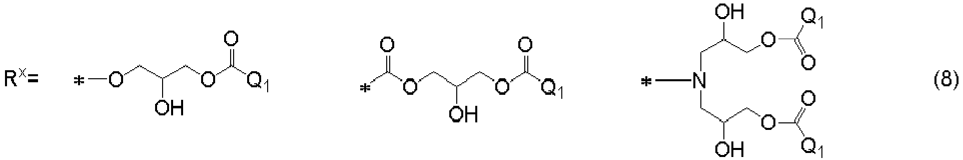 wherein "*" represents an attachment point to an aromatic ring; and Q₁ represents a linear saturated hydrocarbon group having 1 to 30 carbon atoms or a structure represented by the following general formula (9), 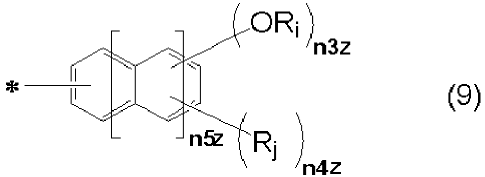 wherein "*" represents an attachment point to a carbonyl group; Rᵢ represents either of the general formulae (4); Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 1 to 10 carbon atoms; "n_{3z}" and "n_{4z}" each represent a number of substituents on an aromatic ring, the number each representing an integer of 0 to 7, provided that n_{3z}+n_{4z} is 0 or more and 7 or less; and "n_{5z}" represents 0 to 2, 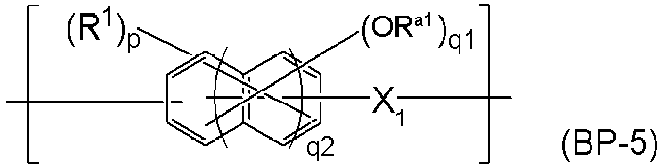 wherein R¹ represents a saturated monovalent organic group having 1 to 30 carbon atoms or an unsaturated monovalent organic group having 2 to 30 carbon atoms; X₁ represents a divalent organic group having 1 to 30 carbon atoms; R^{a1} represents either of the general formulae (4); "p" represents an integer of 0 to 5 and "q₁" represents an integer of 1 to 6, provided that p+q₁ is an integer of 1 or more and 6 or less; and "q₂" represents 0 or 1.

14. A method for manufacturing a compound (A) for forming a metal-containing film, the method comprising
allowing one or more selected from the group consisting of a hydrolysate of only a metal compound represented by the following formula (A-1), a condensate of only a metal compound represented by the following formula (A-1), and a hydrolysis condensate of only a metal compound represented by the following formula (A-1) to react with an organic compound represented by the following formula (1) or
hydrolyzing, condensing, or hydrolysis-condensing a metal compound represented by the following general formula (A-2),
M(OR^{1A})₄ (A-1)
R^{2A}COXCOOH (1)
wherein M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the following general formulae (a-1) to (a-4); and X represents a divalent organic group having 2 to 20 carbon atoms, 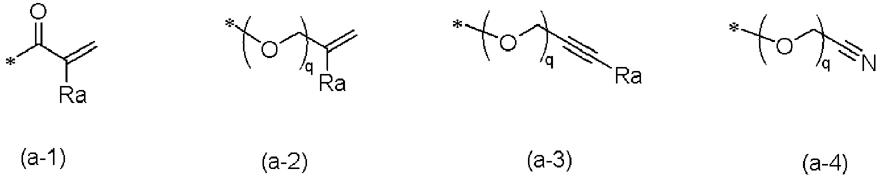 wherein Rₐ represents a hydrogen atom or a monovalent organic group having 1 to 10 carbon atoms; "q" represents 0 or 1; and "*" represents an attachment point,
(R^{2A}COXCOO)ₓM(OR^{1A})_{y} (A-2)
wherein M represents Ti, Zr, or Hf; R^{1A} represents a monovalent organic group having 1 to 20 carbon atoms; R^{2A} represents a divalent organic group having 2 to 20 carbon atoms and containing at least one crosslinking group represented by any of the general formulae (a-1) to (a-4); X represents a divalent organic group having 2 to 20 carbon atoms; x + y = 4; and "x" and "y" each represent an integer of 1 or more.

15. A patterning process for forming a pattern in a substrate to be processed, comprising the steps of:
(I-1) applying the composition for forming a metal-containing film according to any one of claims 9 to 13 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed, or
a patterning process for forming a pattern in a substrate to be processed, comprising the steps of:
(II-1) applying the composition for forming a metal-containing film according to any one of claims 9 to 13 onto a substrate to be processed, followed by heating to form a metal-containing film;
(II-2) forming a resist middle layer film on the metal-containing film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal-containing film by dry etching while using the resist middle layer film having the transferred pattern as a mask; and
(II-7) processing the substrate to be processed while using the metal-containing film having the formed pattern as a mask to form the pattern in the substrate to be processed, or
a patterning process for forming a pattern in a substrate to be processed, comprising the steps of:
(III-1) applying the composition for forming a metal-containing film according to any one of claims 9 to 13 onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed, or
a patterning process for forming a pattern in a substrate to be processed, comprising the steps of:
(IV-1) applying the composition for forming a metal-containing film according to any one of claims 9 to 13 onto a substrate to be processed, followed by heating to form a metal-containing film;
(IV-2) forming an organic middle layer film on the metal-containing film;
(IV-3) forming a silicon-containing resist middle layer film or a combination of an organic thin film and an inorganic hard mask middle layer film selected from a silicon oxide film, a silicon nitride film, and a silicon oxynitride film on the organic middle layer film;
(IV-4) forming a resist upper layer film on the silicon-containing resist middle layer film or the organic thin film by using a photoresist material;
(IV-5) subjecting the resist upper layer film to pattern exposure and then development with a developer to form a pattern in the resist upper layer film;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the organic middle layer film by dry etching while using the silicon-containing resist middle layer film or the inorganic hard mask middle layer film having the transferred pattern as a mask;
(IV-8) transferring the pattern to the metal-containing film by dry etching while using the organic middle layer film having the transferred pattern as a mask; and
(IV-9) processing the substrate to be processed while using the metal-containing film having the formed pattern as a mask to form the pattern in the substrate to be processed, or
a patterning process for forming a pattern in a substrate to be processed, being in tone-reversal type and comprising the steps of:
(V-1) forming a resist underlayer film on a substrate to be processed;
(V-2) forming a resist middle layer film or a combination of an organic thin film and an inorganic hard mask middle layer film selected from a silicon oxide film, a silicon nitride film, and a silicon oxynitride film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the composition for forming a metal-containing film according to any one of claims 9 to 13 onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.
